# EUROPEAN PATENT APPLICATION

(11) **EP 4 669 066 A1**
(43) Date of publication of application: **24.12.2025**
(21) Application number: 25183984.1
(22) Date of filing: 19.06.2025
(51) Int. Cl.: H10K 50/13, H10K 59/32, H10K 59/38, H10K 85/30, H10K 85/40, H10K 85/60

(54) **LIGHT-EMITTING DEVICE AND ELECTRONIC APPARATUS INCLUDING THE SAME**

(30) Priority: 19.06.2024 KR 20240079792
(71) Applicant: Samsung Display Co., Ltd., Yongin-si, Gyeonggi-do 17113 (KR)
(72) Inventor: Shin, Hyun, 17113 Yongin-si, Gyeonggi-do (KR); Kim, Eungdo, 17113 Yongin-si, Gyeonggi-do (KR); Kang, Yujin, 17113 Yongin-si, Gyeonggi-do (KR); Park, Junha, 17113 Yongin-si, Gyeonggi-do (KR); Lee, Seunghyun, 17113 Yongin-si, Gyeonggi-do (KR); Jun, Mieun, 17113 Yongin-si, Gyeonggi-do (KR)
(74) Representative: Gulde & Partner

(57) **Abstract**

Embodiments provide a light-emitting device and an electronic apparatus including the same. The light-emitting device includes a first electrode, a second electrode facing the first electrode, an emission layer between the first electrode and the second electrode, a hole transport region between the first electrode and the emission layer, and a hole transport region between the emission layer and the second electrode. The emission layer includes a first emission layer, a second emission layer, and a third emission layer, which are sequentially arranged from the hole transport region, wherein the second emission layer has a different configuration from the first emission layer and third emission layer.

## Description

### CROSS-REFERENCE TO RELATED APPLICATION(S)

### BACKGROUND

### 1. Technical Field

Embodiments relate to a light-emitting device and an electronic apparatus including the same.

### 2. Description of the Related Art

Light-emitting devices are self-emissive devices that have wide viewing angles, high contrast ratios, short response times, and excellent characteristics in terms of luminance, driving voltage, and response speed.

In a light-emitting device, a first electrode may be arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. When the excitons transition from an excited state to a ground state, light is emitted.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The invention is defined by the appended claims. The description that follows is subjected to this limitation. Any disclosure lying outside the scope of said claims is only intended for illustrative as well as comparative purposes.

Embodiments include a light-emitting device, which includes an emission layer and a depletion layer and/or a low-doped layer in the emission layer, and an electronic apparatus including the light-emitting device.

Additional aspects will be set forth in part in the description which follows and, in part, will be apparent from the description, or may be learned by practice of the embodiments of the disclosure.

According to embodiments, a light-emitting device includes:
a first electrode;
a second electrode facing the first electrode;
an emission layer between the first electrode and the second electrode,
a hole transport region between the first electrode and the emission layer, and
an electron transport region between the emission layer and the second electrode, wherein
the emission layer includes a first emission layer, a second emission layer, and a third emission layer, which are sequentially arranged from the hole transport region,
a thickness of the emission layer is x,
a thickness of the first emission layer is a, a thickness of the second emission layer is (b-a), and a thickness of the third emission layer is (x-b),
a is a real number that satisfies 0.4x ≤ a < 0.6x,
b is a real number that satisfies 0.4x < b ≤ 0.6x,
a and b are different from each other, and satisfy a < b,
the first emission layer and the third emission layer each independently include a first host, a second host, a first dopant, and a second dopant,
the second emission layer includes: a first host, a second host, and a first dopant; or a first host, a second host, a first dopant, and a second dopant,
when the second emission layer includes the second dopant, y2 is smaller than *y1,*
y1 is a weight percentage (wt%) value of the second dopant in the first emission layer that is expressed based on 100 wt% of the entire first emission layer,
y2 is a weight percentage (wt%) value of the second dopant in the second emission layer that is expressed based on 100 wt% of the entire second emission layer,
the first host, the second host, the first dopant, and the second dopant are different from one another,
the first host includes a group represented by Formula 1,
the second host includes at least one π electron-deficient nitrogen-containing C₁-C₆₀ cyclic group,
the first dopant includes a transition metal, and
the second dopant emits delayed fluorescence:

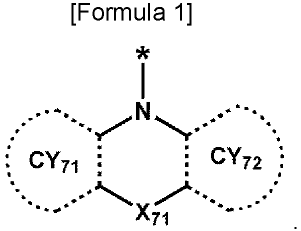

In Formula 1,
ring CY₇₁ and ring CY₇₂ are each independently a π electron-rich C₃-C₆₀ cyclic group or a pyridine group,
X₇₁ is: a single bond; or a linking group including O, S, N, B, C, Si, or any combination thereof, and
* indicates a binding site to a neighboring atom in the first host.

In an embodiment, x may be in a range of 30 nm to 40 nm.

In an embodiment, (b-a) may be equal to or less than (0.1x) nm.

In an embodiment, (b-a) may be equal to or less than 3 nm.

In an embodiment, (b-a) may be equal to or greater than 1 nm.

In an embodiment, y1 may be equal to or less than 3.

In an embodiment, when the second emission layer includes a second dopant, y2 may be equal to or less than 0.35(y1).

In an embodiment, the second host may include a pyridine group, a pyrimidine group, a pyrazine group, a pyridazine group, a triazine group, or any combination thereof.

In an embodiment, the second host may include a compound represented by Formula 2, which is explained below.

In an embodiment, the first dopant may include iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm).

In an embodiment, the first dopant may include platinum (Pt), and two or more nitrogen-containing cyclic groups.

In an embodiment, a difference between a triplet energy level (eV) and a singlet energy level (eV) of the second dopant may be in a range of about 0 eV to about 0.3 eV.

In an embodiment, the second dopant may include at least one cyclic group that includes boron (B) and nitrogen (N) as ring-forming atoms.

In an embodiment, the emission layer may emit light having a maximum emission wavelength in a range of about 430 nm to about 480 nm.

According to embodiments, a light-emitting device may include:
a first electrode;
a second electrode facing the first electrode;
an emission layer between the first electrode and the second electrode;
a hole transport region between the first electrode and the emission layer; and
an electron transport region between the emission layer and the second electrode, wherein
the emission layer may include a first emission layer, a second-1 emission layer, a fourth emission layer, a second-2 emission layer, and a third emission layer, which are sequentially arranged from the hole transport region,
a thickness of the emission layer may be x,
a thickness of the first emission layer may be a1, a thickness of the second-1 emission layer may be (b1-a1), a thickness of the fourth emission layer may be (a2-b1), a thickness of the second-2 emission layer may be (b2-a2), and a thickness of the third emission layer may be (x-b2),
a1 may be a real number that satisfies 0.4x ≤ a1 < 0.6x,
b1 may be a real number that satisfies 0.4x < b1 ≤ 0.6x,
a2 may be a real number that satisfies 0.4x ≤ a2 < 0.6x,
b2 may be a real number that satisfies 0.4x < b2 ≤ 0.6x,
a1, b1, a2, and b2 may be different from each other,
a1, b1, a2, and b2 may satisfy a1 < b1 < a2 < b2,
the first emission layer, the third emission layer, and the fourth emission layer may each independently include a first host, a second host, a first dopant, and a second dopant,
the second-1 emission layer and the second-2 emission layer may each independently include: a first host, a second host, and a first dopant; or a first host, a second host, a first dopant, and a second dopant,
when the second-1 emission layer includes the second dopant, y21 may be smaller than y1,
when the second-2 emission layer includes the second dopant, y22 may be smaller than y1,
y1 may be a weight percentage (wt%) value of the second dopant in the first emission layer that is expressed based on 100 wt% of the entire first emission layer,
y21 may be a weight percentage (wt%) value of the second dopant in the second-1 emission layer that is expressed based on 100 wt% of the entire second-1 emission layer,
y22 may be a weight percentage (wt%) value of the second dopant in the second-2 emission layer that is expressed based on 100 wt% of the entire second-2 emission layer,
the first host, the second host, the first dopant, and the second dopant may be different from one another,
the first host may include a group represented by Formula 1, which is explained herein,
the second host may include at least one π electron-deficient nitrogen-containing C₁-C₆₀ cyclic group,
the first dopant may include a transition metal, and
the second dopant may emit delayed fluorescence.

In an embodiment, (a2-b1) may be equal to or greater than 1 nm.

According to embodiments, a light-emitting device may include:
a first electrode;
a second electrode facing the first electrode;
an emission layer between the first electrode and the second electrode;
a hole transport region between the first electrode and the emission layer; and
an electron transport region between the emission layer and the second electrode, wherein
the emission layer may include a first emission layer, a second-1 emission layer, a fourth-1 emission layer, a second-2 emission layer, a fourth-2 emission layer, a second-3 emission layer, and a third emission layer, which are sequentially arranged from the hole transport region,
a thickness of the emission layer may be x,
a thickness of the first emission layer may be a1, a thickness of the second-1 emission layer may be (b1-a1), a thickness of the fourth-1 emission layer may be (a2-b1), a thickness of the second-2 emission layer may be (b2-a2), a thickness of the fourth-2 emission layer may be (a3-b2), a thickness of the second-3 emission layer may be (b3-a3), and a thickness of the third emission layer may be (x-b3),
a1 may be a real number that satisfies 0.4x ≤ a1 < 0.6x,
b1 may be a real number that satisfies 0.4x < b1 ≤ 0.6x,
a2 may be a real number that satisfies 0.4x ≤ a2 < 0.6x,
b2 may be a real number that satisfies 0.4x < b2 ≤ 0.6x,
a3 may be a real number that satisfies 0.4x ≤ a3 < 0.6x,
b3 may be a real number that satisfies 0.4x < b3 ≤ 0.6x,
a1, b1, a2, b2, a3, and b3 may be different from each other,
a1, b1, a2, b2, a3, and b3 may satisfy a1 < b1 < a2 < b2 < a3 <b3,
the first emission layer, the third emission layer, the fourth-1 emission layer, and the fourth-2 emission layer may each independently include a first host, a second host, a first dopant, and a second dopant,
the second-1 emission layer, the second-2 emission layer, and the second-3 emission layer may each independently include: a first host, a second host, and a first dopant; or a first host, a second host, a first dopant, and a second dopant,
when the second-1 emission layer includes the second dopant, y21 may be smaller than y1,
when the second-2 emission layer includes the second dopant, y22 may be smaller than y1,
when the second-3 emission layer includes the second dopant, y23 may be smaller than y1,
y1 may be a weight percentage (wt%) value of the second dopant in the first emission layer that is expressed based on 100 wt% of the entire first emission layer,
y21 may be a weight percentage (wt%) value of the second dopant in the second-1 emission layer that is expressed based on 100 wt% of the entire second-1 emission layer,
y22 may be a weight percentage (wt%) value of the second dopant in the second-2 emission layer that is expressed based on 100 wt% of the entire second-2 emission layer,
y23 may be a weight percentage (wt%) value of the second dopant in the second-3 emission layer that is expressed based on 100 wt% of the entire second-3 emission layer,
the first host, the second host, the first dopant, and the second dopant may be different from one another,
the first host may include a group represented by Formula 1, which is explained herein,
the second host may include at least one π electron-deficient nitrogen-containing C₁-C₆₀ cyclic group,
the first dopant may include a transition metal, and
the second dopant may emit delayed fluorescence.

In an embodiment, (a2-b1) and (a3-b2) may each independently be equal to or greater than 1 nm.

According to embodiments, an electronic apparatus includes the light-emitting device.

In an embodiment, the electronic apparatus may further include a thin-film transistor, wherein the thin-film transistor may include a source electrode and a drain electrode, and the first electrode of the light-emitting device may be electrically connected to at least one of the source electrode and the drain electrode.

In an embodiment, the electronic apparatus may further include a light control layer, wherein the light control layer may include quantum dots.

It is to be understood that the embodiments above are described in a generic and explanatory sense only and not for the purposes of limitation, and the disclosure is not limited to the embodiments described above.

### BRIEF DESCRIPTION OF THE DRAWINGS

The accompanying drawings are included to provide a further understanding of the embodiments, and are incorporated in and constitute a part of this specification. The drawings illustrate embodiments of the disclosure and principles thereof. The above and other aspects and features of the disclosure will become more apparent by describing in detail embodiments thereof with reference to the accompanying drawings, in which:
FIG. 1 is a schematic cross-sectional view of a light-emitting device according to an embodiment;
FIG. 2 is a schematic cross-sectional view of a light-emitting device according to another embodiment;
FIG. 3 is a schematic cross-sectional view of a light-emitting device according to another embodiment;
FIG. 4 is a schematic cross-sectional view of an electronic apparatus according to an embodiment;
FIG. 5 is a schematic cross-sectional view of an electronic apparatus according to another embodiment;
FIG. 6 is a schematic perspective view of an electronic equipment according to an embodiment;
FIG. 7 is a schematic perspective view of an exterior of a vehicle as an electronic equipment according to an embodiment; and
FIGS. 8A to 8C are each a schematic diagram of an interior of a vehicle, according to embodiments.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like reference numbers and reference characters refer to like elements throughout.

In the specification, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the specification, when an element is "directly on", "directly connected to", or "directly coupled to" another element, there are no intervening elements present. For example, "directly on" may mean that two layers or two elements are disposed without an additional element such as an adhesion element therebetween.

In the specification, the expressions used in the singular such as "a", "an", and "the" are intended to include the plural forms as well, unless the context clearly indicates otherwise.

In the specification, the term "and/or" includes any and all combinations of one or more of the associated listed items. For example, "A and/or B" may be understood to mean "A, B, or A and B". The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of", modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system).

It should be understood that the terms "comprises", "comprising", "includes", "including", "have", "having", "contains", "containing", and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

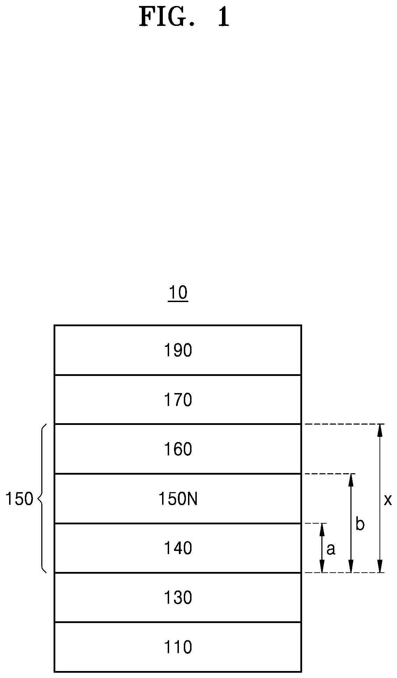

According to embodiments, a light-emitting device 10 may include: a first electrode 110; a second electrode 190 facing the first electrode 110; an emission layer 150 between the first electrode 110 and the second electrode 190;
a hole transport region 130 between the first electrode 110 and the emission layer 150; and an electron transport region 170 between the emission layer 150 and the second electrode 190, wherein
the emission layer 150 may include a first emission layer 140, a second emission layer 150N, and a third emission layer 160, which are sequentially arranged from the hole transport region 130 (see FIG. 1).

According to embodiments, in the light-emitting device 10, the emission layer 150 may include a first host, a second host, a first dopant, and a second dopant, wherein the first host, the second host, the first dopant, and the second dopant may be different from one another.

According to embodiments, in the light-emitting device 10, a thickness of the emission layer 150 may be x, a thickness of the first emission layer 140 may be a, a thickness of the second emission layer 150N may be (b-a), and a thickness of the third emission layer 160 may be (x-b).

According to embodiments, in the light-emitting device 10,
a may be a real number that satisfies 0.4x ≤ a < 0.6x,
b may be a real number that satisfies 0.4x < b ≤ 0.6x, and
a and b may be different from each other, and may satisfy a < b.

In the related art, when manufacturing a light-emitting device, a linear source structure may be used, and thus, in forming an emission layer, a section is formed in which the smallest amount of source is much less than a target amount or does not contain any source at all. A light-emitting device manufactured in this way may include a non-uniform emission layer, and device characteristics may be degraded, as compared to a light-emitting device that is manufactured using a point source.

According to embodiments, by controlling the position of a depletion layer that does not include the smallest amount of the source (e.g., a second dopant) or a low-doped layer that includes a small amount of the source, the source may be applied at a uniform ratio in the remaining regions other than the depletion layer or the low-doped layer in the emission layer, thereby preventing degradation of device characteristics.

In the depletion layer or in the low-doped layer within the emission layer, the mobility of holes and electrons may be further increased, thereby exhibiting low driving voltage characteristics of the light-emitting device disclosed herein.

In an embodiment, x, the thickness of the emission layer 150, may be equal to or greater than 30 nm, equal to or greater than 31 nm, or equal to or greater than 32 nm.

In an embodiment, x, the thickness of the emission layer 150, may be equal to or less than 40 nm, equal to or less than 39 nm, or equal to or less than 38 nm.

In an embodiment, (b-a), the thickness of the second emission layer 150N, may be equal to or less than (0.1x) nm.

In an embodiment, (b-a), the thickness of the second emission layer 150N, may be equal to or less than 3 nm. Even if some luminescence occurs in the second emission layer 150N or a host exists in an excited state, energy may be transferred to either end of the second emission layer 150N, so that luminescence of the second emission layer 150N may ultimately be implemented, and thus no loss of excitons occurs.

In an embodiment, (b-a), the thickness of the second emission layer 150N, may be equal to or greater than 1 nm.

In an embodiment, a may satisfy 0.4x ≤ a < 0.58x.

In an embodiment, b may satisfy 0.42x < b ≤ 0.6x.

According to embodiments, in the light-emitting device 10, the first emission layer 140 and the third emission layer 160 may each independently include a first host, a second host, a first dopant, and a second dopant.

According to embodiments, in the light-emitting device 10, the second emission layer 150N may include: a first host, a second host, and a first dopant; or a first host, a second host, a first dopant, and a second dopant.

According to embodiments, in the light-emitting device 10, when the second emission layer 150N includes the second dopant, y2 may be smaller than y1 (e.g., y2 *< y1).*

According to embodiments, in the light-emitting device 10, y1 may be a weight percentage (wt%) value of the second dopant in the first emission layer 140 that is expressed based on 100 wt% of the entire first emission layer 140.

According to embodiments, in the light-emitting device 10, y2 may be a weight percentage (wt%) value of the second dopant in the second emission layer 150N that is expressed based on 100 wt% of the entire second emission layer 150N.

In an embodiment, in the first emission layer 140, y1, which is the wt% value of the second dopant, may be equal to or less than 5, equal to or less than 4.5, equal to or less than 4, equal to or less than 3.5, equal to or less than 3, equal to or less than 2.5, equal to or less than 2, or equal to or less than 1.5.

In an embodiment, when the second emission layer 150N includes the second dopant, y2, which is the wt% value of the second dopant in the second emission layer 150N, may be equal to or less than 0.35(y1) (e.g., y2 ≤ 0.35(y1)).

In an embodiment, y1, which is the wt% value of the second dopant in the first emission layer 140, and y3, which is a wt% value of the second dopant in the third emission layer 160, may be identical to each other. According to embodiments, in the light-emitting device 10, y3 may be expressed based on 100 wt% of the entire third emission layer 160.

Thus, the emission layer 150 of the light-emitting device 10 according to embodiments may have a uniform concentration of the second dopant in the remaining emission layers, except for the depletion layer or the low-doped layer (e.g., the second emission layer 150N).

In an embodiment, when the second emission layer 150N includes the second dopant, y2, which is the wt% of the dopant in the second emission layer 150N, may be smaller than y3, which is the wt% value of the second dopant in the third emission layer 160. For example, y2 may be equal to or less than 0.35(y3) (y2 ≤ 0.35(y3)).

### [First host, second host, first dopant, and second dopant]

The emission layer 150 may include a first host, a second host, a first dopant, and a second dopant, wherein the first host, the second host, the first dopant, and the second dopant may be different from one another, and the emission layer 150 may emit phosphorescence or fluorescence (e.g., delayed fluorescence) emitted from the first dopant or the second dopant included in the emission layer 150.

For example, the first host and the second host included in the emission layer 150 may form an exciplex, and the second host and the first dopant included in the emission layer 150 may form an exciplex.

In an embodiment, the first dopant may not serve as a dopant, and may instead serve as an auxiliary dopant that transfers energy to a dopant (or to an emitter).

In embodiments, the first dopant may serve as an emitter, and may also serve as an auxiliary dopant that transfers energy to a dopant (or to an emitter).

In embodiments, the second dopant may serve as an emitter, and may also serve as an auxiliary dopant that transfers energy to a dopant (or to an emitter).

In embodiments, the second dopant may not serve as a dopant, and may instead serve as an auxiliary dopant that transfers energy to a dopant (or to an emitter).

When the emission layer 150 includes both a compound that includes at least one cyclic compound that includes boron (B) and nitrogen as ring-forming atoms, and an organometallic compound (e.g., a compound represented by Formula 31 as described below), the organometallic compound may serve as a sensitizer. When the organometallic compound serves as a sensitizer, the energy of excitons produced in the emission layer 150 may be transferred to the organometallic compound, and transferred from the organometallic compound to other remaining dopants. Thus, the other remaining dopants may serve as an emitter.

For example, phosphorescence or fluorescence emitted from the first dopant or the second dopant may be blue phosphorescence or blue fluorescence (e.g., blue delayed fluorescence). The blue light may have a maximum emission wavelength in a range of about 390 nm to about 500 nm. For example, the blue light may have a maximum emission wavelength in a range of about 410 nm to about 490 nm. For example, the blue light may have a maximum emission wavelength in a range of about 430 nm to about 480 nm. For example, the blue light may have a maximum emission wavelength in a range of about 440 nm to about 475 nm. For example, the blue light may have a maximum emission wavelength in a range of about 455 nm to about 470 nm.

For example, the first dopant and the second dopant may each independently be a phosphorescent dopant material or any fluorescent dopant material.

### [Description of first host]

According to embodiments, the first host may include a group represented by Formula 1:

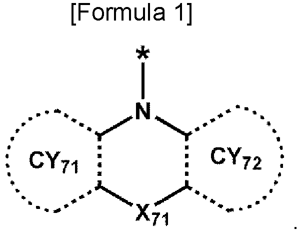

In Formula 1,
ring CY₇₁ and ring CY₇₂ may each independently be a π electron-rich C₃-C₆₀ cyclic group or a pyridine group,
X₇₁ may be: a single bond; or a linking group including O, S, N, B, C, Si, or any combination thereof, and
* indicates a binding site to a neighboring atom in the first host.

In an embodiment, the first host may include a compound represented by Formula 1-1, a compound represented by Formula 1-2, a compound represented by Formula 1-3, a compound represented by Formula 1-4, a compound represented by Formula 1-5, or any combination thereof:

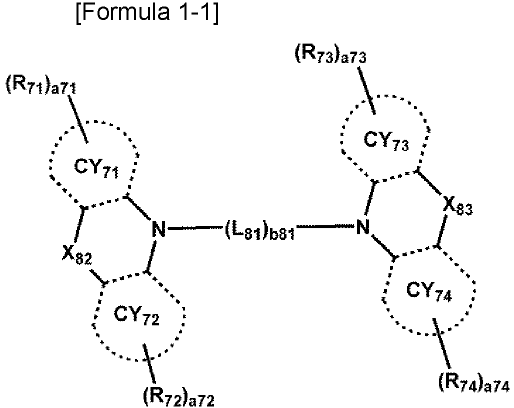

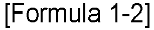

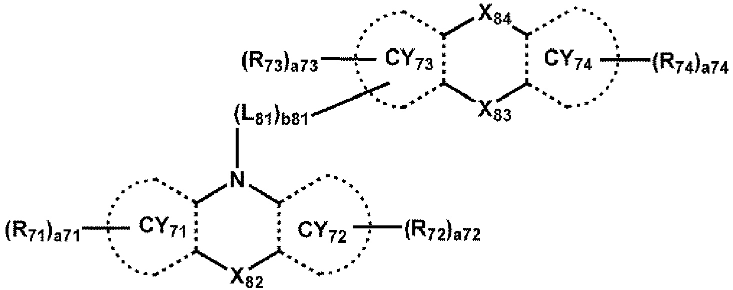

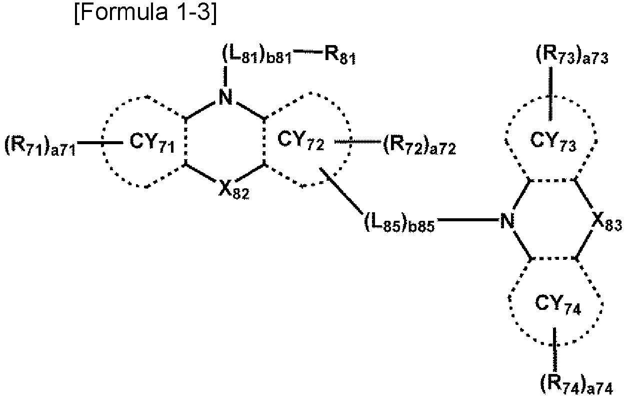

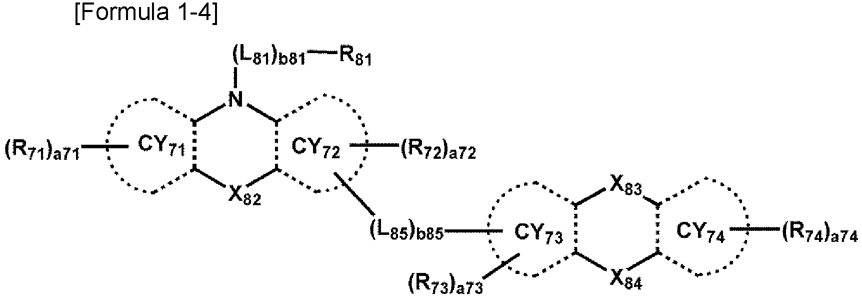

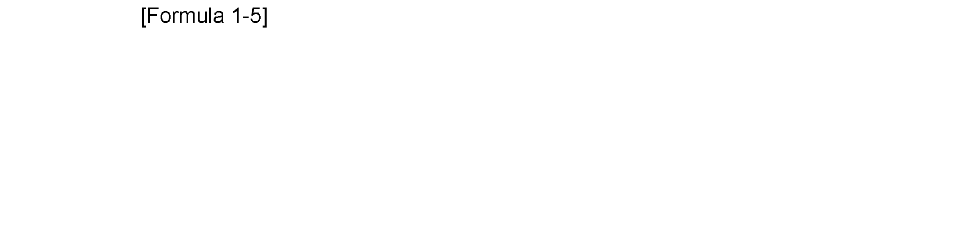

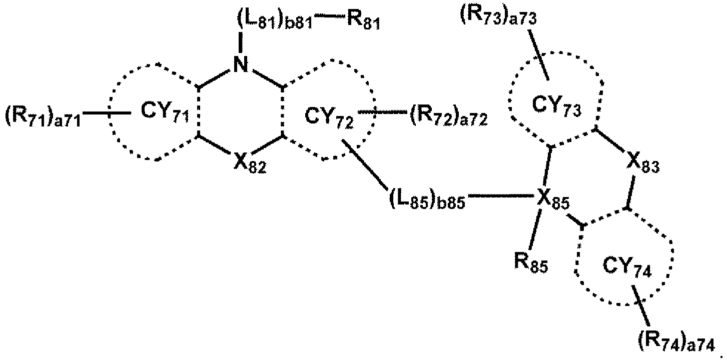

In Formulae 1-1 to 1-5,
ring CY₇₁ to ring CY₇₄ may each independently be a π electron-rich C₃-C₆₀ cyclic group or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be the same as described herein,
a71 to a74 may each independently be an integer from 0 to 20, and
R₁₀ₐ may be the same as described herein.

In Formulae 1-1 to 1-5, when a71 is 2 or more, two or more of R₇₁ may be identical to or different from each other; when a72 is 2 or more, two or more of R₇₂ may be identical to or different from each other; when a73 is 2 or more, two or more of R₇₃ may be identical to or different from each other; and when a74 is 2 or more, two or more of R₇₄ may be identical to or different from each other.

In an embodiment, in Formulae 1-1 and 1-2, a moiety represented by 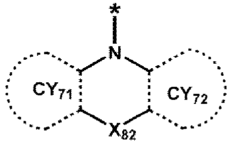 may be a moiety represented by one of Formulae CY71-1(1) to CY71-1(8), and/or
in Formulae 1-1 and 1-3, a moiety represented by 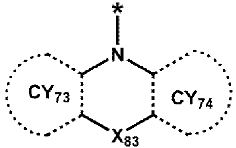 may be a moiety represented by one of Formulae CY71-2(1) to CY71-2(8), and/or
in Formulae 1-2 and 1-4, a moiety represented by 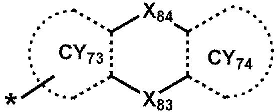 may be a moiety represented by one of Formulae CY71-3(1) to CY71-3(32), and/or
in Formulae 1-3 to 1-5, a moiety represented by 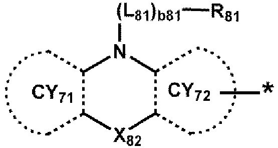 may be a moiety represented by one of Formulae CY71-4(1) to CY71-4(32), and/or
in Formula 1-5, a moiety represented by 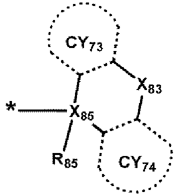 may be a moiety represented by one of Formulae CY71-5(1) to CY71-5(8):

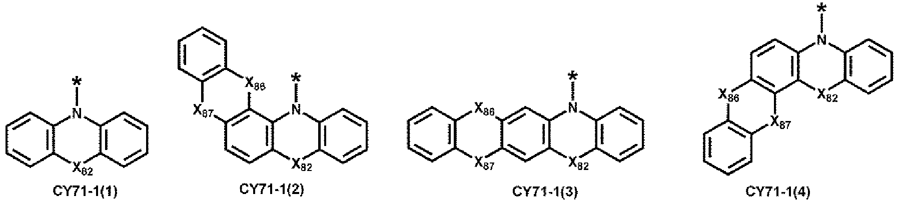

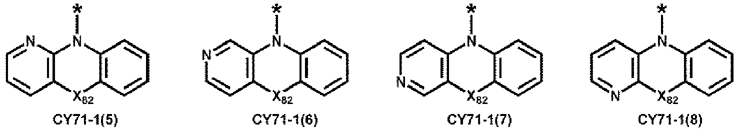

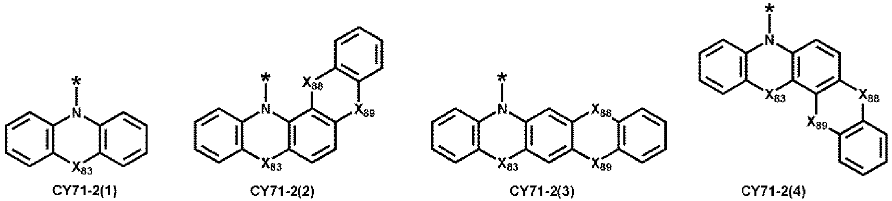

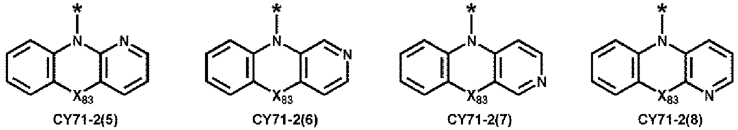

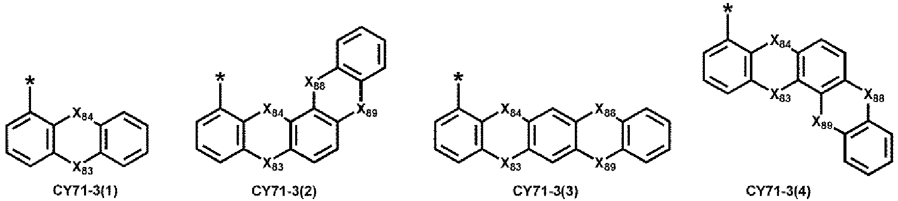

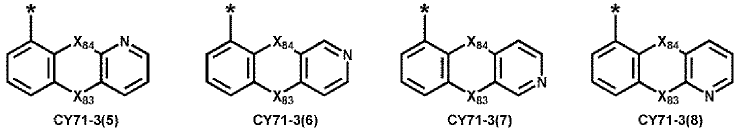

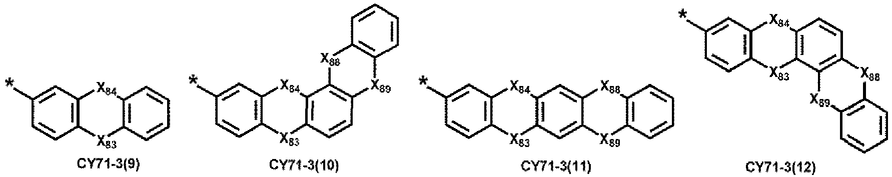

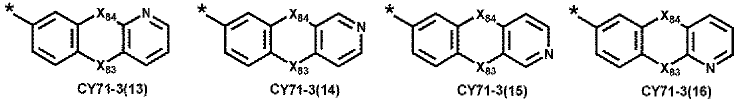

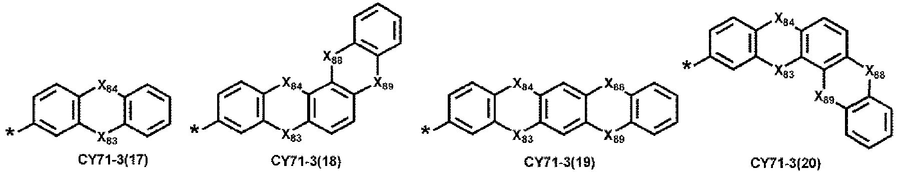

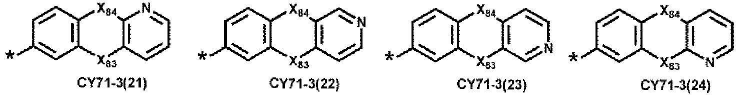

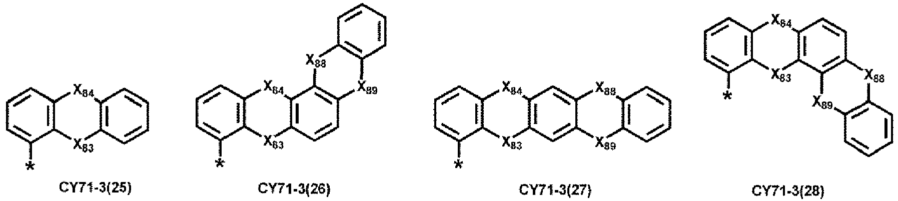

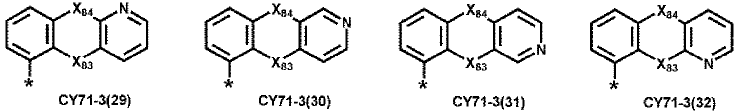

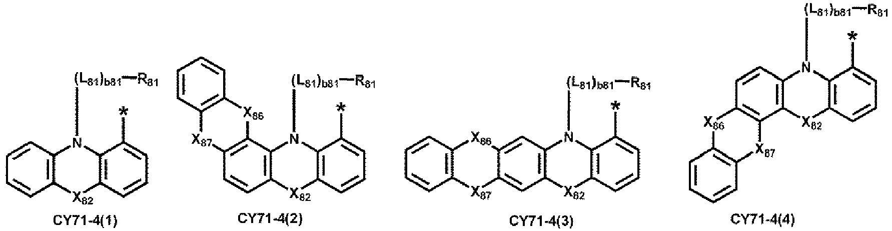

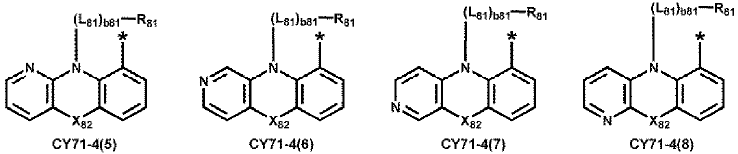

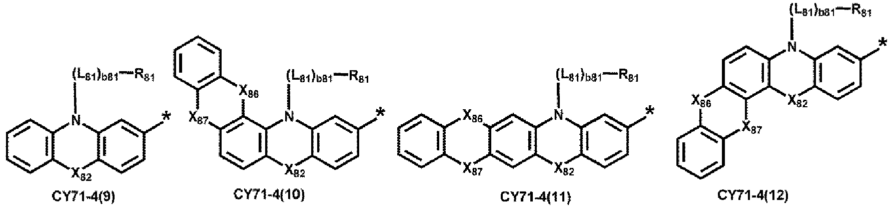

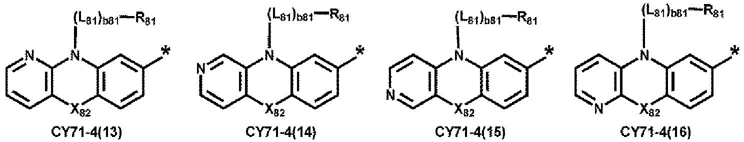

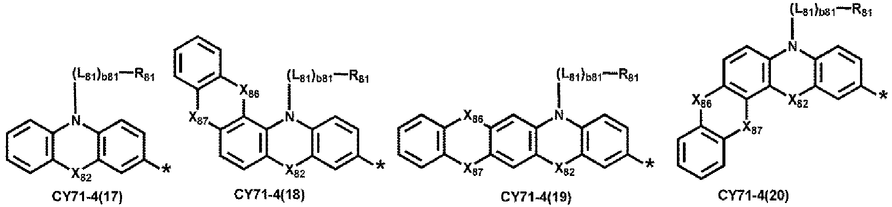

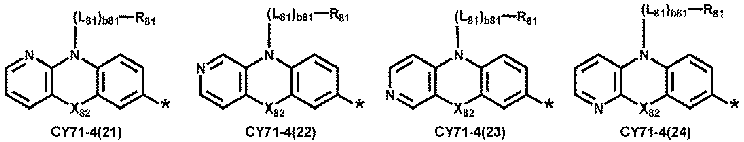

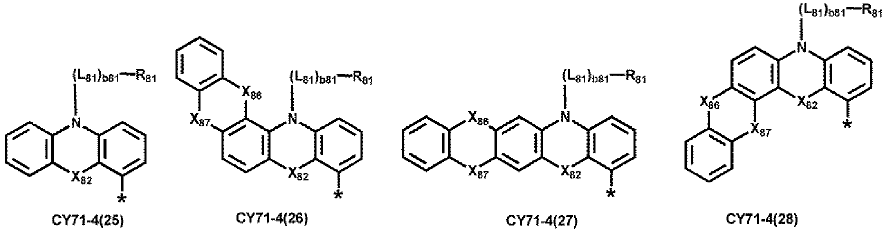

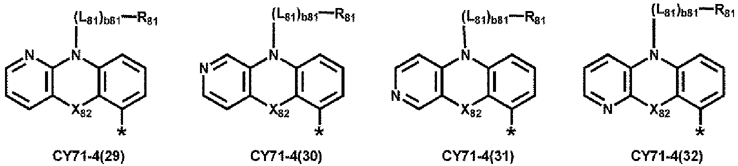

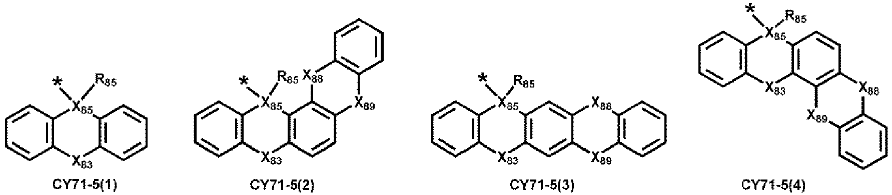

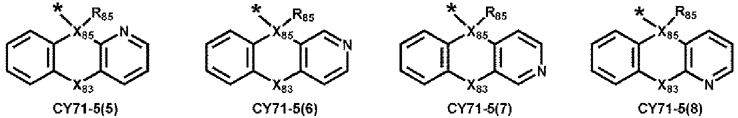

In Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₂ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R₈₇ₐ)(R_{87b}),
in Formulae CY71-1(1) to CY71-1(8) and CY71-4(1) to CY71-4(32), X₈₆ and X₈₇ may not each be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
in Formulae CY71-2(1) to CY71-2(8), CY71-3(1) to CY71-3(32), and CY71-5(1) to CY71-5(8), X₈₈ and X₈₉ may not each be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each independently be the same as described in connection with R₈₁.

In an embodiment, in Formulae 1-1 to 1-5, L₈₁ to L₈₅ may each independently be:
a single bond; or
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), -P(=O)(Q₃₁)(Q₃₂), or any combination thereof, and
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

### [Description of second host]

The second host may include at least one π electron-deficient nitrogen-containing C₁-C₆₀ cyclic group.

In an embodiment, the second host may include a pyridine group, a pyrimidine group, a pyrazine group, a pyridazine group, a triazine group, or any combination thereof.

In an embodiment, the second host may include a compound represented by Formula 2:

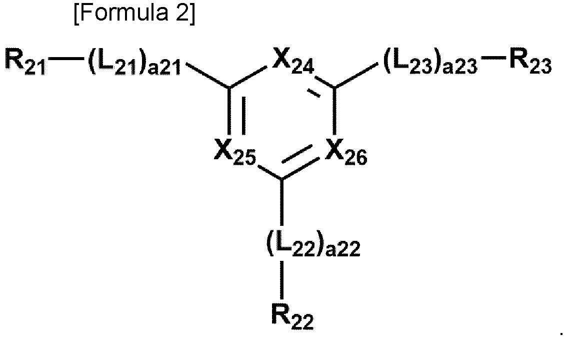

In Formula 2,
L₂₁ to L₂₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
a21 to a23 may each independently be an integer from 1 to 5,
X₂₄ may be N or C(R₂₄), X₂₅ may be N or C(R₂₅), X₂₆ may be N or C(R₂₆), and at least one of X₂₄ to X₂₆ may each be N,
R₂₁ to R₂₆ may each be the same as described herein, and
R₁₀ₐ may be the same as described herein.

In Formula 2, a21 to a23 respectively indicate the number of L₂₁ to the number of L₂₃, and a21 to a23 may each independently be an integer from 1 to 5. When a21 is 2 or more, two or more of L₂₁ may be identical to or different from each other, when a22 is 2 or more, two or more of L₂₂ may be identical to or different from each other, and when a23 is 2 or more, two or more of L₂₃ may be identical to or different from each other. For example, a21 to a23 may each independently be 1 or 2.

In an embodiment, in Formula 2, L₂₁ to L₂₃ may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzoxasiline group, a dibenzothiasiline group, a dibenzodihydroazasiline group, a dibenzodihydrodihydrodisiline group, a dibenzodihydrosiline group, a dibenzodioxine group, a dibenzoxathiine group, a dibenzoxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - O (Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof, and
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In an embodiment, in Formula 2, a21 and a22 may each independently be 1, 2, or 3; and L₂₁ and L₂₂ may each independently be a benzene group, a pyridine group, a pyrimidine group, a pyridazine group, a pyrazine group, or a triazine group, each unsubstituted or substituted with at least one R₁₀ₐ.

In an embodiment, in Formula 2, a bond between L₂₁ and R₂₁, a bond between L₂₂ and R₂₂, a bond between L₂₃ and R₂₃, a bond between two or more of L₂₁, a bond between two or more of L₂₂, a bond between two or more of L₂₃, a bond between L₂₁ and carbon between X₂₄ and X₂₅, a bond between L₂₂ and carbon between X₂₅ and X₂₆, and a bond between L₂₃ and carbon between X₂₄ and X₂₆ may each be a "carbon-carbon single bond."

In an embodiment, in Formula 2, two or three of X₂₄ to X₂₆ may each be N.

In an embodiment, in Formula 2, a moiety represented by *-(L₂₁)ₐ₂₁-R₂₁ and a moiety represented by *-(L₂₂)ₐ₂₂-R₂₂ may be identical to each other.

In embodiments, in Formula 2, a moiety represented by *-(L₂₁)ₐ₂₁-R₂₁ and a moiety represented by *-(L₂₂)ₐ₂₂-R₂₂ may be different from each other.

### [Description of first dopant]

In an embodiment, the first dopant may include a transition metal. For example, the transition metal may include iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm).

In an embodiment, the first dopant may include Pt.

In an embodiment, the first dopant may include two or more nitrogen-containing cyclic groups. Examples of a nitrogen-containing cyclic group may include a pyridine group, a pyrimidine group, a pyridazine group, a triazine group, an imidazole group, a benzimidazole group, a carbazole group, and the like.

In an embodiment, the first dopant may include a compound represented by Formula 31:

[Formula 31] M(L₃₁)ₐ₃₁(L₃₂)ₐ₃₂

In Formula 31,
M may be a transition metal,
L₃₁ may be a ligand represented by Formula 32, and a31 may be 1, 2, or 3, wherein when a31 is 2 or more, two or more of L₃₁ may be identical to or different from each other,
L₃₂ may be an organic ligand, and a32 may be 0, 1, 2, 3, or 4, wherein when a32 is 2 or more, two or more of L₃₂ may be identical to or different from each other:

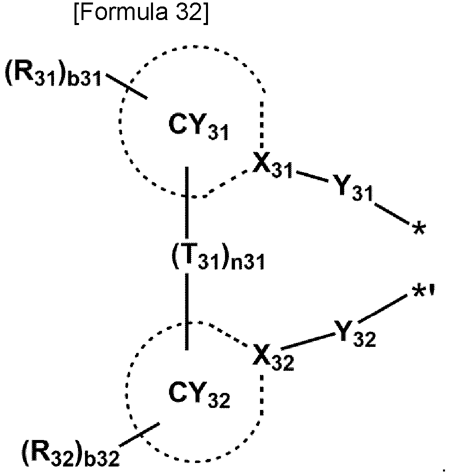

In Formula 32,
X₃₁ and X₃₂ may each independently be N or C,
Y₃₁ and Y₃₂ may each independently be a chemical bond, O, S, N(Q₃₁₁), B(Q₃₁₁), P(Q₃₁₁), C(Q₃₁₁)(Q₃₁₂), or Si(Q₃₁₁)(Q₃₁₂),
ring CY₃₁ and ring CY₃₂ may each independently be a C₃-C₆₀ carbocyclic group or a C₁-C₆₀ heterocyclic group,
T₃₁ may be a single bond, *-O-*', *-S-*', *-C(=O)-*', *-N(R₃₁ₐ)-*', *-C(R₃₁ₐ)(R_{31b})-*', *-C(R₃₁ₐ)=C(R_{31b})-*', *-C(R₃₁ₐ)=*', or *=C=*',
n31 may be an integer from 1 to 3,
R₃₁, R₃₂, R₃₁ₐ, and R_{31b} may each independently be hydrogen, deuterium, -F, - Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁₎(Q₃₀₂), -C(=O)(Q₃₀₁), -S(=O)₂(Q₃₀₁), or -P(=O)(Q₃₀₁)(Q₃₀₂),
b31 and b32 may each independently be an integer from 0 to 10,
Q₃₀₁ to Q₃₀₃, Q₃₁₁, and Q₃₁₂ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, or any combination thereof,
* and *' each indicate a binding site to M in Formula 31, and
R₁₀ₐ may be the same as described herein.

In an embodiment, the first dopant may include a compound represented by Formula 33:

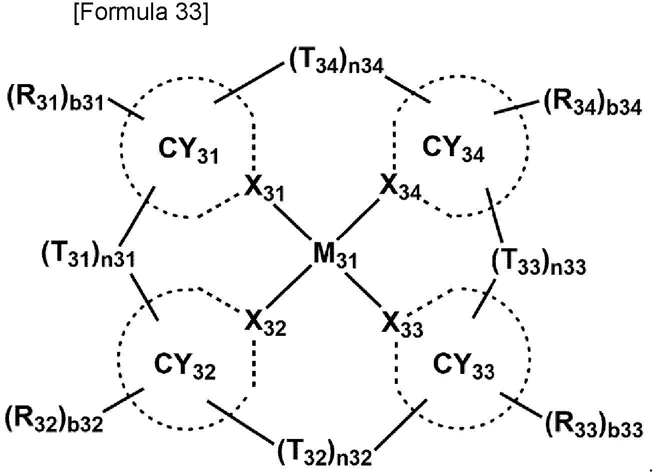

In Formula 33,
M₃₁ may be a transition metal,
X₃₁ to X₃₄ may each independently be C or N,
two of four bonds selected from a bond between X₃₁ and M₃₁, a bond between X₃₂ and M₃₁, a bond between X₃₃ and M₃₁, and a bond between X₃₄ and M₃₁ may each be a coordinate bond, and the remaining two bonds may each be a covalent bond.
ring CY₃₁ to ring CY₃₄ may each independently be a C₅-C₃₀ carbocyclic group or a C₁-C₃₀ heterocyclic group,
T₃₁ may be a single bond, *-O-*', *-S-*', *-C(=O)-*', *-N(R₃₅ₐ)-*', *-C(R₃₅ₐ)(R_{35b})-*', *-C(R₃₅ₐ)=C(R_{35b})-*', *-C(R₃₅ₐ)=*', or *=C=*',
T₃₂ may be a single bond, *-O-*', *-S-*', *-C(=O)-*', *-N(R₃₆ₐ)-*', *-C(R₃₆ₐ)(R_{36b})-*', *-C(R₃₆ₐ)=C(R_{36b})-*', *-C(R₃₆ₐ)=*', or *=C=*',
T₃₃ may be a single bond, *-O-*', *-S-*', *-C(=O)-*', *-N(R₃₇ₐ)-*', *-C(R₃₇ₐ)(R_{37b})-*', *-C(R₃₇ₐ)=C(R_{37b})-*', *-C(R₃₇ₐ)=*', or *=C=*',
T₃₄ may be a single bond, *-O-*', *-S-*', *-C(=O)-*', *-N(R₃₈ₐ)-*', *-C(R₃₈ₐ)(R_{38b})-*', *-C(R₃₈ₐ)=C(R_{38b})-*', *-C(R₃₈ₐ)=*', or *=C=*',
n31 to n34 may each independently be an integer from 0 to 5, provided that three or more of n31 to n34 may each independently be an integer from 1 to 5,
when n31 is 0, T₃₁ is absent; when n32 is 0, T₃₂ is absent; when n33 is 0, T₃₃ is absent; and when n34 is 0, T₃₄ is absent,
when n31 is 2 or more, two or more of T₃₁ may be identical to or different from each other, when n32 is 2 or more, two or more of T₃₂ may be identical to or different from each other, when n33 is 2 or more, two or more of T₃₃ may be identical to or different from each other, and when n34 is 2 or more, two or more of T₃₄ may be identical to or different from each other,
R₃₁ to R₃₄, R₃₅ₐ, R_{35b}, R₃₆ₐ, R_{36b}, R₃₇ₐ, R_{37b}, R₃₈ₐ, and R_{38b} may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkenyl group unsubstituted or substituted with at least one R₁₀ₐ, a C₁-C₂₀ alkynyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
b31 to b34 may each independently be an integer from 0 to 20,
two or more of R₃₁ in the number of b31 may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₂ in the number of b32 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₃ in the number of b33 may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₄ in the number of b34 may optionally be bonded together to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₁ to R₃₄, R₃₅ₐ, R_{35b}, R₃₆ₐ, R_{36b}, R₃₇ₐ, R_{37b}, R₃₈ₐ, and R_{38b} may optionally be bonded to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₁₀ₐ and Q₃₀₁ to Q₃₀₃ may each be the same as described herein.

In an embodiment, the first dopant may include a compound represented by Formula 33-1 or Formula 33-2:

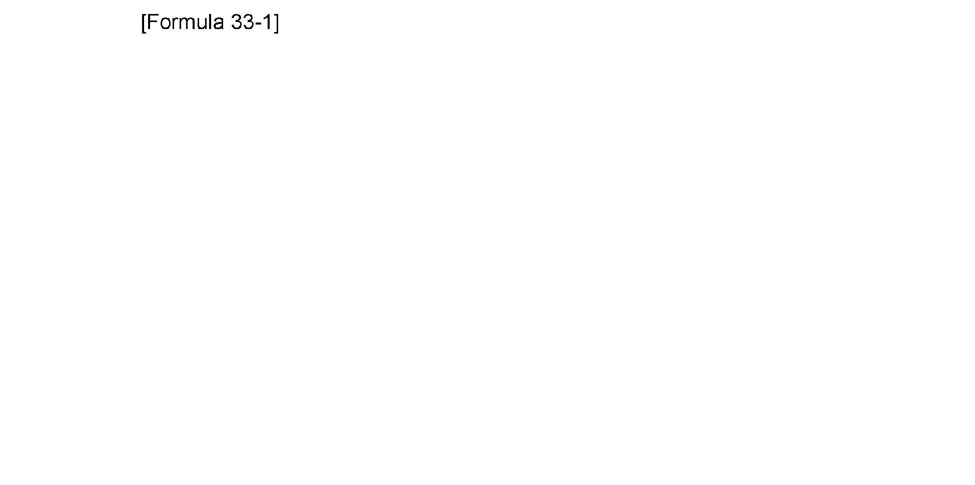

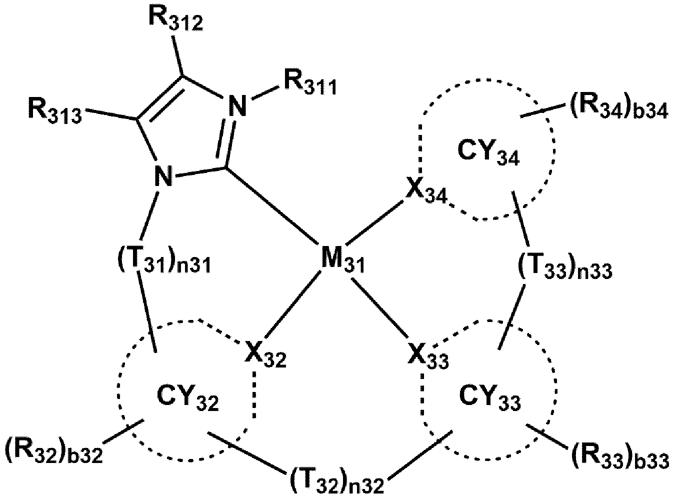

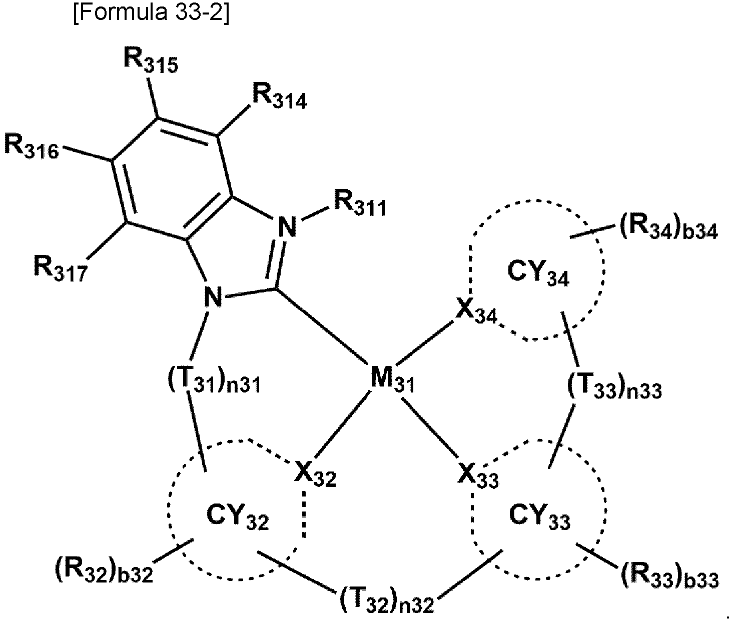

In Formulae 33-1 and 33-2,
M₃₁, X₃₂ to X₃₄, T₃₁ to T₃₃, n31 to n33, ring CY₃₂ to ring CY₃₄, R₃₂ to R₃₄, and b32 to b34 may each be the same as described herein, and
R₃₁₁ to R₃₁₇ may each independently be the same as described in connection with R₃₁ as described herein.

### [Description of second dopant]

In an embodiment, the second dopant may emit delayed fluorescence.

In an embodiment, a difference between a triplet energy level (eV) and a singlet energy level (eV) in the second dopant may be in a range of about 0 eV to about 0.3 eV.

In an embodiment, the second dopant may include at least one cyclic group that includes B and N as ring-forming atoms.

In an embodiment, the second dopant may be a C₈-C₆₀ polycyclic group-containing compound that includes two or more cyclic groups that are condensed together while sharing a boron (B) atom.

In an embodiment, the second dopant may include a condensed ring in which at least one third ring is condensed with at least one fourth ring, wherein
the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and
the fourth ring may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In an embodiment, the second dopant may be a compound represented by Formula 41, a compound represented by Formula 42, or any combination thereof:

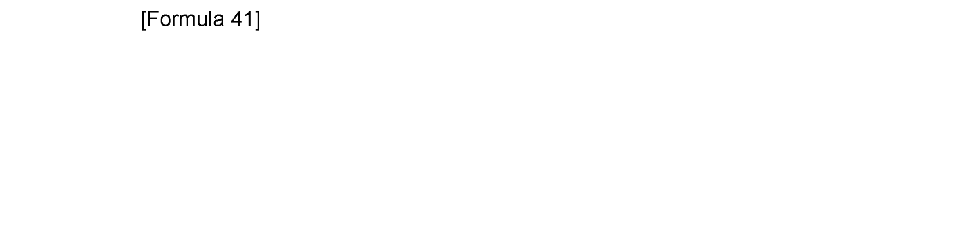

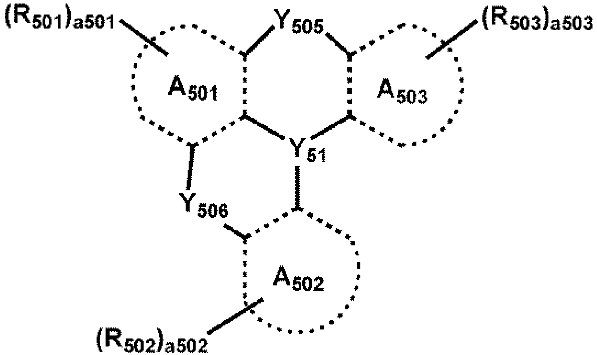

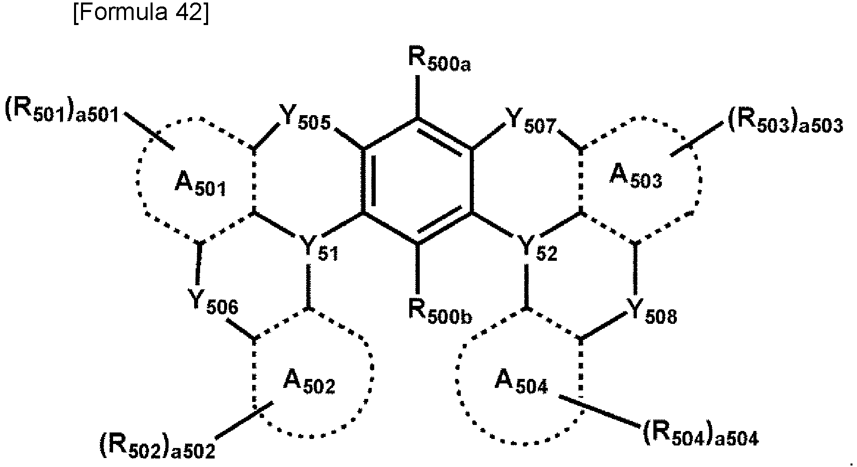

In Formulae 41 and 42,
ring A₅₀₁ to ring A₅₀₄ may each independently be a C₃-C₆₀ carbocyclic group or a C₁-C₆₀ heterocyclic group,
Y₅₀₅ may be O, S, N(R₅₀₅), B(R₅₀₅), C(R₅₀₅ₐ)(R_{505b}), or Si(R₅₀₅ₐ)(R_{505b}),
Y₅₀₆ may be O, S, N(R₅₀₆), B(R₅₀₆), C(R₅₀₆ₐ)(R_{506b}), or Si(R₅₀₆ₐ)(R_{506b}),
Y₅₀₇ may be O, S, N(R₅₀₇), B(R₅₀₇), C(R₅₀₇ₐ)(R_{507b}), or Si(R₅₀₇ₐ)(R_{507b}),
Y₅₀₈ may be O, S, N(R₅₀₈), B(R₅₀₈), C(R₅₀₈ₐ)(R_{508b}), or Si(R₅₀₈ₐ)(R_{508b}),
Y₅₁ and Y₅₂ may each independently be B, P(=O), or S(=O),
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each be the same as described herein,
a501 to a504 may each independently be an integer from 0 to 20, and
R₁₀ₐ may be the same as described herein.

In Formulae 41 and 42, when a501 is 2 or more, two or more of R₅₀₁ may be identical to or different from each other; when a502 is 2 or more, two or more of R₅₀₂ may be identical to or different from each other; when a503 is 2 or more, two or more of R₅₀₃ may be identical to or different from each other; and when a504 is 2 or more, two or more of R₅₀₄ may be identical to or different from each other.

In the specification, R₇₁ to R₇₄, R₈₁ to R₈₅, R₈₂ₐ, R_{82b}, R₈₃ₐ, R_{83b}, R₈₄ₐ, and R_{84b} in Formulae 1 and 1-1 to 1-5, R₂₁ to R₂₆ in Formula 2, R₃₁ to R₃₄, R₃₅ₐ, R_{35b}, R₃₆ₐ, R_{36b}, R₃₇ₐ, R_{37b}, R₃₈ₐ, and R_{38b} in Formula 3, and R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} Formulae 41 and 42 may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ,-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂). Q₁ to Q₃ may each be the same as described herein.

In an embodiment, R₇₁ to R₇₄, R₈₁ to R₈₅, R₈₂ₐ, R_{82b}, R₈₃ₐ, R_{83b}, R₈₄ₐ, and R_{84b} in Formulae 1 and 1-1 to 1-5, R₂₁ to R₂₆ in Formula 2, and R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 41 and 42 may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof:

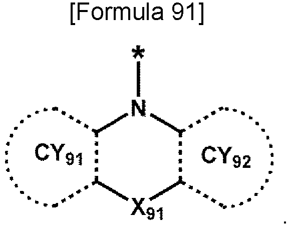

In Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} may respectively be the same as described in connection with R₈₂, R₈₂ₐ, and R_{82b}, as described herein,
R₁₀ₐ may be the same as described herein, and
* indicates a binding site to a neighboring atom.

In an embodiment, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be:
   hydrogen or a C₁-C₁₀ alkyl group; or
   a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In an embodiment, R₇₁ to R₇₄, R₈₁ to R₈₅, R₈₂ₐ, R_{82b}, R₈₃ₐ, R_{83b}, R₈₄ₐ, and R_{84b} in Formulae 1 and 1-1 to 1-5, R₂₁ to R₂₆ in Formula 2, and R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 41 and 42 may each independently be:
hydrogen, deuterium, -F, a cyano group, a nitro group, -CH₃, -CD₃, -CD₂H, - CDH₂, -CF₃, -CF₂H, -CFH₂, a group represented by one of Formulae 9-1 to 9-19, a group represented by one of Formulae 10-1 to 10-246, -C(Q₁)(Q₂)(Q₃), -Si(Q₁)(Q₂)(Q₃), or -P(=O)(Q₁)(Q₂) (wherein Q₁ to Q₃ may each be the same as described herein):

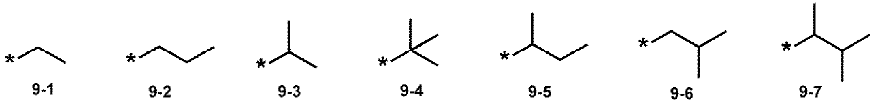

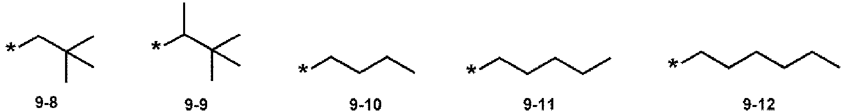

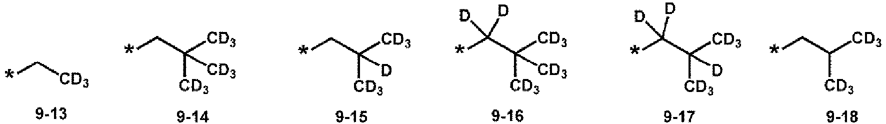

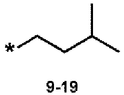

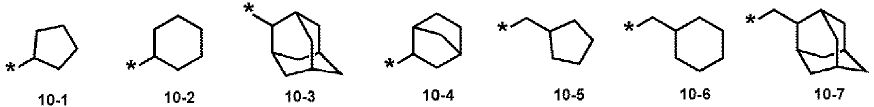

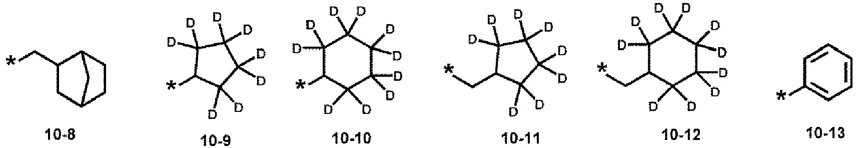

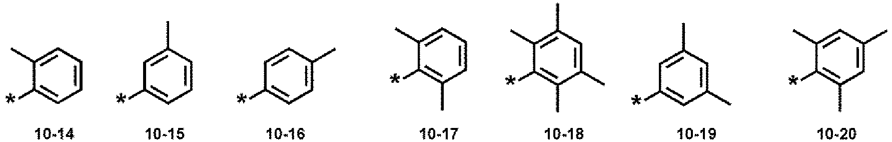

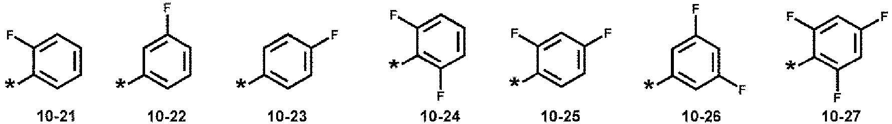

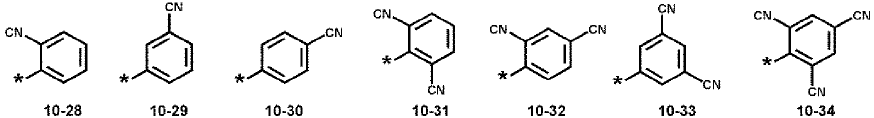

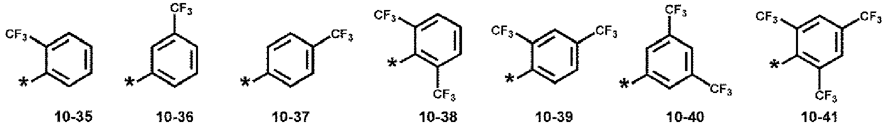

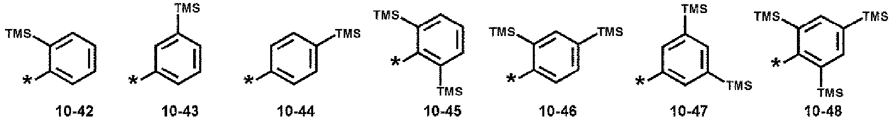

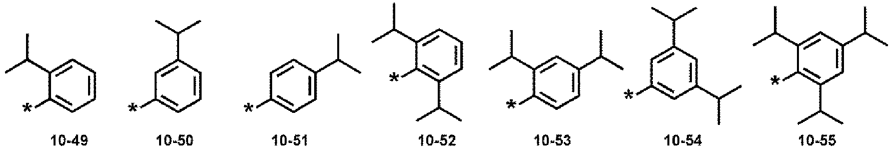

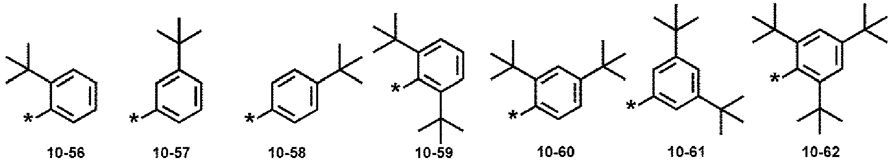

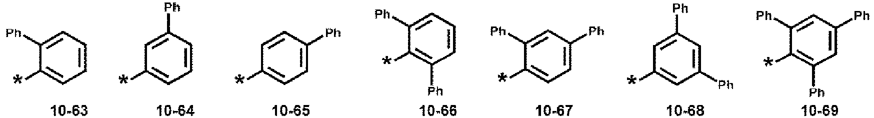

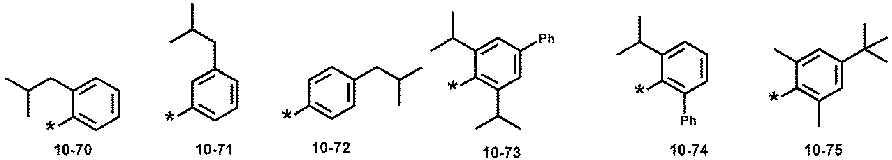

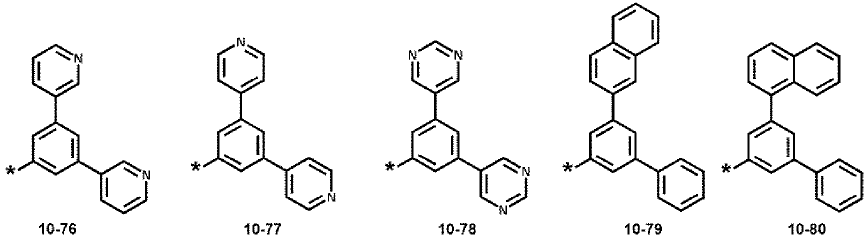

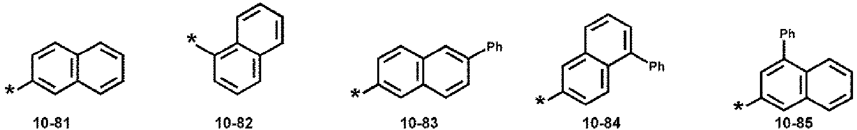

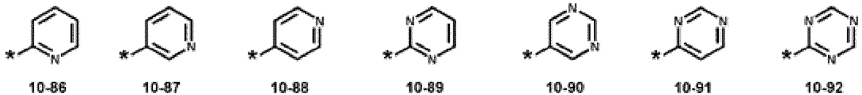

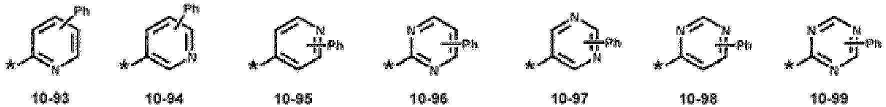

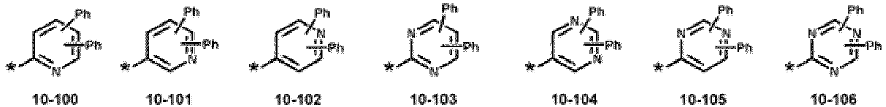

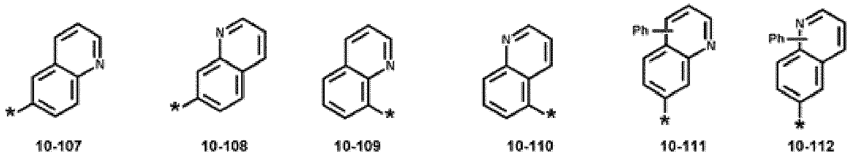

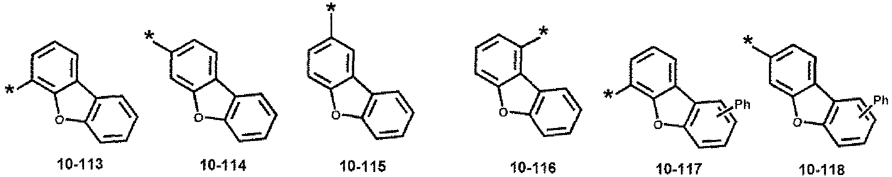

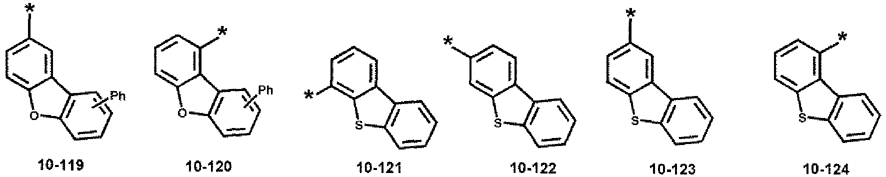

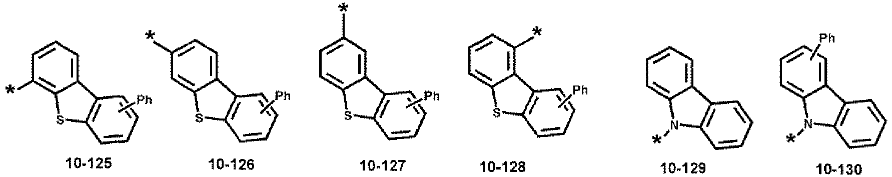

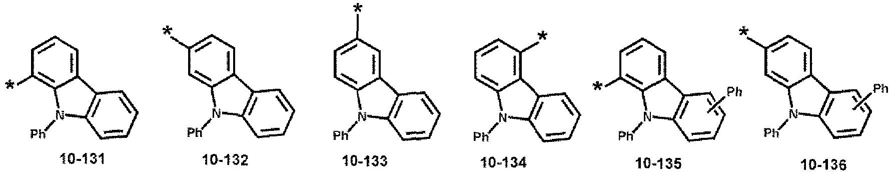

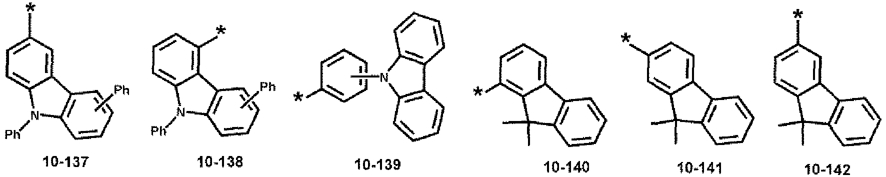

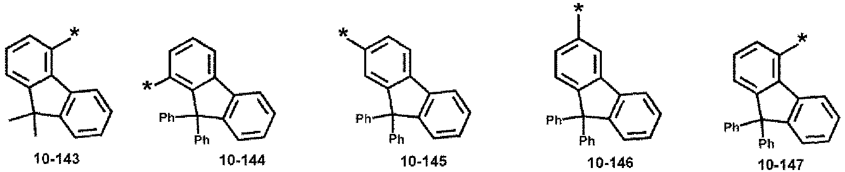

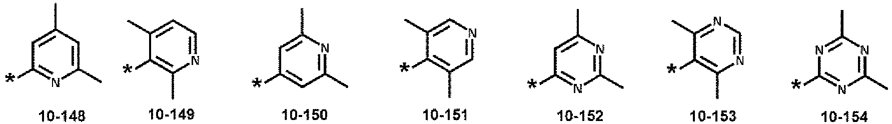

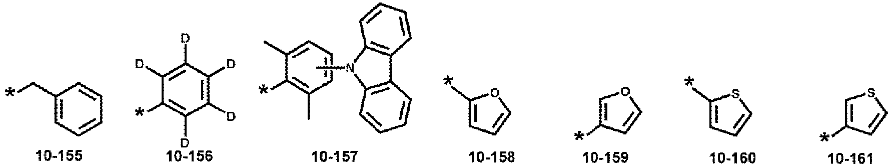

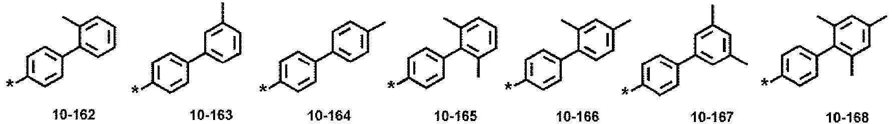

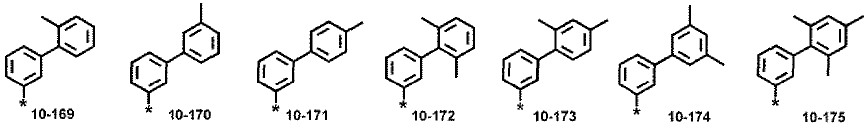

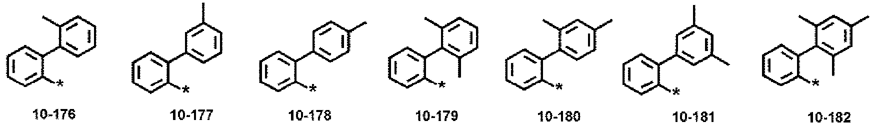

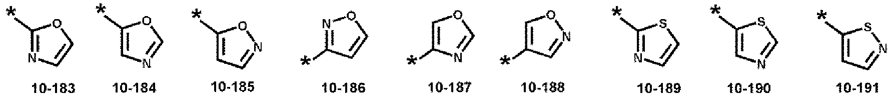

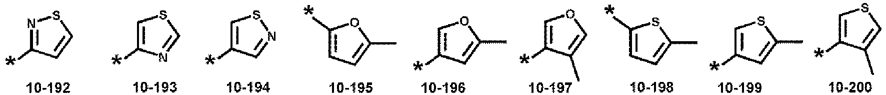

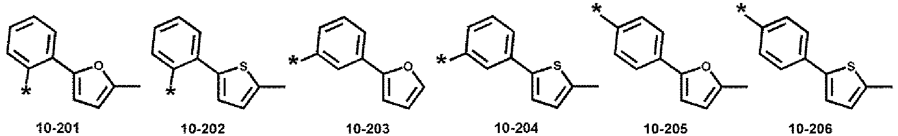

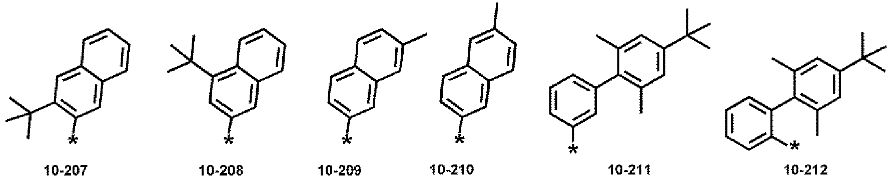

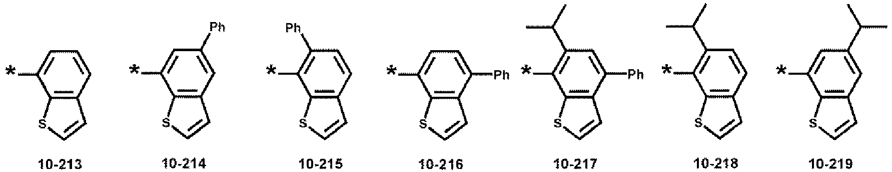

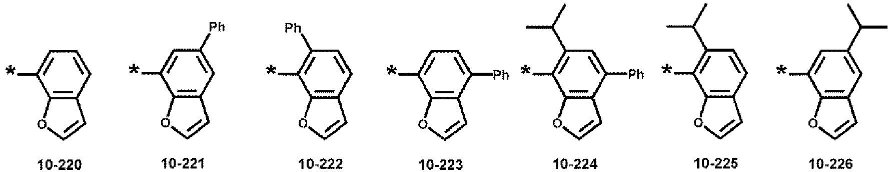

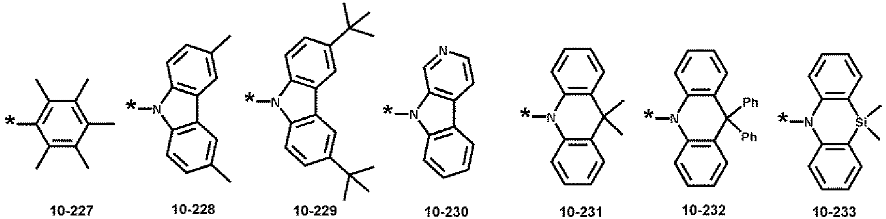

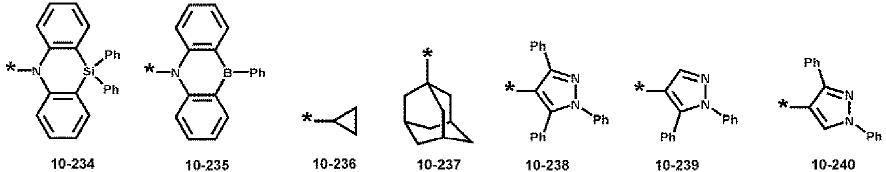

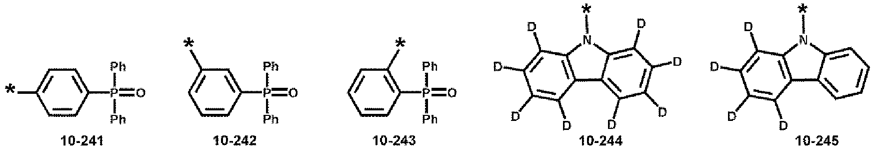

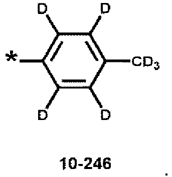

In Formulae 9-1 to 9-19 and 10-1 to 10-246, * indicates a binding site to a neighboring atom, Ph represents a phenyl group, and TMS represents a trimethylsilyl group.

In an embodiment, in Formula 2, R₂₁ and R₂₂ may each independently be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), or -Si(Q₁)(Q₂)(Q₃), and

Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment, in Formula 2,
a moiety represented by *-(L₂₁)ₐ₂₁-R₂₁ may be a group represented by one of Formulae CY51-1 to CY51-26, and/or
a moiety represented by *-(L₂₂)ₐ₂₂-R₂₂ may be a group represented by one of Formulae CY52-1 to CY52-26, and/or
a moiety represented by *-(L₂₃)ₐ₂₃-R₂₃ in Formula 2 may be a group represented by one of Formulae CY53-1 to CY53-27, -C(Q₁)(Q₂)(Q₃), or -Si(Q₁)(Q₂)(Q₃) (wherein Q₁ to Q₃ may each be the same as described herein):

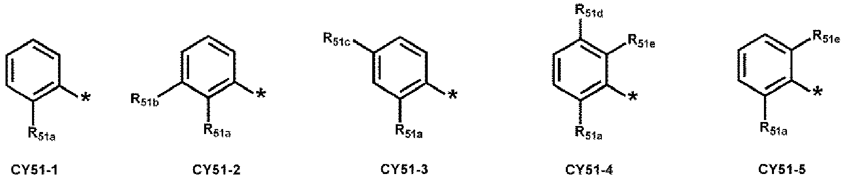

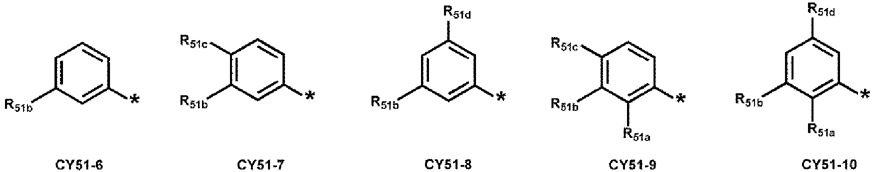

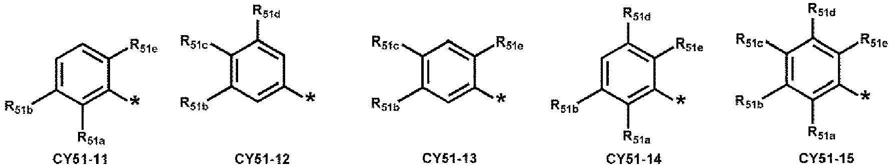

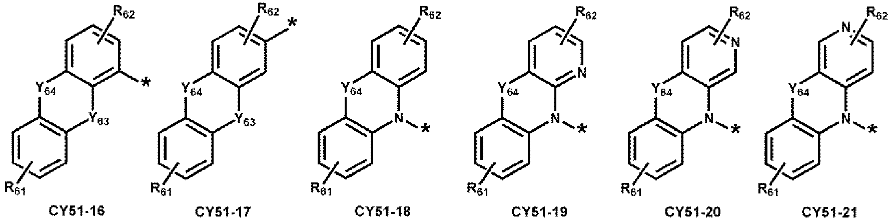

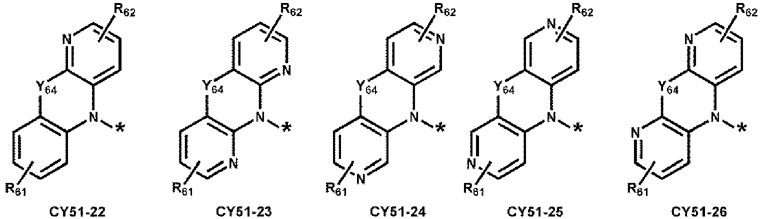

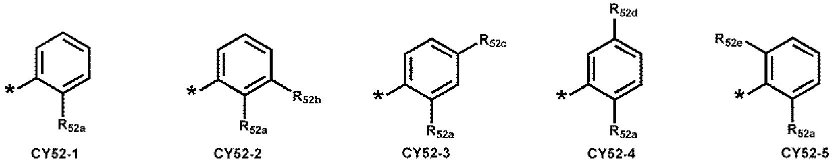

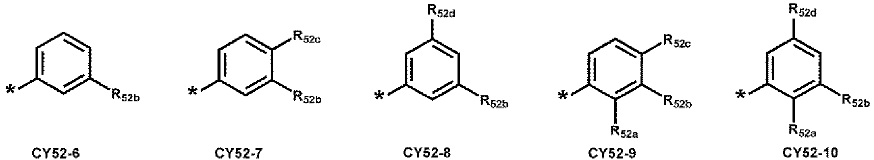

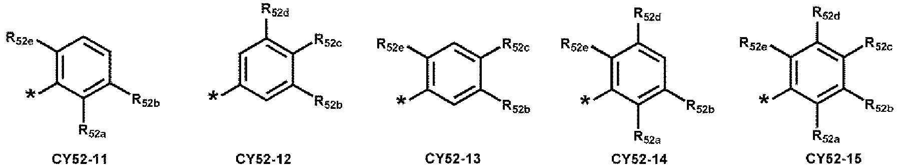

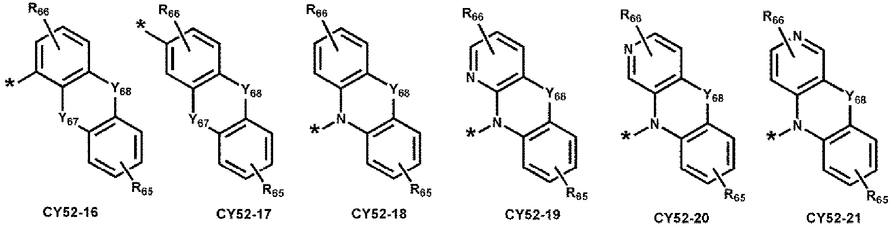

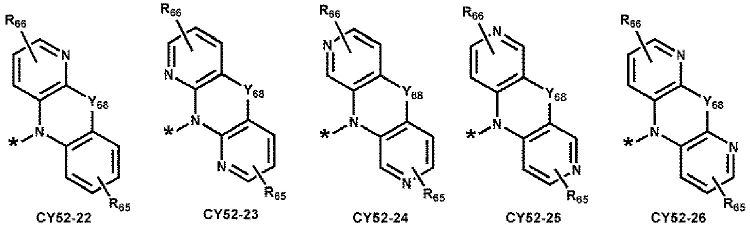

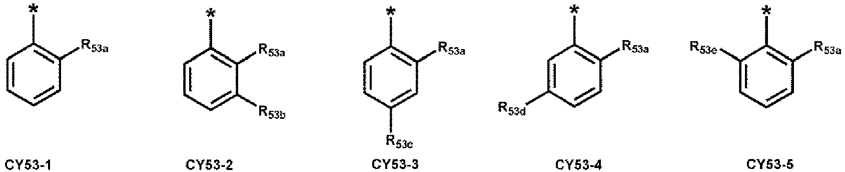

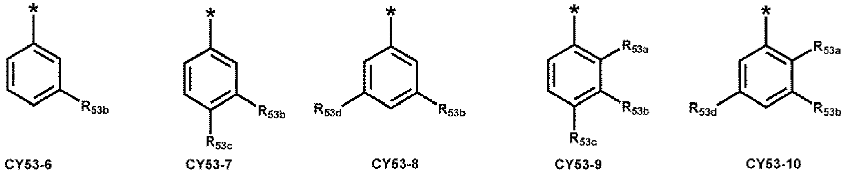

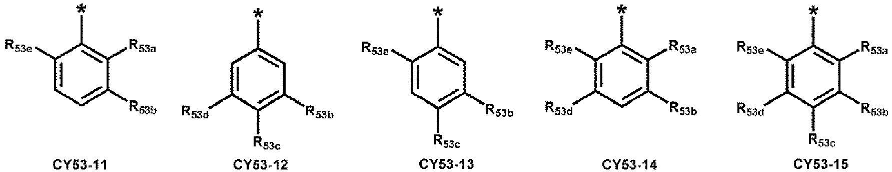

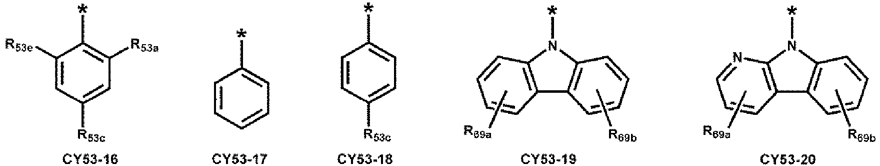

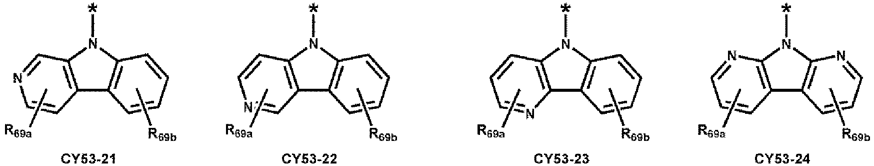

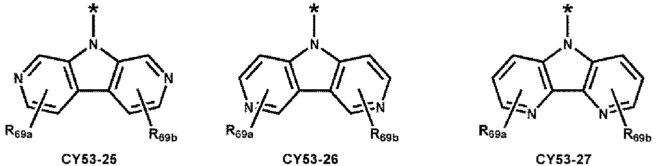

In Formulae CY51-1 to CY51-26, CY52-1 to CY52-26, and CY53-1 to CY53-27,
Y₆₃ may be a single bond, O, S, N(R₆₃), B(R₆₃), C(R₆₃ₐ)(R_{63b}), or Si(R₆₃ₐ)(R_{63b}),
Y₆₄ may be a single bond, O, S, N(R₆₄), B(R₆₄), C(R₆₄ₐ)(R_{64b}), or Si(R₆₄ₐ)(R_{64b}),
Y₆₇ may be a single bond, O, S, N(R₆₇), B(R₆₇), C(R₆₇ₐ)(R_{67b}), or Si(R₆₇ₐ)(R_{67b}),
Y₆₈ may be a single bond, O, S, N(R₆₈), B(R₆₈), C(R₆₈ₐ)(R_{68b}), or Si(R₆₈ₐ)(R_{68b}),
Y₆₃ and Y₆₄ in Formulae CY51-16 and CY51-17 may each not be a single bond at the same time,
Y₆₇ and Y₆₈ in Formulae CY52-16 and CY52-17 may each not be a single bond at the same time,
R₅₁ₐ to R₅₁ₑ, R₆₁ to R₆₄, R₆₃ₐ, R_{63b}, R₆₄ₐ, and R_{64b} may each independently be the same as described in connection with R₂₁, except that R₅₁ₐ to R₅₁ₑ may each not be hydrogen,
R₅₂ₐ to R₅₂ₑ, R₆₅ to R₆₈, R₆₇ₐ, R_{67b}, R₆₈ₐ, and R_{68b} may each independently be the same as described in connection with R₂₂, except that R₅₂ₐ to R₅₂ₑ may each not be hydrogen,
R₅₃ₐ to R₅₃ₑ, R₆₉ₐ, and R_{69b} may each independently be the same as described in connection with R₂₃, except that R₅₃ₐ to R₅₃ₑ may each not be hydrogen, and
* indicates a binding site to a neighboring atom.

In an embodiment,
in Formulae CY51-1 to CY51-26 and CY52-1 to CY52-26, R₅₁ₐ to R₅₁ₑ and R₅₂ₐ to R₅₂ₑ may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
-C(Q₁)(Q₂)(Q₃) or -Si(Q₁)(Q₂)(Q₃),
Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof,
in Formulae CY51-16 and CY51-17, Y₆₃ may be O or S, and Y₆₄ may be Si(R₆₄ₐ)(R_{64b}); or Y₆₃ may be Si(R₆₃ₐ)(R_{63b}), and Y₆₄ may be O or S, and
in Formulae CY52-16 and CY52-17, Y₆₇ may be O or S, and Y₆₈ may be Si(R₆₈ₐ)(R_{68b}); or Y₆₇ may be Si(R₆₇ₐ)(R_{67b}), and Y₆₈ may be O or S.

### [Embodiments of first host, second host, first dopant, and second dopant]

In an embodiment, the first host may include one of Compounds HTH1 to HTH61:

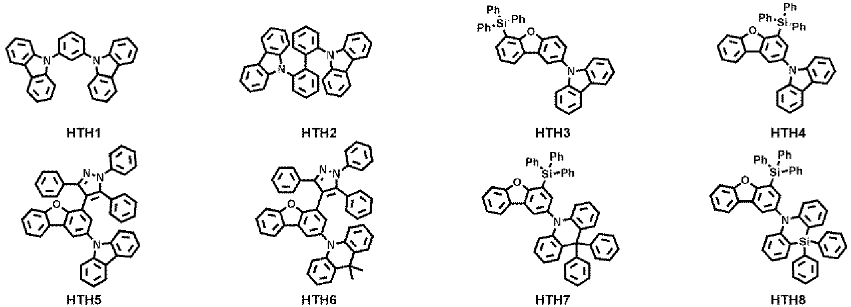

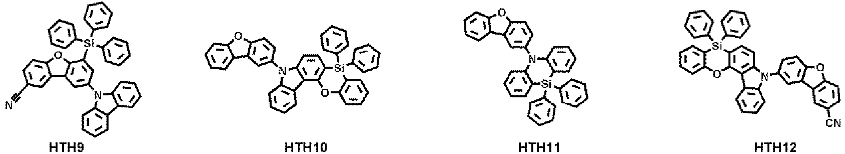

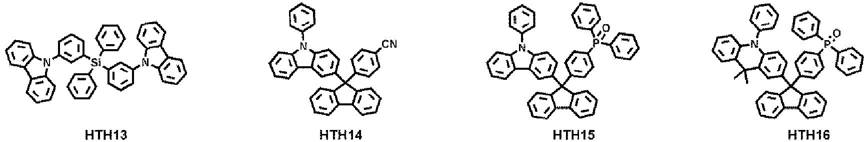

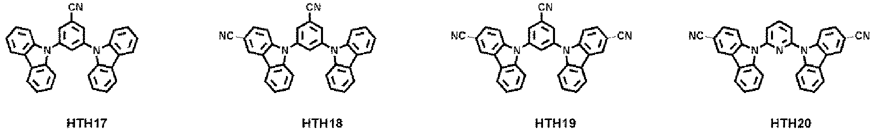

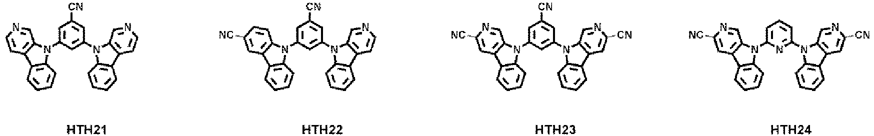

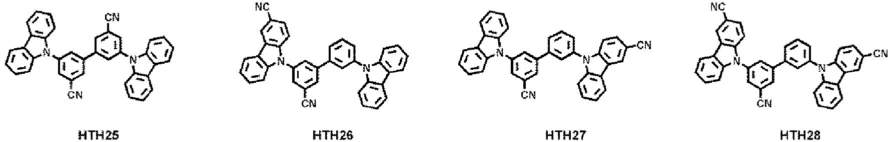

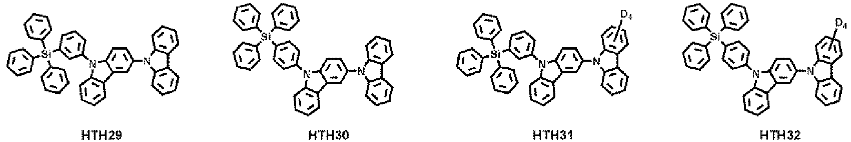

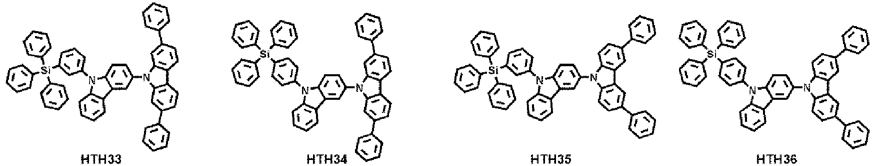

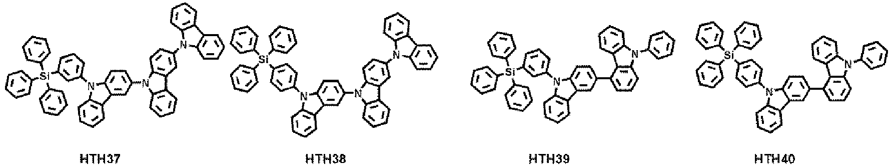

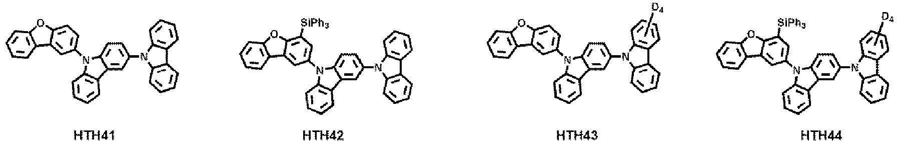

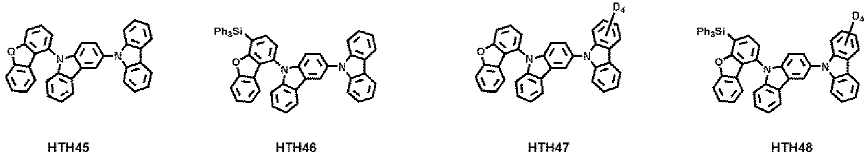

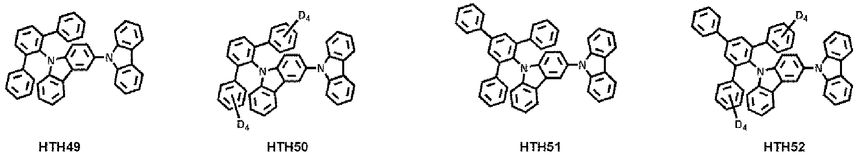

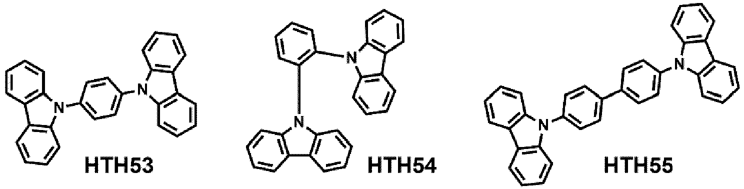

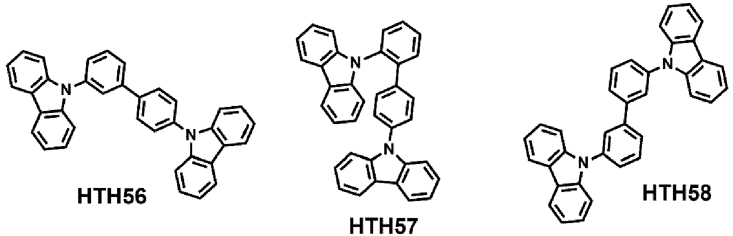

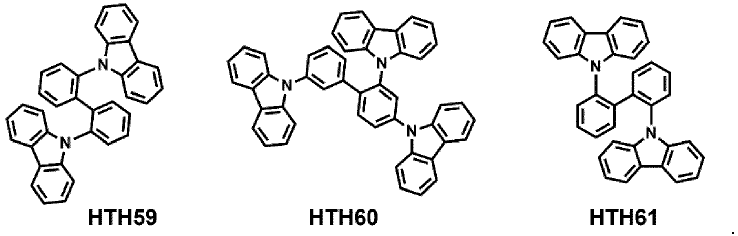

In an embodiment, the second host may include one of Compounds ETH1 to ETH104:

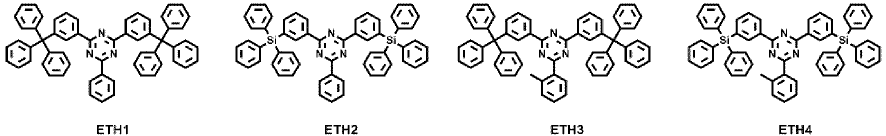

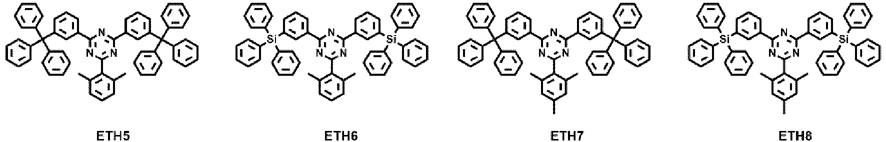

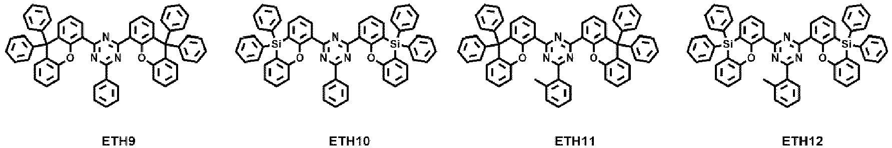

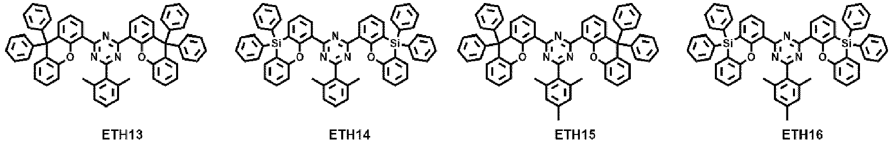

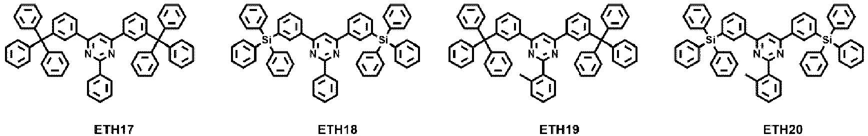

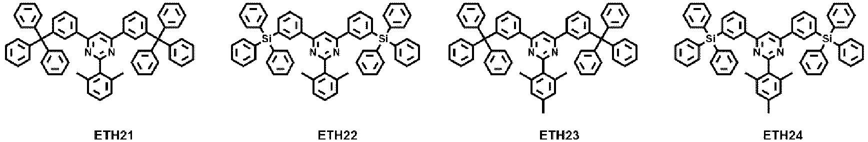

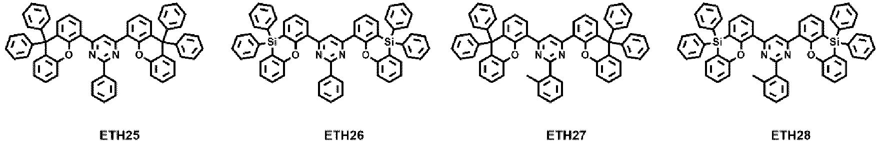

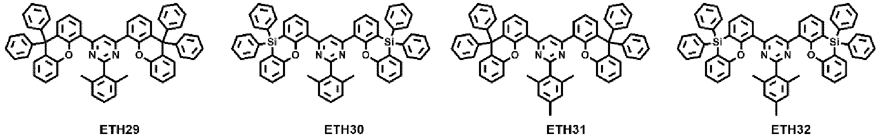

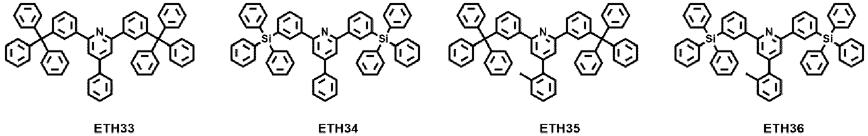

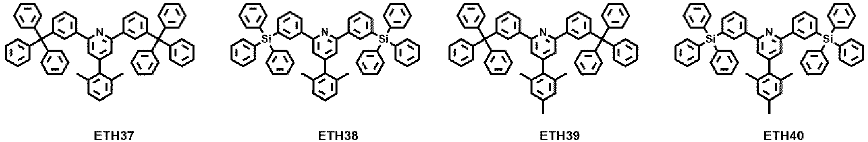

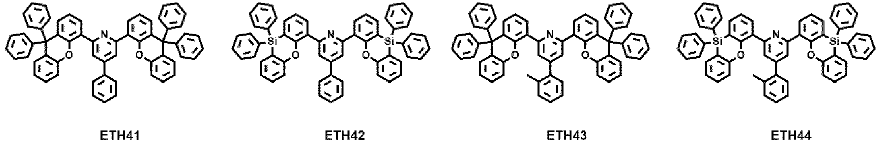

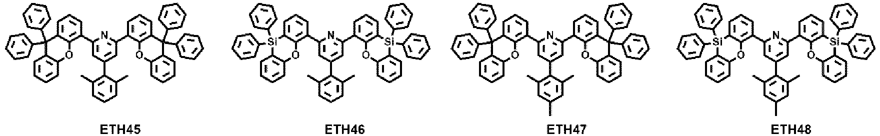

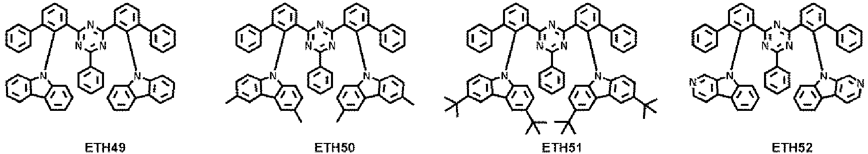

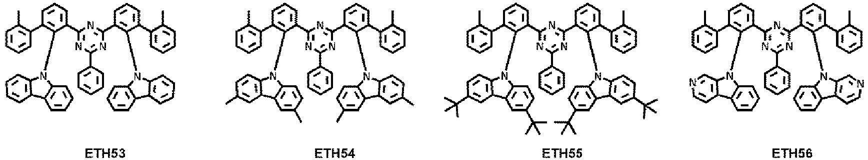

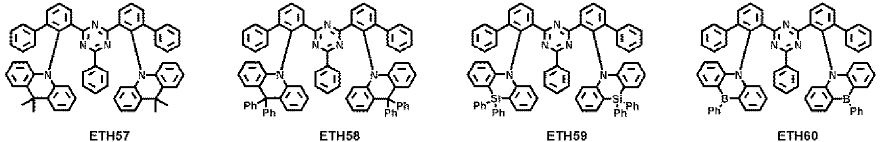

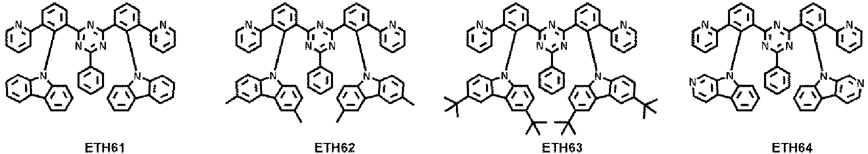

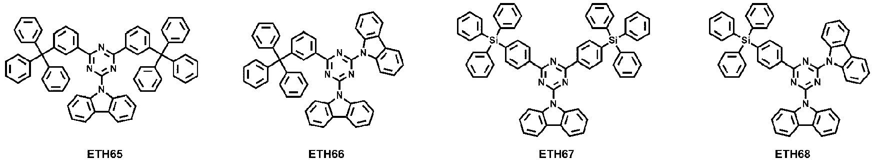

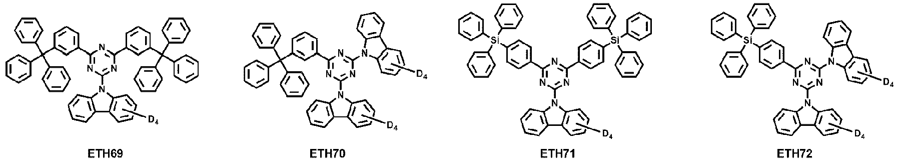

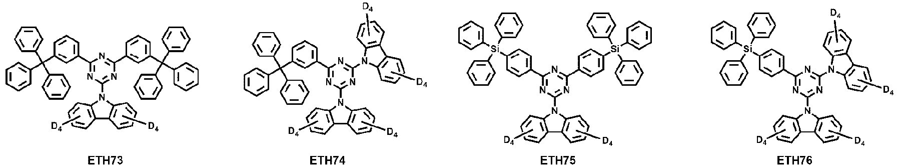

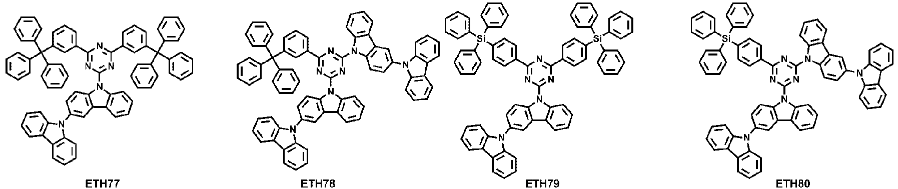

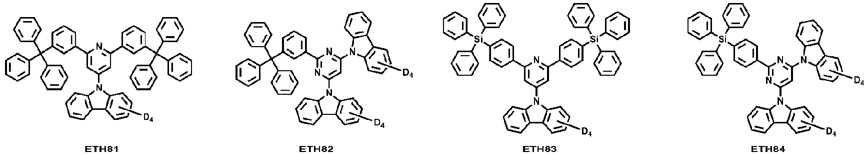

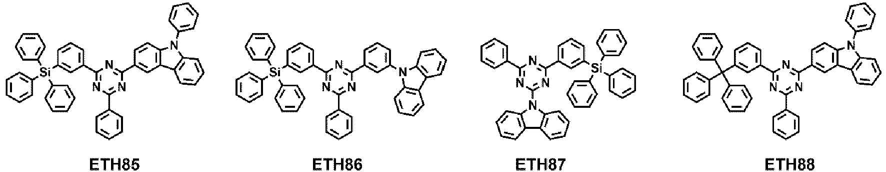

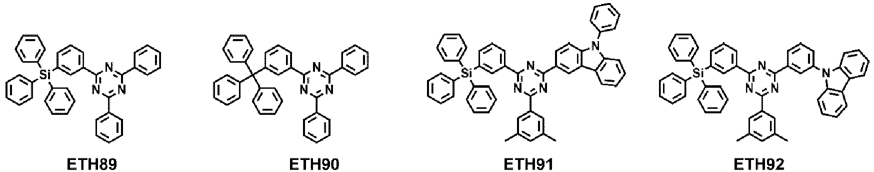

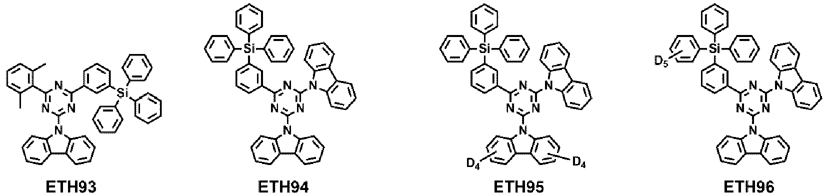

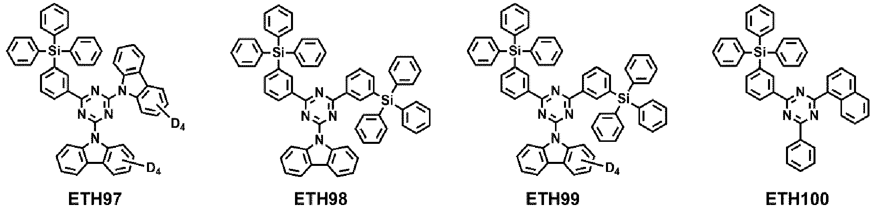

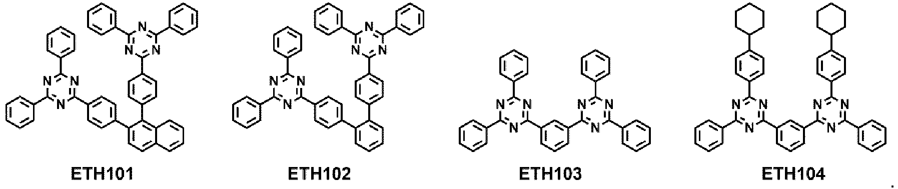

In an embodiment, the first dopant may include at least one of Compounds PD1 to PD57:

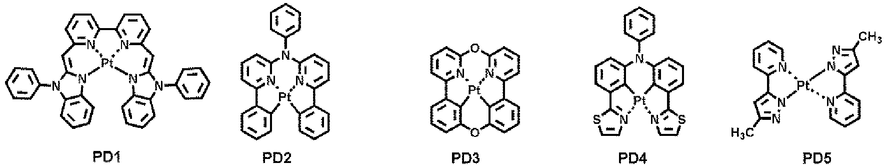

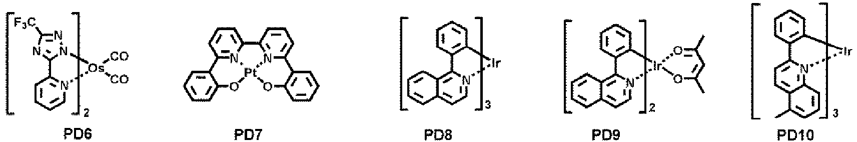

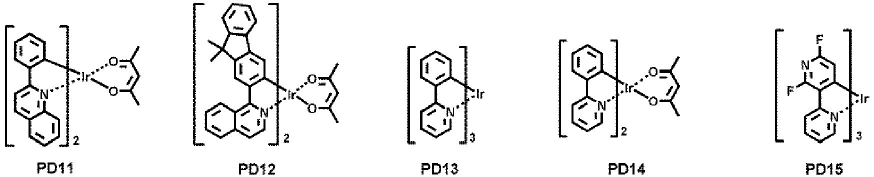

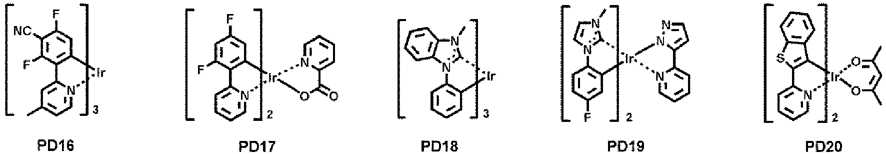

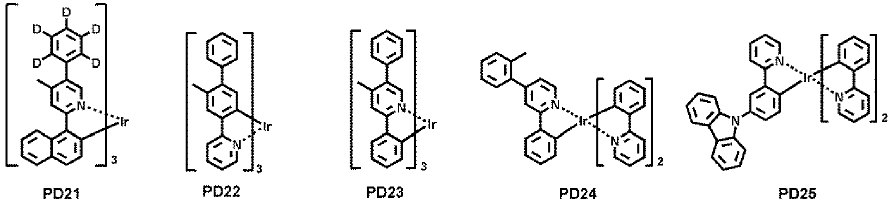

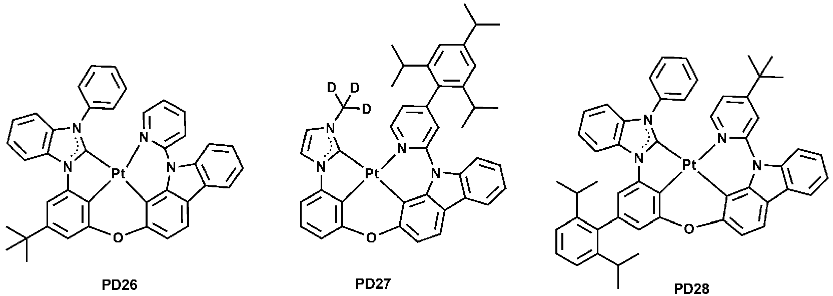

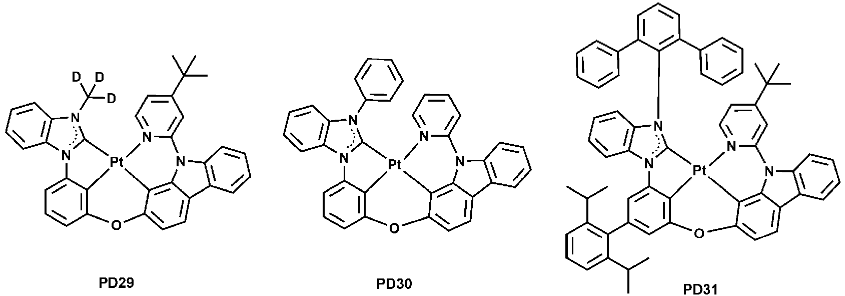

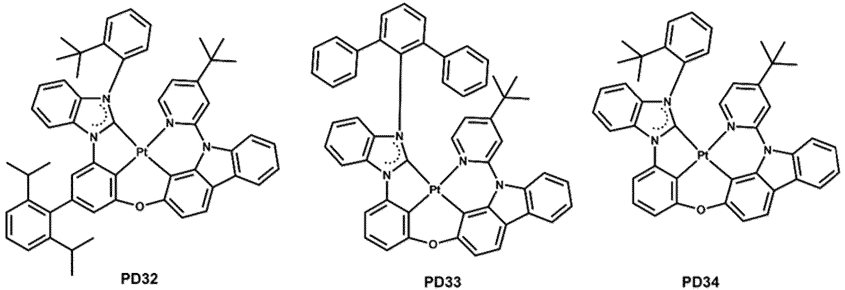

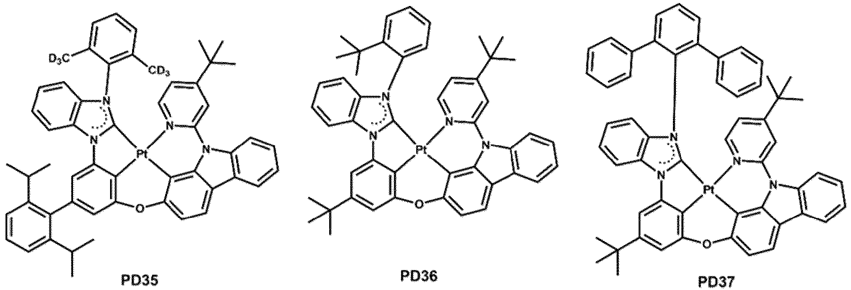

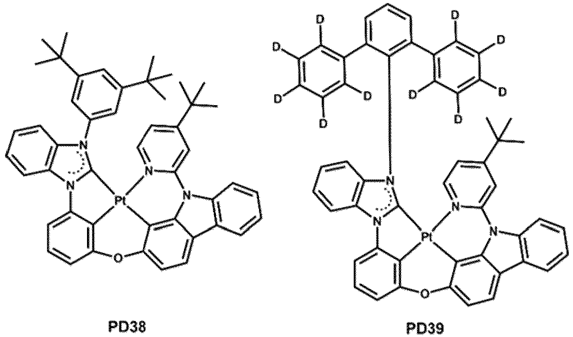

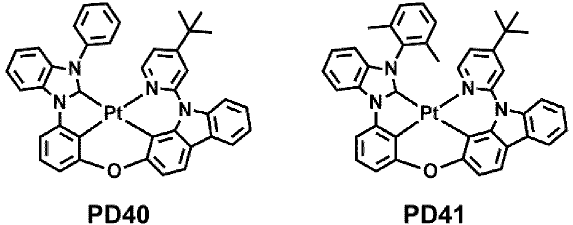

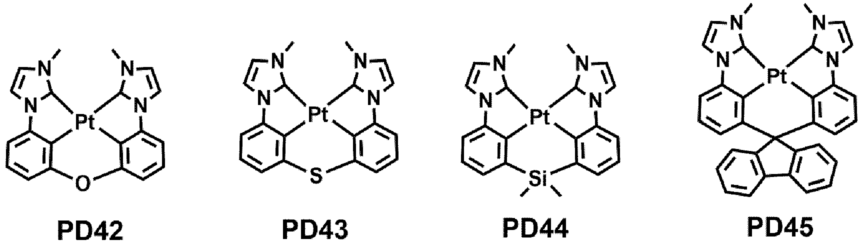

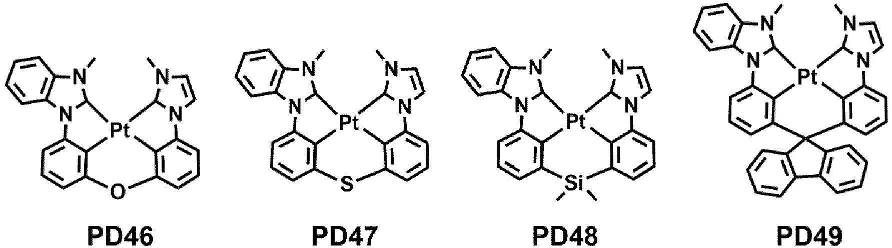

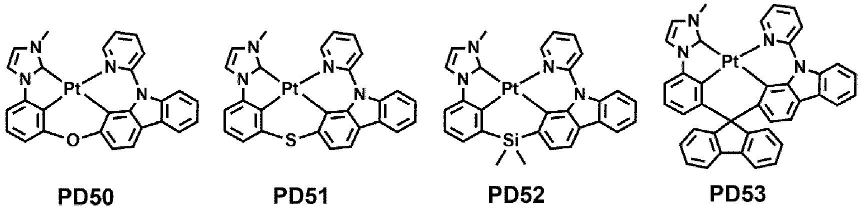

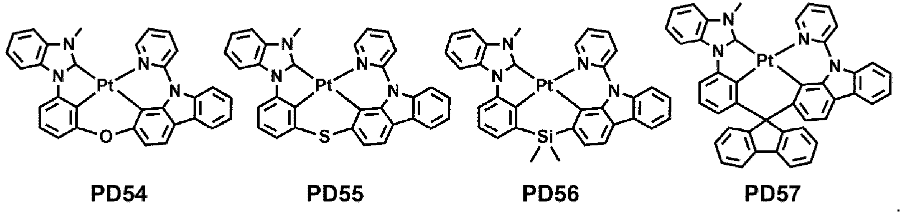

In an embodiment, the second dopant may include at least one of Compounds DFD1 to DFD26:

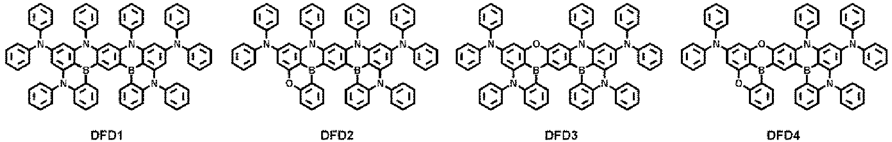

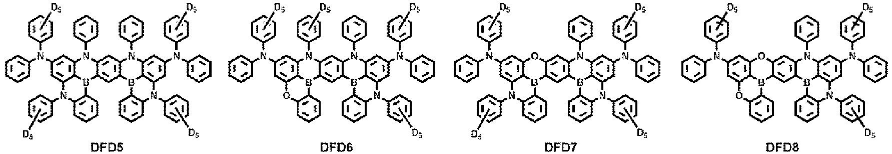

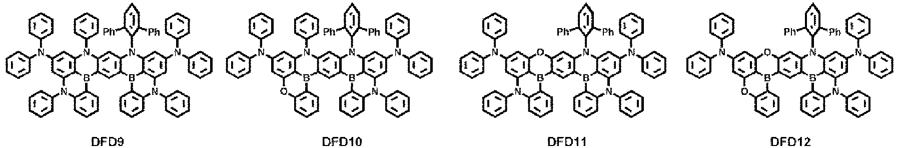

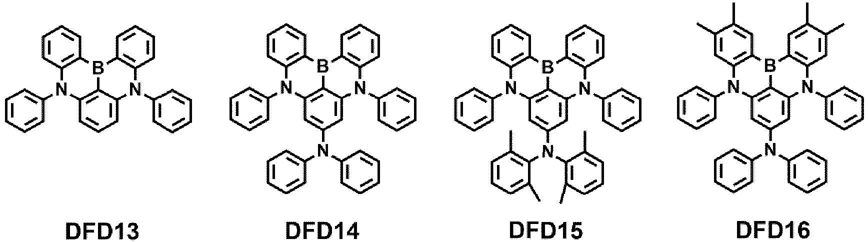

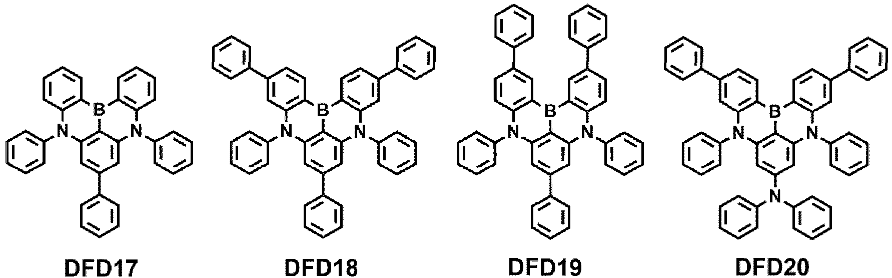

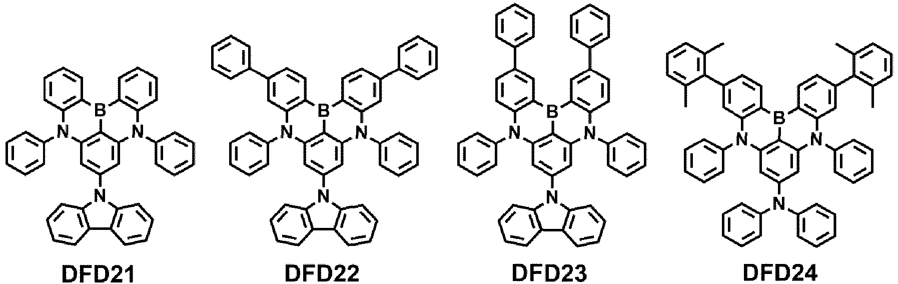

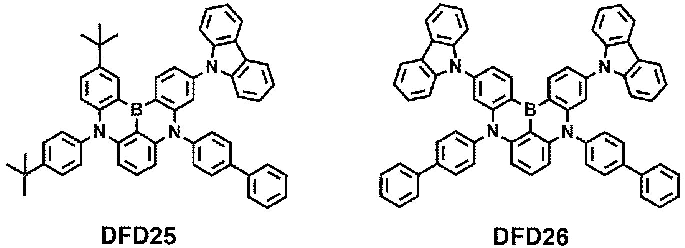

In Compounds HTH1 to HTH61, ETH1 to ETH104, PD1 to PD57, and DFD1 to DFD26, Ph represents a phenyl group, D₅ represents substitution with five deuterium atoms, and D₄ represents substitution with four deuterium atoms. For example, a group represented by 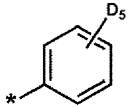 may be identical to a group represented by

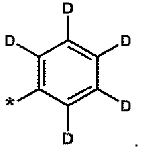

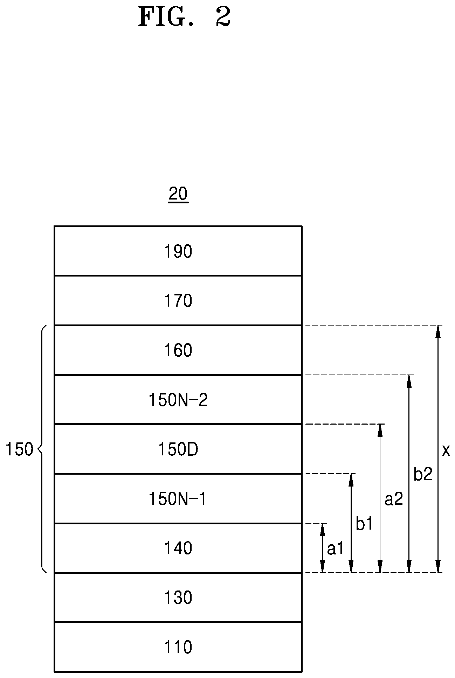

According to an embodiment,
a light-emitting device 20 (see FIG. 2) may include: a first electrode 110; a second electrode facing the first electrode 110; an emission layer 150 between the first electrode 110 and the second electrode 190;
a hole transport region 130 between the first electrode 110 and the emission layer 150; and an electron transport region 170 between the emission layer 150 and the second electrode 190, wherein
the emission layer 150 may include a first emission layer 140, a second-1 emission layer 150N-1, a fourth emission layer 150D, a second-2 emission layer 150N-2, and a third emission layer 160, which are sequentially arranged from the hole transport region,
a thickness of the emission layer may be x,
a thickness of the first emission layer may be a1, a thickness of the second-1 emission layer may be (b1-a1), a thickness of the fourth emission layer may be (a2-b1), a thickness of the second-2 emission layer may be (b2-a2), and a thickness of the third emission layer may be (x-b2),
a1 may be a real number that satisfies 0.4x ≤ a1 < 0.6x,
b1 may be a real number that satisfies 0.4x < b1 ≤ 0.6x,
a2 may be a real number that satisfies 0.4x ≤ a2 < 0.6x,
b2 may be a real number that satisfies 0.4x < b2 ≤ 0.6x,
a1, b1, a2, and b2 may be different from each other, and
a1, b1, a2, and b2 may satisfy a1 < b1 < a2 < b2.

In an embodiment, x, the thickness of the emission layer 150, may be equal to or greater than 30 nm, equal to or greater than 31 nm, or equal to or greater than 32 nm.

In an embodiment, x, the thickness of the emission layer 150, may be equal to or less than 40 nm, equal to or less than 39 nm, or equal to or less than 38 nm.

In an embodiment, (b2-a1) may be equal to or less than (0.1x) nm.

In an embodiment, (b1-a1), the thickness of the second-1 emission layer 150N-1, and (b2-a2), the thickness of the second-2 emission layer 150N-2, may each independently be equal to or less than 3 nm.

In an embodiment, (b1-a1), the thickness of the second-1 emission layer 150N-1, and (b2-a2), the thickness of the second-2 emission layer 150N-2, may each independently be equal to or greater than 1 nm.

In an embodiment, (a2-b1), the thickness of the fourth emission layer 150D, may be equal to or greater than 1 nm.

In the light-emitting device 20, the first emission layer 140, the third emission layer 160, and the fourth emission layer 150D may each independently include a first host, a second host, a first dopant, and a second dopant.

In the light-emitting device 20, the second-1 emission layer 150N-1 and the second-2 emission layer 150N-2 may each independently include: a first host, a second host, and a first dopant; or a first host, a second host, a first dopant, and a second dopant.

The first host, the second host, the first dopant, and the second dopant may respectively be the same as described herein.

In the light-emitting device 20, when the second-1 emission layer 150N-1 includes the second dopant, y21 may be smaller than y1 (e.g., y21 < y1).

In the light-emitting device 20, when the second-2 emission layer 150N-2 includes the second dopant, y22 may be smaller than y1 (e.g., y22 < y1).

In the light-emitting device 20, y1 may be a wt% value of the second dopant in the first emission layer 140 that is expressed based on 100 wt% of the entire first emission layer 140.

In the light-emitting device 20, y21 may be a wt% value of the second dopant in the second-1 emission layer 150N-1 that is expressed based on 100 wt% of the entire second-1 emission layer 150N-1.

In the light-emitting device 20, y22 may be a wt% value of the second dopant in the second-2 emission layer 150N-2 that is expressed based on 100 wt% of the entire second-2 emission layer 150N-2.

In an embodiment, in the first emission layer 140, y1, which is the wt% value of the second dopant, may be equal to or less than 5, equal to or less than 4.5, equal to or less than 4, equal to or less than 3.5, equal to or less than 3, equal to or less than 2.5, equal to or less than 2, or equal to or less than 1.5.

In an embodiment, when the second-1 emission layer 150N-1 includes the second dopant, y21, which is the wt% value of the second dopant in the second-1 emission layer 150N-1, may be equal to or less than 0.35(y1) (e.g., y21 ≤ 0.35(y1)).

In an embodiment, when the second-2 emission layer 150N-2 includes the second dopant, y22, which is the wt% value of the second dopant in the second-2 emission layer 150N-2, may be equal to or less than 0.35(y1) (e.g., y22 ≤ 0.35(y1)).

In an embodiment, y1, which is the wt% value of the second dopant in the first emission layer 140, and y3, which is a wt% value of the second dopant in the third emission layer 160, may be identical to each other. In the light-emitting device 20, y3 may be expressed based on 100 wt% of the entire third emission layer 160.

In an embodiment, y1, which is the wt% value of the second dopant in the first emission layer 140, and y4, which is a wt% value of the second dopant in the fourth emission layer 150D, may be identical to each other. In the light-emitting device 20, y4 may be expressed based on 100 wt% of the entire fourth emission layer 150D.

Thus, the emission layer 150 of the light-emitting device 20 according to an embodiment may have a uniform concentration of the second dopant in the remaining emission layers, except for the depletion layer or the low-doped layer (e.g., the second-1 emission layer 150N-1 and the second-2 emission layer 150N-2).

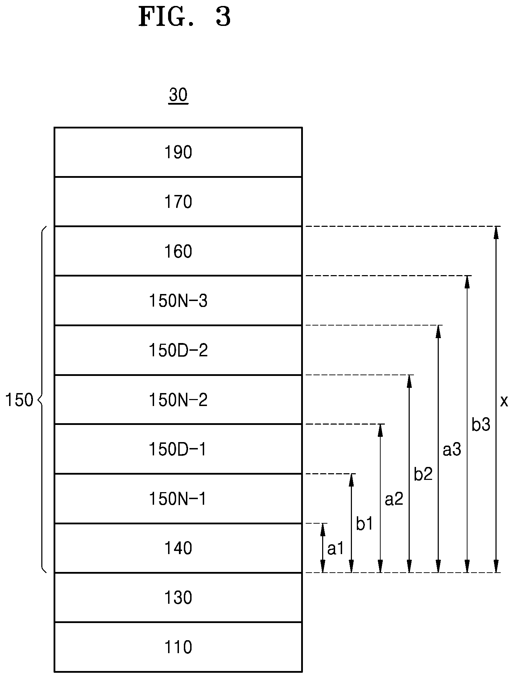

According to another embodiment,
a light-emitting device 30 (see FIG. 3) may include: a first electrode 110; a second electrode facing the first electrode 110; an emission layer 150 between the first electrode 110 and the second electrode 190;
a hole transport region 130 between the first electrode 110 and the emission layer 150; and an electron transport region 170 between the emission layer 150 and the second electrode 190, wherein
the emission layer 150 may include a first emission layer 140, a second-1 emission layer 150N-1, a fourth-1 emission layer 150D-1, a second-2 emission layer 150N-2, a fourth-2 emission layer 150D-2, a second-3 emission layer 150N-3, and a third emission layer 160, which are sequentially arranged from the hole transport region 130,
a thickness of the emission layer may be x,
a thickness of the first emission layer may be a1, a thickness of the second-1 emission layer may be (b1-a1), a thickness of the fourth-1 emission layer may be (a2-b1), a thickness of the second-2 emission layer may be (b2-a2), a thickness of the fourth-2 emission layer may be (a3-b2), a thickness of the second-3 emission layer may be (b3-a3), and a thickness of the third emission layer may be (x-b3),
a1 may be a real number that satisfies 0.4x ≤ a1 < 0.6x,
b1 may be a real number that satisfies 0.4x < b1 ≤ 0.6x,
a2 may be a real number that satisfies 0.4x ≤ a2 < 0.6x,
b2 may be a real number that satisfies 0.4x < b2 ≤ 0.6x,
a3 may be a real number that satisfies 0.4x ≤ a3 < 0.6x,
b3 may be a real number that satisfies 0.4x < b3 ≤ 0.6x,
a1, b1, a2, b2, a3, and b3 may be different from each other, and
a1, b1, a2, b2, a3, and b3 may satisfy a1 < b1 < a2 < b2 < a3 <b3.

In an embodiment, x, the thickness of the emission layer 150, may be equal to or greater than 30 nm, equal to or greater than 31 nm, or equal to or greater than 32 nm.

In an embodiment, x, the thickness of the emission layer 150, may be equal to or less than 40 nm, equal to or less than 39 nm, or equal to or less than 38 nm.

In an embodiment, (b3-a1) may be equal to or less than (0.1x) nm.

In an embodiment, (b1-a1), the thickness of the second-1 emission layer 150N-1, (b2-a2), the thickness of the second-2 emission layer 150N-2, and (b3-a3), the thickness of the second-3 emission layer 150N-3, may each independently be equal to or less than 3 nm.

In an embodiment, (b1-a1), the thickness of the second-1 emission layer 150N-1, (b2-a2), the thickness of the second-2 emission layer 150N-2, and (b3-a3), the thickness of the second-3 emission layer 150N-3, may each independently be equal to or greater than 1 nm.

In an embodiment, (a2-b1), the thickness of the fourth-1 emission layer 150D-1, and (a3-b2), the thickness of the fourth-2 emission layer 150D-2, may each independently be equal to or greater than 1 nm.

In the light-emitting device 30, the first emission layer 140, the third emission layer 160, the fourth-1emission layer 150D-1, and the fourth-2 emission layer 150D-2 may each independently include a first host, a second host, a first dopant, and a second dopant.

In the light-emitting device 30, the second-1 emission layer 150N-1, the second-2 emission layer 150N-2, and the second-3 emission layer 150N-3 may each independently include: a first host, a second host, and a first dopant; or a first host, a second host, a first dopant, and a second dopant.

The first host, the second host, the first dopant, and the second dopant may respectively be the same as described herein.

In the light-emitting device 30, when the second-1 emission layer 150N-1 includes the second dopant, y21 may be smaller than y1 (e.g., y21 < y1).

In the light-emitting device 30, when the second-2 emission layer 150N-2 includes the second dopant, y22 may be smaller than y1 (e.g., y22 < y1).

In the light-emitting device 30, when the second-3 emission layer 150N-3 includes the second dopant, y23 may be smaller than y1 (e.g., y23 < y1).

In the light-emitting device 30, y1 may be a wt% value of the second dopant in the first emission layer 140 that is expressed based on 100 wt% of the entire first emission layer 140.

In the light-emitting device 30, y21 may be a wt% value of the second dopant in the second-1 emission layer 150N-1 that is expressed based on 100 wt% of the entire second-1 emission layer 150N-1.

In the light-emitting device 30, y22 may be a wt% value of the second dopant in the second-2 emission layer 150N-2 that is expressed based on 100 wt% of the entire second-2 emission layer 150N-2.

In the light-emitting device 30, y23 may be a wt% value of the second dopant in the second-3 emission layer 150N-3 that is expressed based on 100 wt% of the entire second-3 emission layer 150N-3.

In an embodiment, in the first emission layer 140, y1, which is the wt% value of the second dopant, may be equal to or less than 5, equal to or less than 4.5, equal to or less than 4, equal to or less than 3.5, equal to or less than 3, equal to or less than 2.5, equal to or less than 2, or equal to or less than 1.5.

In an embodiment, when the second-1 emission layer 150N-1 includes the second dopant, y21, which is the wt% value of the second dopant in the second-1 emission layer 150N-1, may be equal to or less than 0.35(y1) (e.g., y21 ≤ 0.35(y1)).

In an embodiment, when the second-2 emission layer 150N-2 includes the second dopant, y22, which is the wt% value of the second dopant in the second-2 emission layer 150N-2, may be equal to or less than 0.35(y1) (e.g., y22 ≤ 0.35(y1)).

In an embodiment, when the second-3 emission layer 150N-3 includes the second dopant, y23, which is the wt% value of the second dopant in the second-3 emission layer 150N-3, may be equal to or less than 0.35(y1) (e.g., y23 ≤ 0.35(y1)).

In an embodiment, y1, which is the wt% value of the second dopant in the first emission layer 140, and y3, which is a wt% value of the second dopant in the third emission layer 160, may be identical to each other. In the light-emitting device 30, y3 may be expressed based on 100 wt% of the entire third emission layer 160.

In an embodiment, y1, which is the wt% value of the second dopant in the first emission layer 140, and y41, which is a wt% value of the second dopant in the fourth-1 emission layer 150D-1, may be identical to each other. In the light-emitting device 30, y41 may be expressed based on 100 wt% of the entire fourth-1 emission layer 150D-1.

In an embodiment, y1, which is the wt% value of the second dopant in the first emission layer 140, and y42, which is a wt% value of the second dopant in the fourth-2 emission layer 150D-2, may be identical to each other. In the light-emitting device 30, y42 may be expressed based on 100 wt% of the entire fourth-2 emission layer 150D-2.

Thus. the emission layer 150 of the light-emitting device 30 according to an embodiment may have a uniform concentration of the second dopant in the remaining emission layers, except for the depletion layer or the low-doped layer (e.g., the second-1 emission layer 150N-1, the second-2 emission layer 150N-2, and the second-3 emission layer 150N-3).

In an embodiment,
the first electrode 110 of the light-emitting device 10, 20, or 30 may be an anode,
the second electrode 190 of the light-emitting device 10, 20, or 30 may be a cathode,
the hole transport region 130 may include a hole injection layer, a hole transport layer, an emission auxiliary layer, an electron blocking layer, or any combination thereof, and
the electron transport region 170 may include a hole blocking layer, an electron transport layer, an electron injection layer, an electron control layer, or any combination thereof.

In embodiments, the emission layer 150 may emit red light, green light, blue light, and/or white light. For example, the emission layer 150 may emit blue light. The blue light may have a maximum emission wavelength in a range of, for example, about 400 nm to about 480 nm. In an embodiment, the emission layer 150 may emit blue light having a maximum emission wavelength in a range of about 430 nm to about 480 nm.

In embodiments, the electron transport region 170 of the light-emitting device 10, 20, or 30 may include a hole blocking layer, and the hole blocking layer may include a phosphine oxide-containing compound, a silicon-containing compound, or any combination thereof. In an embodiment, the hole blocking layer may directly contact the emission layer 150.

In an embodiment, the light-emitting device 10, 20, or 30 may further include a capping layer located outside the first electrode or outside the second electrode.

For example, the light-emitting device 10, 20, or 30 may further include at least one of a first capping layer arranged outside the first electrode and a second capping layer arranged outside the second electrode. Further details on the first capping layer and/or the second capping layer may be the same as described herein.

In the specification, the expression "the emission layer 150 may include a first host" may be interpreted as "the emission layer 150 may include one kind of compound belonging to the category of the first host or two or more different kinds of compounds belonging to the category of the first host."

In the specification, the expression "the emission layer 150 may include a second host" may be interpreted as "the emission layer 150 may include one kind of compound belonging to the category of the second host or two or more different kinds of compounds belonging to the category of the second host."

In the specification, the expression "the emission layer 150 may include a first dopant" may be interpreted as "the emission layer 150 may include one kind of compound belonging to the category of the first dopant or two or more different kinds of compounds belonging to the category of the first dopant."

In the specification, the expression "the emission layer 150 may include a second dopant" may be interpreted as "the emission layer 150 may include one kind of compound belonging to the category of the second dopant or two or more different kinds of compounds belonging to the category of the second dopant."

In the specification, the term "interlayer" may refer to a single layer and/or multiple layers between the first electrode 110 and the second electrode 190 of the light-emitting device 10, 20, or 30.

### [Description of FIGS. 1 to 3]

FIG. 1 is a schematic cross-sectional view of a light-emitting device 10 according to an embodiment. The light-emitting device 10 may include the first electrode 110, the hole transport region 130, the emission layer 150, the electron transport region 170, and the second electrode 190.
FIG. 2 is a schematic cross-sectional view of a light-emitting device 20 according to an embodiment.
FIG. 3 is a schematic cross-sectional view of a light-emitting device 30 according to an embodiment.

Hereinafter, a structure of the light-emitting device 10 according to an embodiment and a method of manufacturing the light-emitting device 10 are described with reference to FIG. 1.

### [First electrode 110]

In FIG. 1, a substrate may be further included under the first electrode 110 or on the second electrode 190. The substrate may be a glass substrate or a plastic substrate. In an embodiment, the substrate may be a flexible substrate and may include plastics with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a transflective electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In an embodiment, when the first electrode 110 is a transflective electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a structure consisting of a single layer or a structure including multiple layers. In an embodiment, the first electrode 110 may have a three-layered structure of ITO/Ag/ITO.

### [Interlayer]

The interlayer may be arranged on the first electrode 110. The interlayer may include the emission layer 150, the hole transport region 130 between the first electrode 110 and the emission layer 150, and the electron transport region 170 between the emission layer 150 and the second electrode 190.

The interlayer may further include, in addition to various organic materials, a metal-containing compound, such as an organometallic compound, an inorganic material, such as quantum dots, or the like.

In an embodiment, the interlayer may include two or more emitting units stacked between the first electrode 110 and the second electrode 190, and at least one charge generation layer between adjacent units among the two or more emitting units. When the interlayer includes the two or more emitting units and the at least one charge generation layer as described above, the light-emitting device 10, 20, or 30 may be a tandem light-emitting device.

### [Hole transport region 130 in interlayer]

The hole transport region 130 may have a structure consisting of a layer consisting of a single material, a structure consisting of a layer including different materials, or a structure including multiple layers including different materials.

The hole transport region 130 may include a hole injection layer, a hole transport layer, an emission auxiliary layer, an electron blocking layer, or any combination thereof.

In embodiments, the hole transport region 130 may have a multi-layered structure, for example, a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein the layers of each structure may be stacked from the first electrode 110 in its respective stated order, but the structure of the hole transport region 130 is not limited thereto.

In embodiments, the hole transport region 130 may include a compound represented by Formula 201, a compound represented by Formula 202, or any combination thereof:

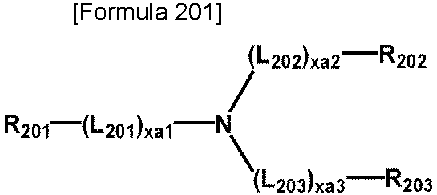

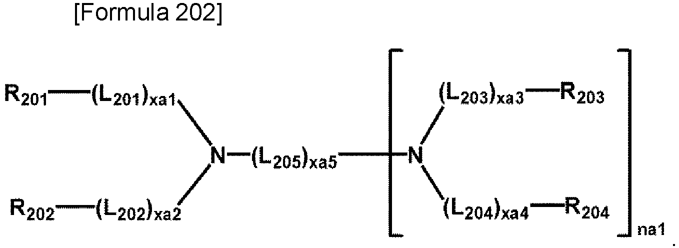

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group (for example, a carbazole group) that is unsubstituted or substituted with at least one R₁₀ₐ (for example, Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In an embodiment, the compound represented by Formula 201 and the compound represented by Formula 202 may each independently include at least one of groups represented by Formulae CY201 to CY217:

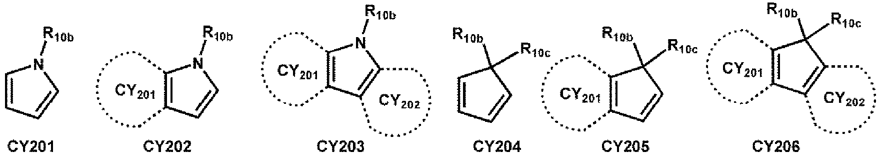

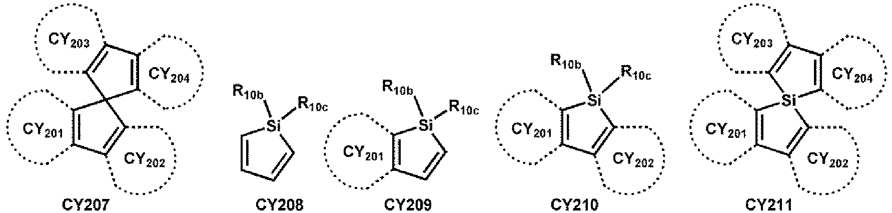

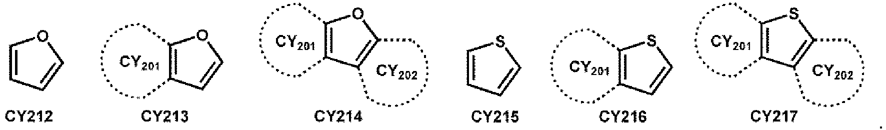

In Formulae CY201 to CY217, R_{10b} and R_{10c} may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, in Formulae CY201 to CY217, ring CY₂₀₁ to ring CY₂₀₄ may each independently be a benzene group, a naphthalene group, a phenanthrene group, or an anthracene group.

In an embodiment, the compound represented by Formula 201 and the compound represented by Formula 202 may each independently include at least one of groups represented by Formulae CY201 to CY203.

In an embodiment, the compound represented by Formula 201 may include at least one of groups represented by Formulae CY201 to CY203 and at least one of groups represented by Formulae CY204 to CY217.

In an embodiment, in Formula 201, xa1 may be 1, R₂₀₁ may be a group represented by one of Formulae CY201 to CY203, xa2 may be 0, and R₂₀₂ may be a group represented by one of Formulae CY204 to CY207.

In an embodiment, the compound represented by Formula 201 and the compound represented by Formula 202 may each not include groups represented by Formulae CY201 to CY203.

In an embodiment, the compound represented by Formula 201 and the compound represented by Formula 202 may each not include groups represented by Formulae CY201 to CY203 and may each independently include at least one of groups represented by Formulae CY204 to CY217.

In an embodiment, the compound represented by Formula 201 and the compound represented by Formula 202 may each not include groups represented by Formulae CY201 to CY217.

In an embodiment, the hole transport region 130 may include one of Compounds HT1 to HT46, m-MTDATA, TDATA, 2-TNATA, NPB (NPD), β-NPB, TPD, spiro-TPD, spiro-NPB, methylated NPB, TAPC, HMTPD, 4,4',4"-tris(N-carbazolyl)triphenylamine (TCTA), polyaniline/dodecylbenzene sulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), or any combination thereof:

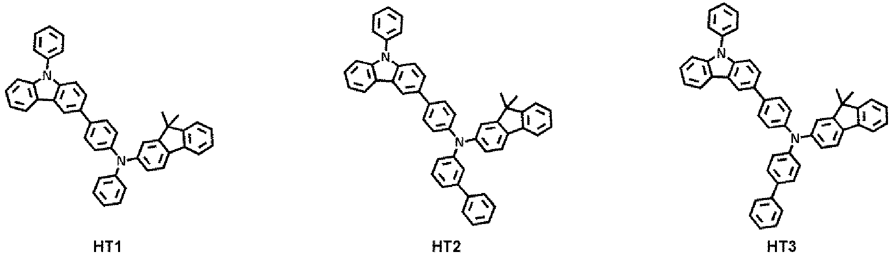

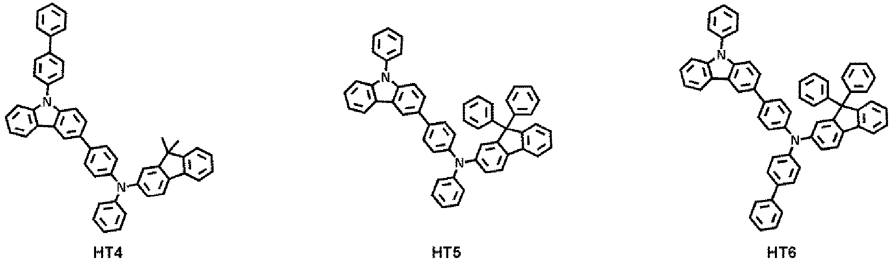

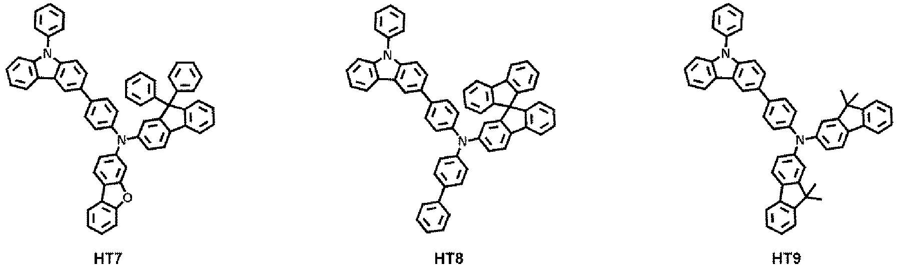

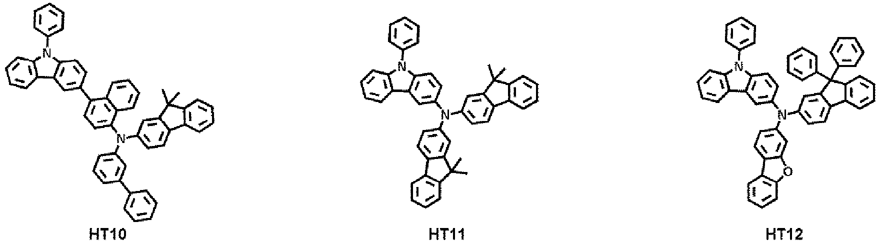

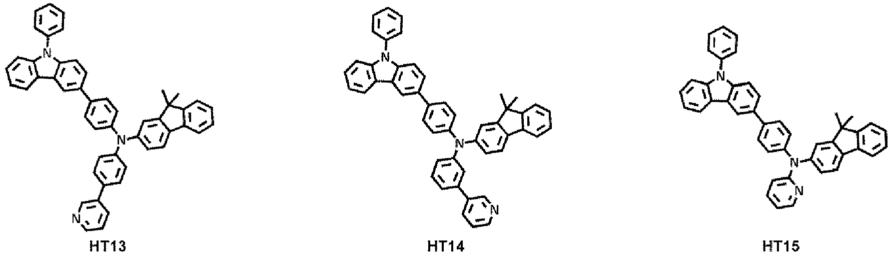

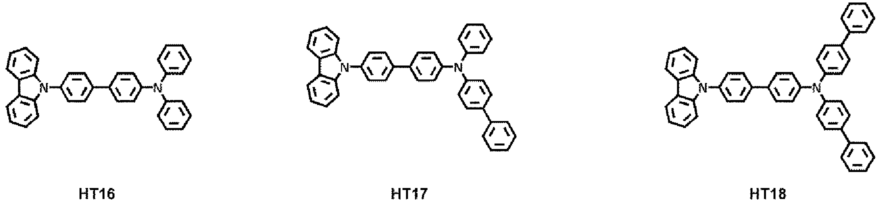

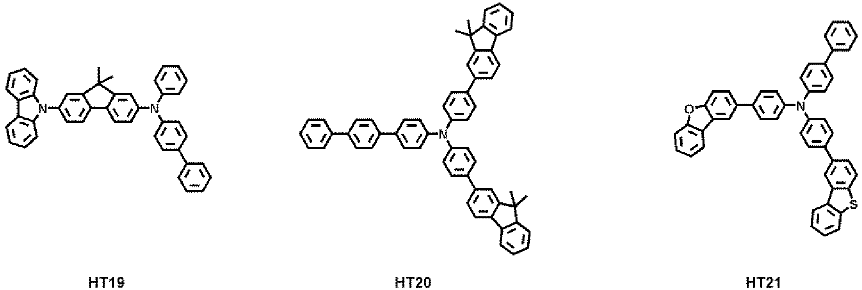

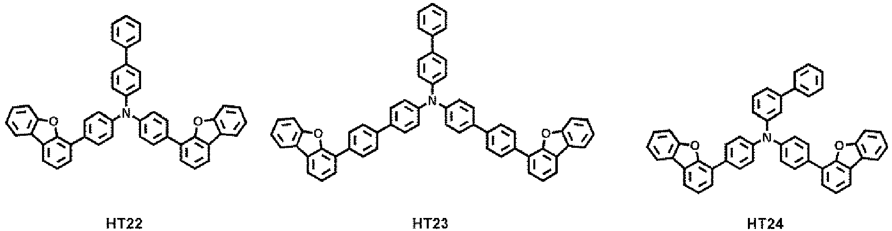

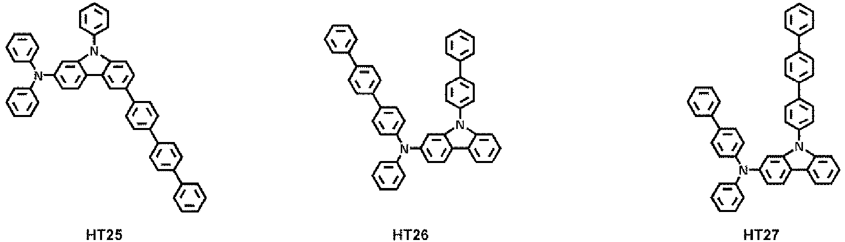

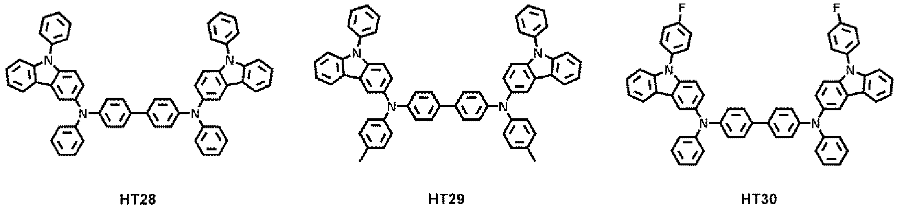

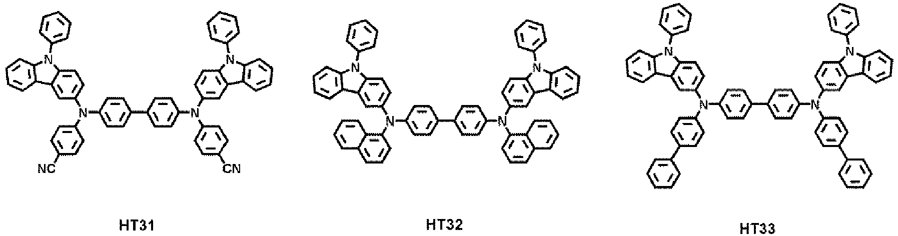

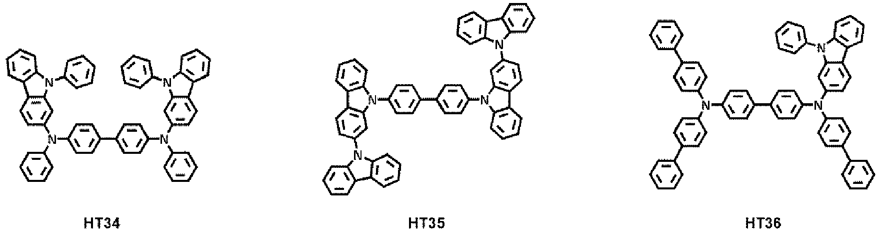

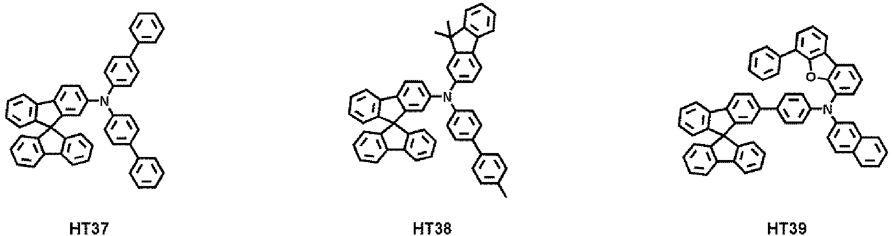

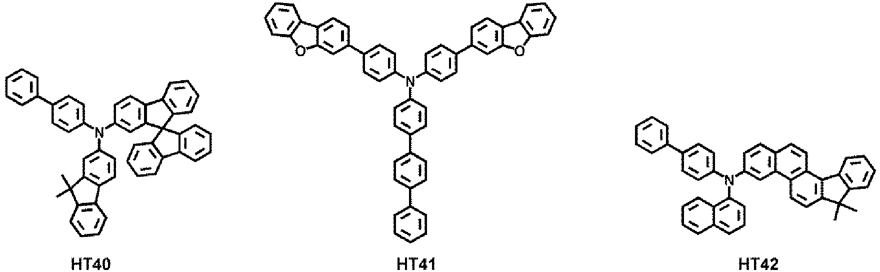

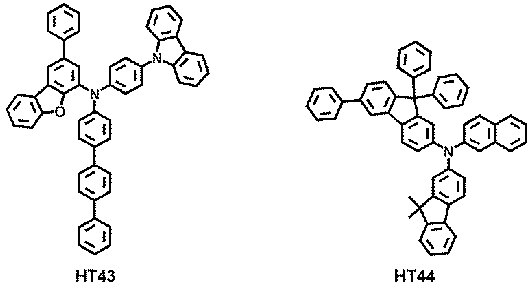

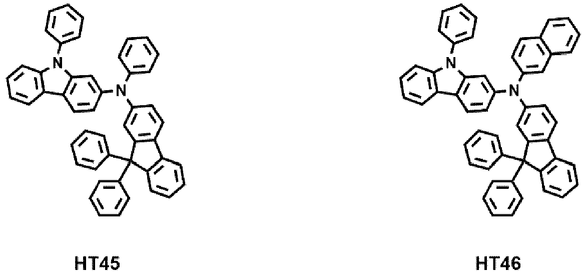

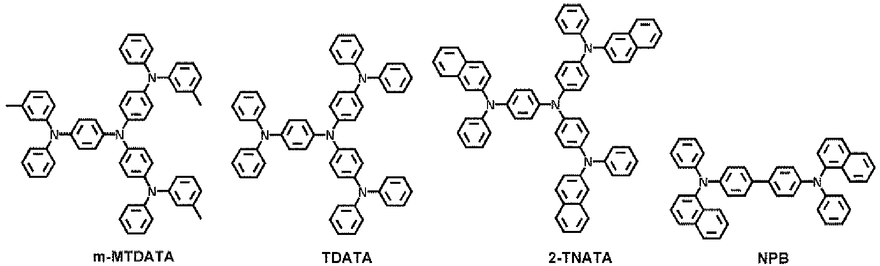

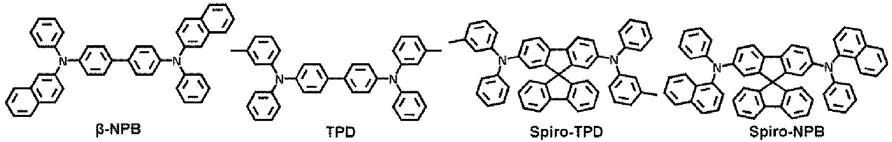

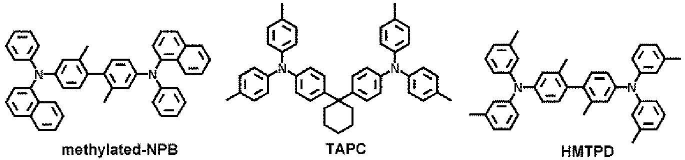

The hole transport region 130 may have a thickness in a range of about 50 Å to about 10,000 Å. For example, the hole transport region 130 may have a thickness in a range of about 100 Å to about 4,000 Å. When the hole transport region 130 includes a hole injection layer, a hole transport layer, or any combination thereof, a thickness of the hole injection layer may be in a range of about 100 Å to about 9,000 Å, and a thickness of the hole transport layer may be in a range of about 50 Å to about 2,000 Å. For example, the thickness of the hole injection layer may be in a range of about 100 Å to about 1,000 Å. For example, the thickness of the hole transport layer may be in a range of about 100 Å to about 1,500 Å. When the thicknesses of the hole transport region 130, the hole injection layer, and the hole transport layer are within these ranges, satisfactory hole transporting characteristics may be obtained without a substantial increase in driving voltage.

The emission auxiliary layer may increase light emission efficiency by compensating for an optical resonance distance according to a wavelength of light emitted by the emission layer, and the electron blocking layer may block the leakage of electrons from the emission layer 150 to the hole transport region 130. Materials that may be included in the hole transport region 130 may be included in the emission auxiliary layer and the electron blocking layer.

### [p-dopant]

The hole transport region 130 may further include, in addition to the aforementioned materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the p-dopant may have a lowest unoccupied molecular orbital (LUMO) energy level equal to or less than about -3.5 eV.

In an embodiment, the p-dopant may include a quinone derivative, a cyano group-containing compound, a compound including element EL1 and element EL2, or any combination thereof.

Examples of a quinone derivative may include TCNQ, F4-TCNQ, and the like.

Examples of a cyano group-containing compound may include HAT-CN, a compound represented by Formula 221, and the like:

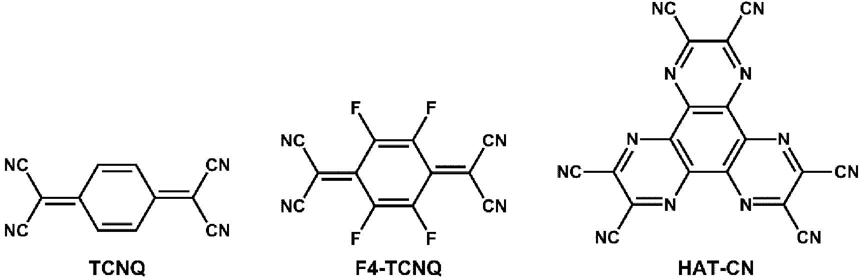

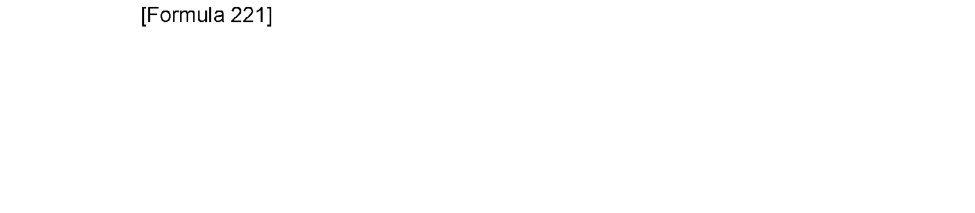

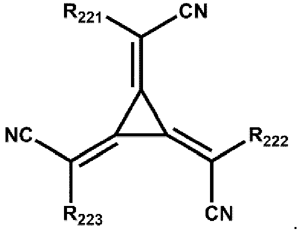

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; - Br; -I; a C₁-C₂₀ alkyl group substituted with a cyano group, -F, -Cl, -Br, -I, or any combination thereof; or any combination thereof.

In the compound including element EL1 and element EL2, element EL1 may be a metal, a metalloid, or a combination thereof, and element EL2 may be a non-metal, a metalloid, or a combination thereof.

Examples of a metal may include an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of a metalloid may include silicon (Si), antimony (Sb), and tellurium (Te).

Examples of a non-metal may include oxygen (O), a halogen (e.g., F, Cl, Br, I, etc.), and the like.

Examples of a compound including element EL1 and element EL2 may include a metal oxide, a metal halide (e.g., a metal fluoride, a metal chloride, a metal bromide, a metal iodide, etc.), a metalloid halide (e.g., a metalloid fluoride, a metalloid chloride, a metalloid bromide, a metalloid iodide, etc.), a metal telluride, or any combination thereof.

Examples of a metal oxide may include a tungsten oxide (e.g., WO, W₂O₃, WO₂, WO₃, W₂O₅, etc.), a vanadium oxide (e.g., VO, V₂O₃, VO₂, V₂O₅, etc.), a molybdenum oxide (e.g., MoO, Mo₂O₃, MoO₂, MoO₃, Mo₂O₅, etc.), a rhenium oxide (e.g., ReO₃, etc.), and the like.

Examples of a metal halide may include an alkali metal halide, an alkaline earth metal halide, a transition metal halide, a post-transition metal halide, a lanthanide metal halide, and the like.

Examples of an alkali metal halide may include LiF, NaF, KF, RbF, CsF, LiCl, NaCl, KCI, RbCl, CsCl, LiBr, NaBr, KBr, RbBr, CsBr, Lil, Nal, KI, Rbl, Csl, and the like.

Examples of an alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, Mgl₂, CaI₂, SrI₂, BaI₂, and the like.

Examples of a transition metal halide may include a titanium halide (e.g., TiF₄, TiCl₄, TiBr₄, Til₄, etc.), a zirconium halide (e.g., ZrF₄, ZrCl₄, ZrBr₄, ZrI₄, etc.), a hafnium halide (e.g., HfF₄, HfCl₄, HfBr₄, Hfl₄, etc.), a vanadium halide (e.g., VF₃, VCl₃, VBr₃, VI₃, etc.), a niobium halide (e.g., NbF₃, NbCl₃, NbBr₃, NbI₃, etc.), a tantalum halide (e.g., TaF₃, TaCl₃, TaBr₃, TaI₃, etc.), a chromium halide (e.g., CrF₃, CrCl₃, CrBr₃, CrI₃, etc.), a molybdenum halide (e.g., MoF₃, MoCl₃, MoBr₃, MoI₃, etc.), a tungsten halide (e.g., WF₃, WCl₃, WBr₃, W1₃, etc.), a manganese halide (e.g., MnF₂, MnCl₂, MnBr₂, MnI₂, etc.), a technetium halide (e.g., TcF₂, TcCl₂, TcBr₂, TcI₂, etc.), a rhenium halide (e.g., ReF₂, ReCl₂, ReBr₂, ReI₂, etc.), an iron halide (e.g., FeF₂, FeCl₂, FeBr₂, FeI₂, etc.), a ruthenium halide (e.g., RuF₂, RuCl₂, RuBr₂, RuI₂, etc.), an osmium halide (e.g., OsF₂, OsCl₂, OsBr₂, OsI₂, etc.), a cobalt halide (e.g., CoF₂, CoCl₂, CoBr₂, CoI₂, etc.), a rhodium halide (e.g., RhF₂, RhCl₂, RhBr₂, RhI₂, etc.), an iridium halide (e.g., IrF₂, IrCl₂, IrBr₂, IrI₂, etc.), a nickel halide (e.g., NiF₂, NiCl₂, NiBr₂, NiI₂, etc.), a palladium halide (e.g., PdF₂, PdCl₂, PdBr₂, PdI₂, etc.), a platinum halide (e.g., PtF₂, PtCl₂, PtBr₂, PtI₂, etc.), a copper halide (e.g., CuF, CuCl, CuBr, Cul, etc.), a silver halide (e.g., AgF, AgCl, AgBr, Agl, etc.), a gold halide (e.g., AuF, AuCl, AuBr, Aul, etc.), and the like.

Examples of a post-transition metal halide may include a zinc halide (e.g., ZnF₂, ZnCl₂, ZnBr₂, ZnI₂, etc.), an indium halide (e.g., InI₃, etc.), a tin halide (e.g., SnI₂, etc.), and the like.

Examples of a lanthanide metal halide may include YbF, YbF₂, YbF₃, SmF₃, YbCl, YbCl₂, YbCl₃, SmCl₃, YbBr, YbBr₂, YbBr₃ SmBr₃, Ybl, YbI₂, YbI₃, SmI₃, and the like.

Examples of a metalloid halide may include an antimony halide (e.g., SbCl₅, etc.) and the like.

Examples of a metal telluride may include an alkali metal telluride (e.g., Li₂Te, Na₂Te, K₂Te, Rb₂Te, Cs₂Te, etc.), an alkaline earth metal telluride (e.g., BeTe, MgTe, CaTe, SrTe, BaTe, etc.), a transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (e.g., ZnTe, etc.), a lanthanide metal telluride (e.g., LaTe, CeTe, PrTe, NdTe, PmTe, EuTe, GdTe, TbTe, DyTe, HoTe, ErTe, TmTe, YbTe, LuTe, etc.), and the like.

### [Emission layer 150 in interlayer]

When the light-emitting device 10 is a full-color light-emitting device, the emission layer may be patterned into a red emission layer, a green emission layer, and/or a blue emission layer, according to a subpixel. In an embodiment, the emission layer 150 may have a stacked structure in which two or more layers among a red emission layer, a green emission layer, and a blue emission layer may contact each other or may be separated from each other to emit white light. In embodiments, the emission layer 150 may have a structure in which two or more materials among a red light-emitting material, a green light-emitting material, and a blue light-emitting material may be mixed with each other in a single layer to emit white light.

The emission layer 150 may include a host and a dopant. The dopant may include a phosphorescent dopant, a fluorescent dopant, or any combination thereof.

The host may include a first host and a second host, and the dopant may include a first dopant and a second dopant. The first host, the second host, the first dopant, and the second dopant may each be the same as described herein.

An amount of the dopant in the emission layer 150 may be in a range of about 0.01 parts by weight to about 15 parts by weight, based on 100 parts by weight of the host.

In an embodiment, the emission layer 150 may include quantum dots.

In an embodiment, the emission layer 150 may include a delayed fluorescence material. The delayed fluorescence material may serve as a host or as a dopant in the emission layer 150.

A thickness of the emission layer 150 may be in a range of about 100 Å to about 1,000 Å. For example, the thickness of the emission layer 150 may be in a range of about 200 Å to about 600 Å. For example, the thickness of the emission layer 150 may be in a range of about 300 Å to about 400 Å. When the thickness of the emission layer 150 is within any of the ranges described above, excellent luminescence characteristics may be obtained without a substantial increase in driving voltage.

### [Host]

In embodiments, the host may include, in addition to the first host and the second host, a compound represented by Formula 301:

[Formula 301] [Ar₃₀₁]x_{b11}-[(L₃₀₁)_{xb1}-R₃₀₁]_{xb21}

In Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ may each independently be the same as described in connection with Q₁.

In an embodiment, in Formula 301, when xb11 is 2 or more, two or more of Ar₃₀₁ may be linked to each other via a single bond.

In an embodiment, the host may include a compound represented by Formula 301-1, a compound represented by Formula 301-2, or any combination thereof:

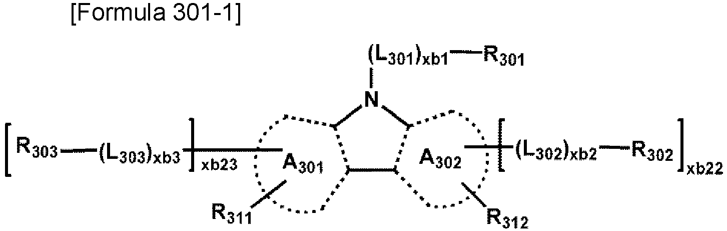

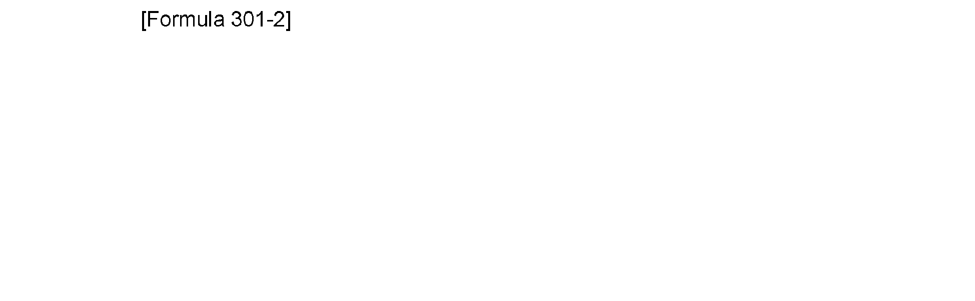

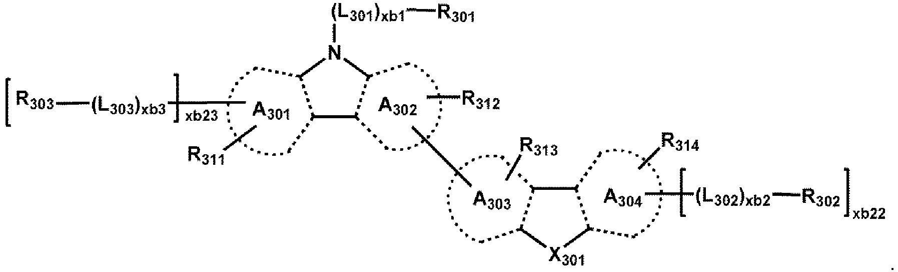

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described in the specification,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each independently be the same as described in connection with R₃₀₁.

In an embodiment, the host may include an alkali earth metal complex, a post-transition metal complex, or any combination thereof. In an embodiment, the host may include a Be complex (for example, Compound H55), an Mg complex, a Zn complex, or any combination thereof.

In embodiments, the host may include: one of Compounds H1 to H124; 9,10-di(2-naphthyl)anthracene (ADN); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP); 1,3-di-9-carbazolylbenzene (mCP); 1,3,5-tri(carbazol-9-yl)benzene (TCP); or any combination thereof:

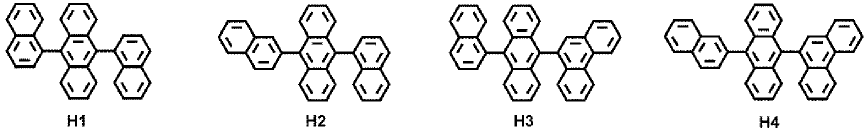

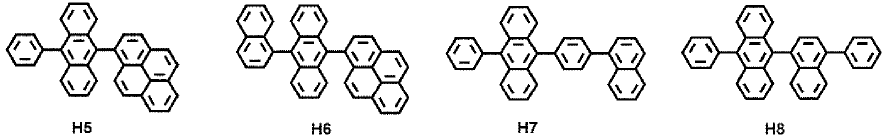

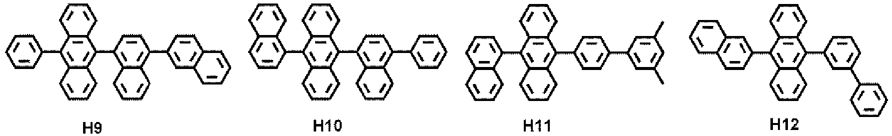

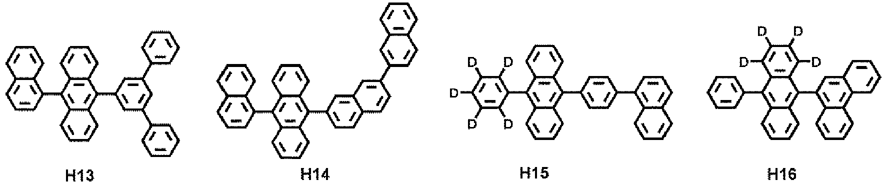

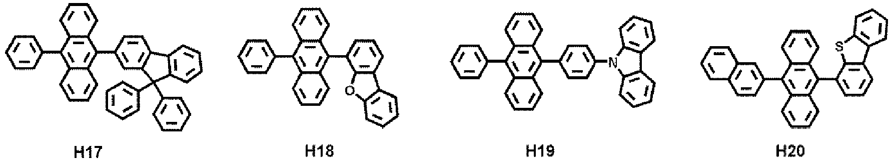

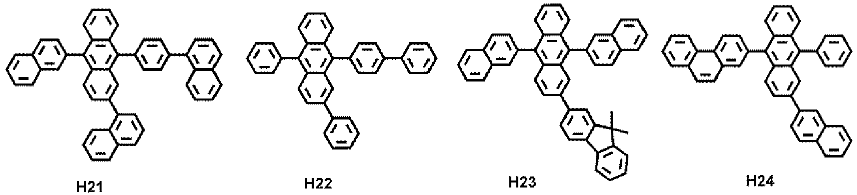

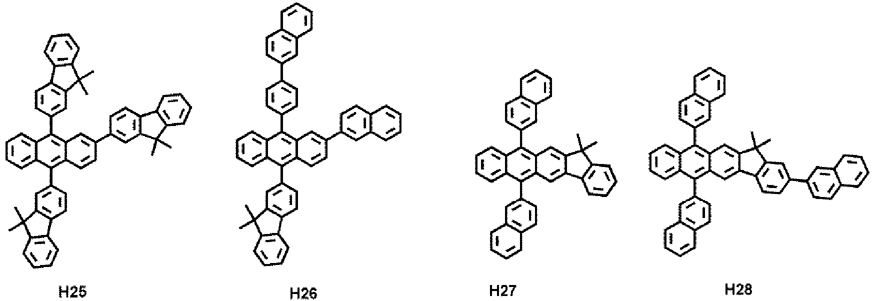

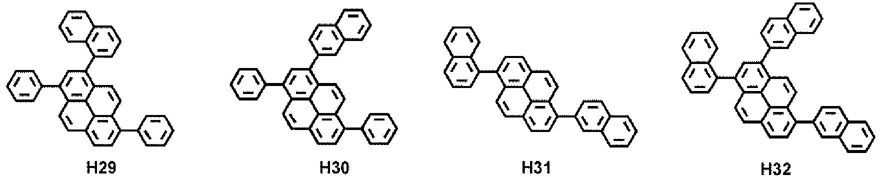

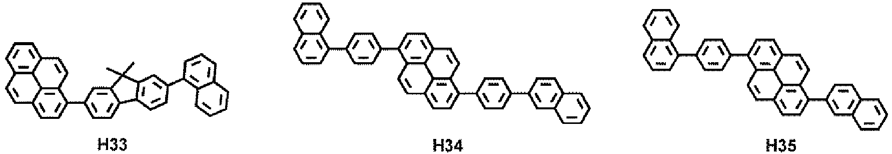

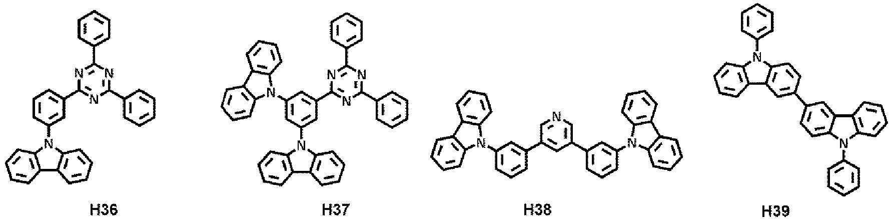

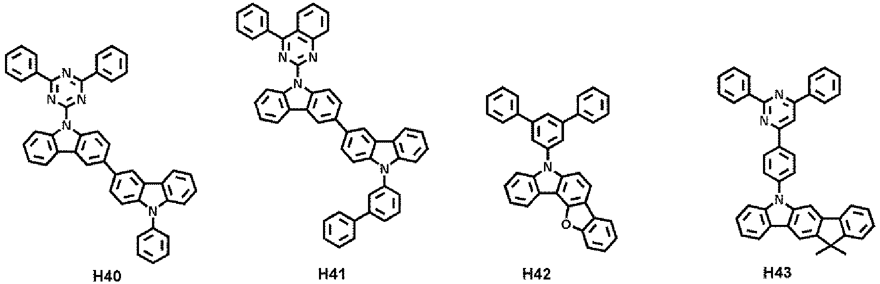

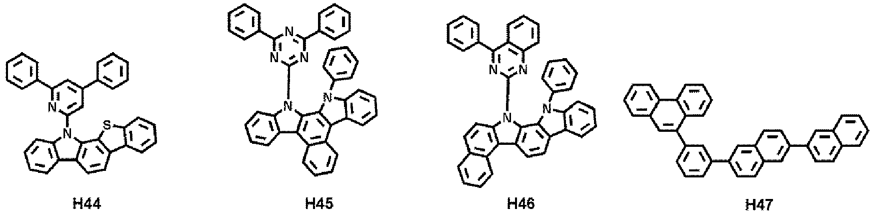

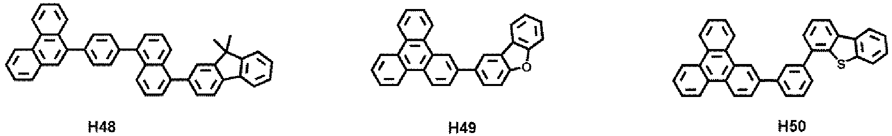

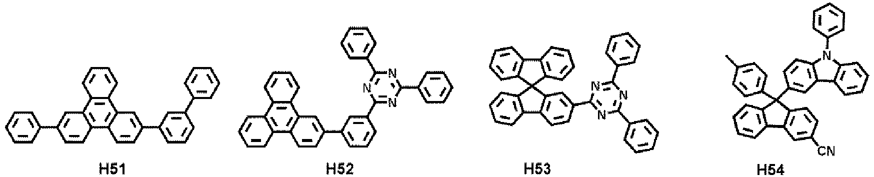

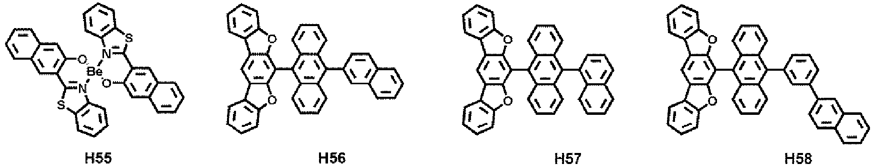

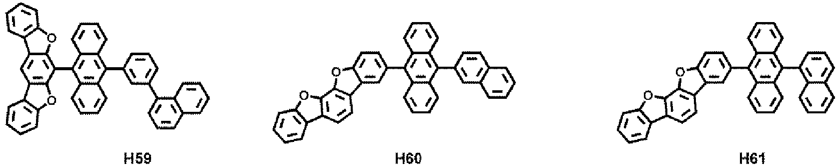

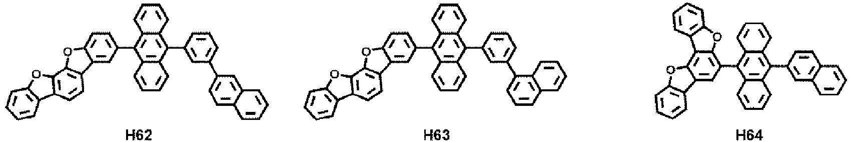

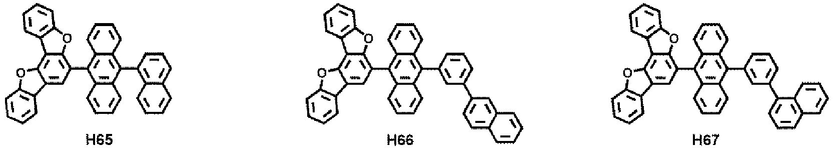

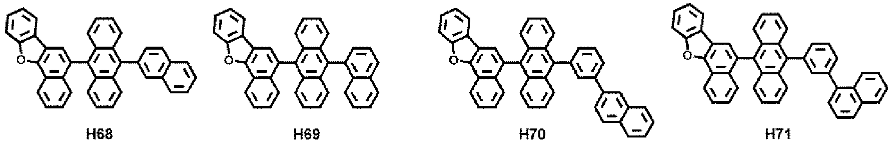

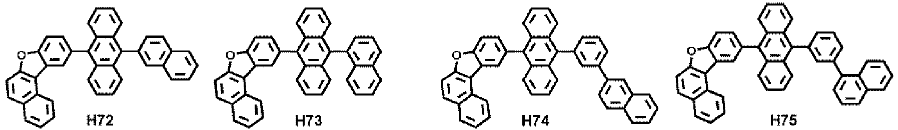

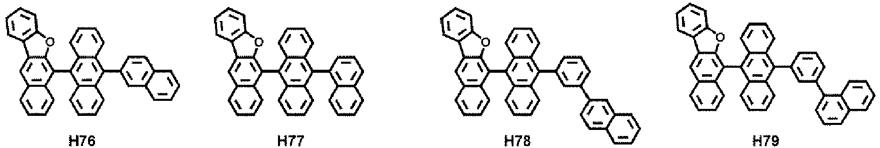

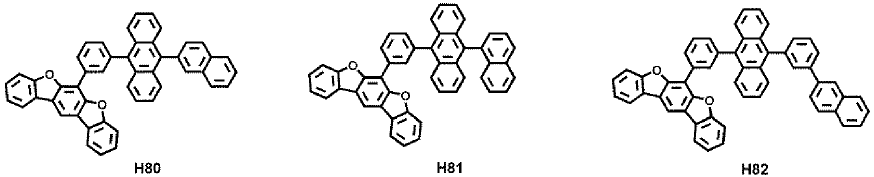

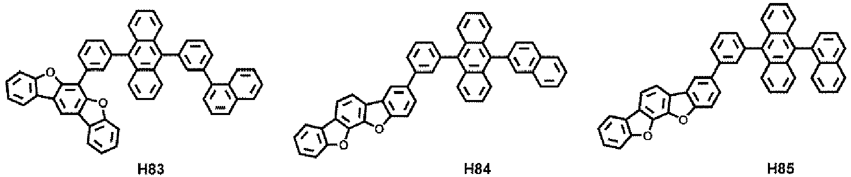

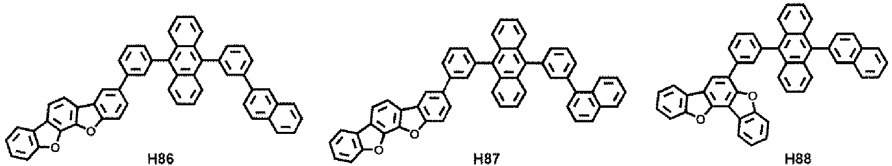

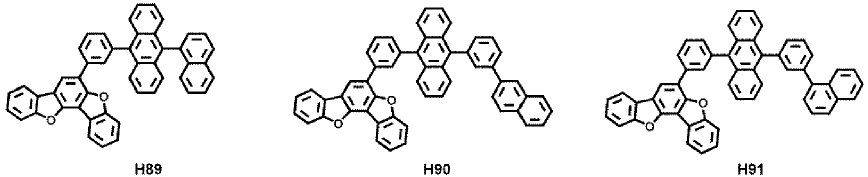

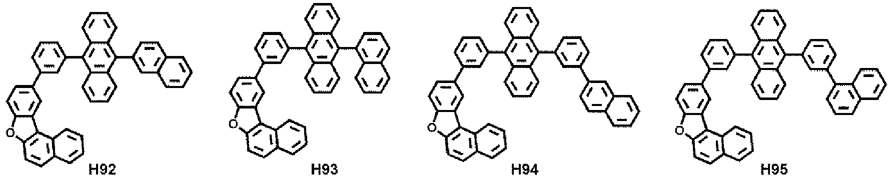

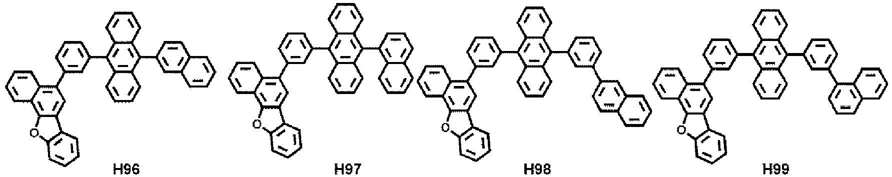

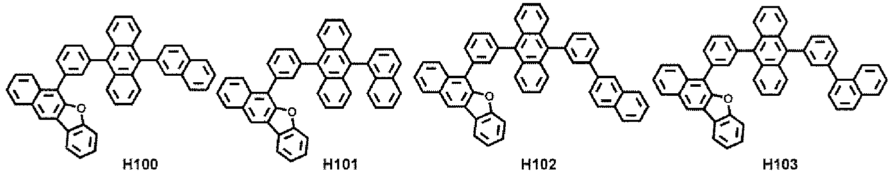

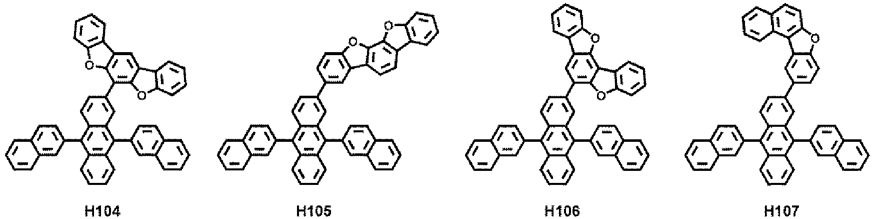

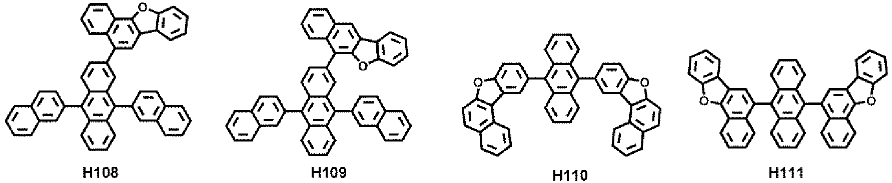

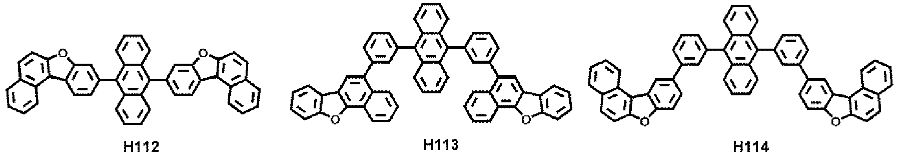

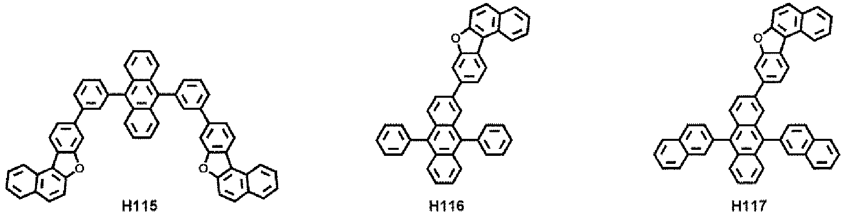

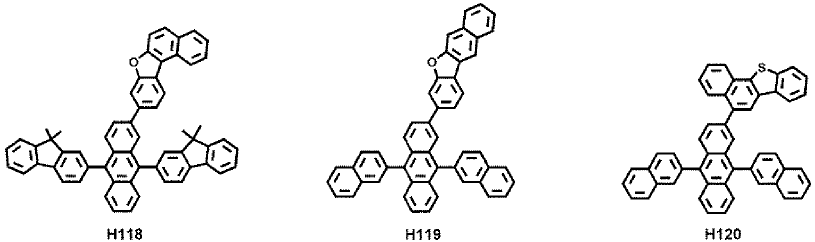

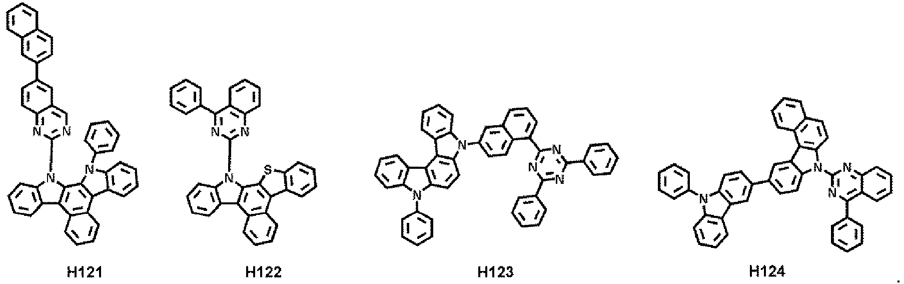

### [Phosphorescent dopant]

The phosphorescent dopant may be electrically neutral.

The phosphorescent dopant may include an organometallic compound represented by Formula 31 as described herein.

### [Fluorescent dopant]

The fluorescent dopant may include an amine group-containing compound, a styryl group-containing compound, or any combination thereof.

In an embodiment, the fluorescent dopant may include a compound represented by Formula 501:

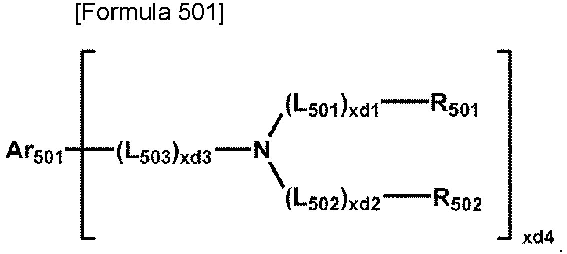

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, in Formula 501, Ar₅₀₁ may be a condensed cyclic group (for example, an anthracene group, a chrysene group, a pyrene group, etc.) in which three or more monocyclic groups are condensed together.

In an embodiment, in Formula 501, xd4 may be 2.

In embodiments, the fluorescent dopant may include: one of Compounds FD1 to FD36; DPVBi; DPAVBi; or any combination thereof:

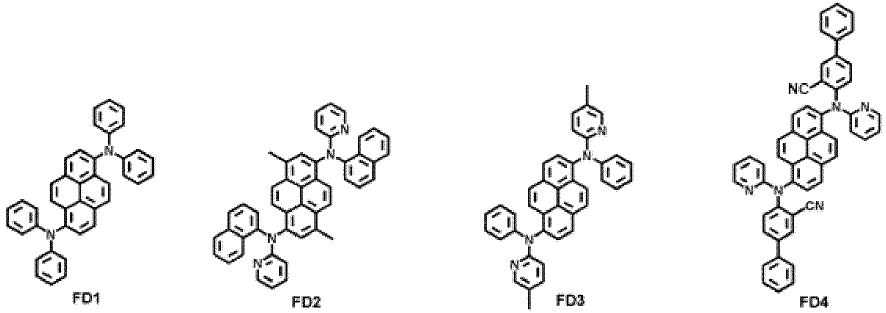

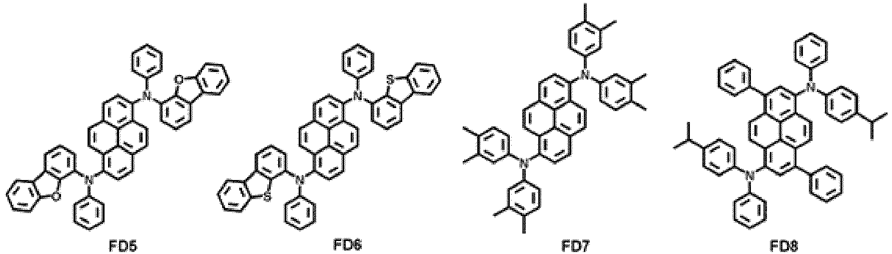

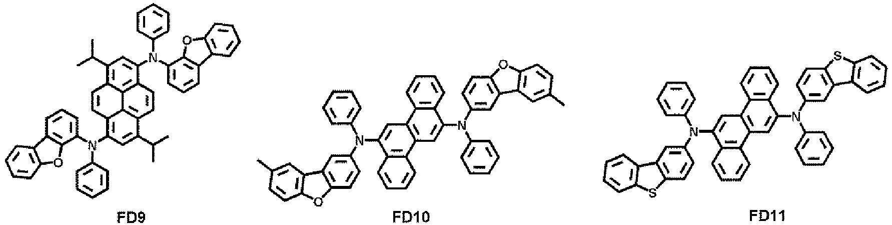

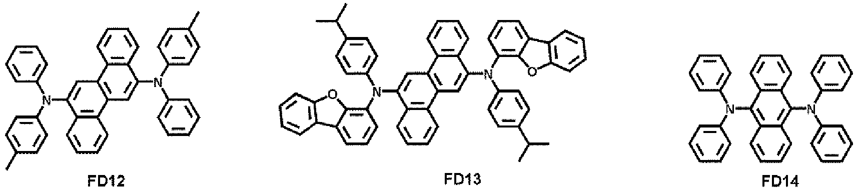

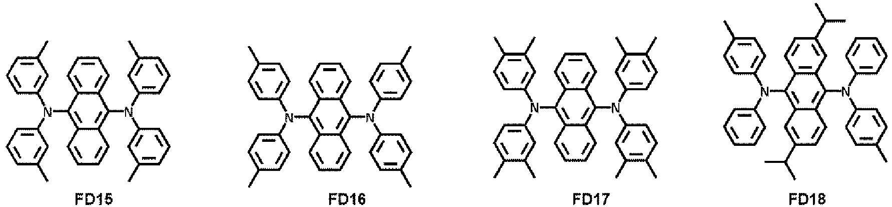

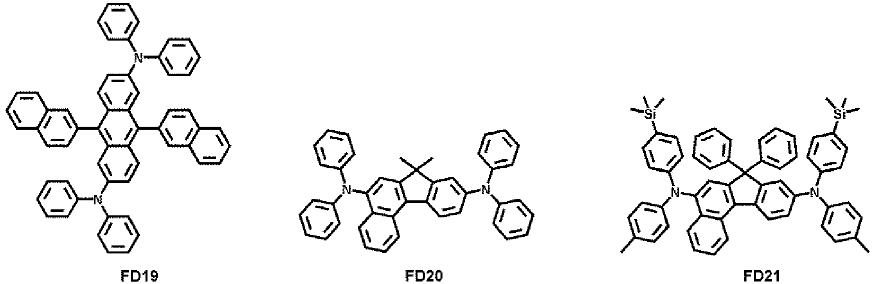

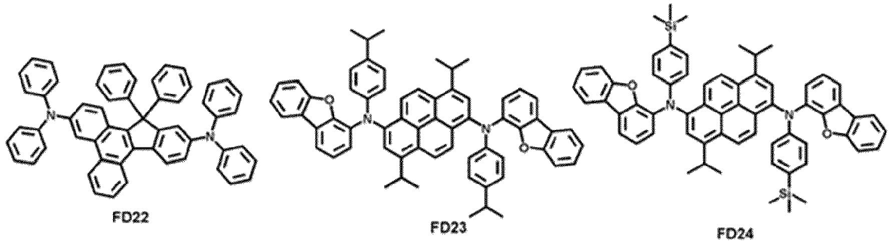

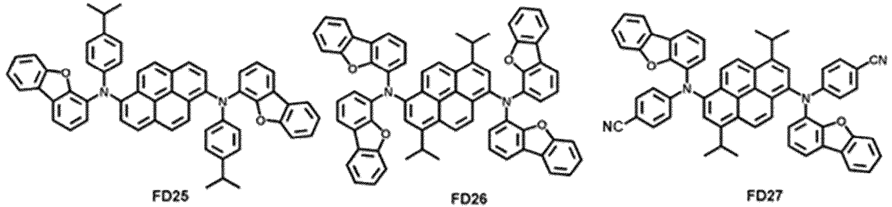

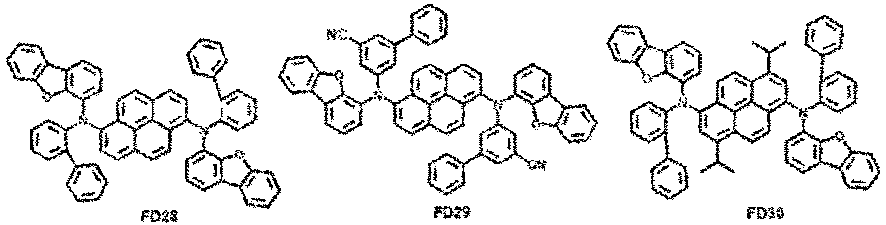

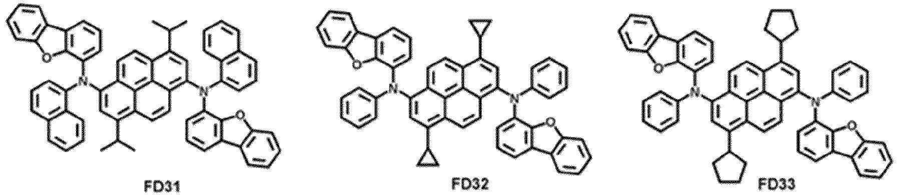

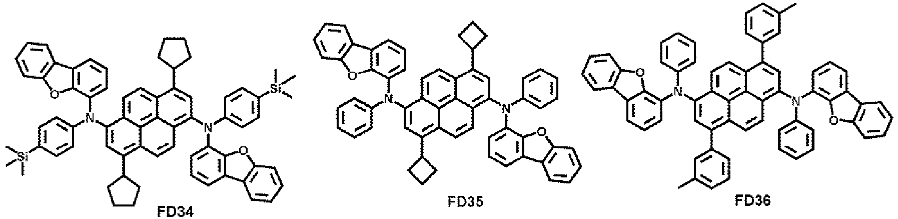

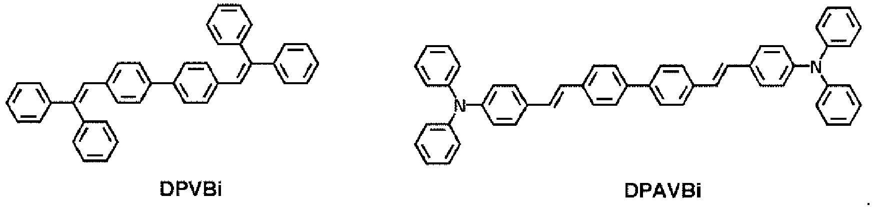

### [Delayed fluorescence material]

The emission layer 150 may include a delayed fluorescence material.

In the specification, a delayed fluorescence material may be selected from compounds capable of emitting delayed fluorescence, based on a delayed fluorescence emission mechanism.

The delayed fluorescence material included in the emission layer 150 may serve as a host or as a dopant, depending on the types of other materials included in the emission layer 150.

In an embodiment, a difference between a triplet energy level (eV) of the delayed fluorescence material and a singlet energy level (eV) of the delayed fluorescence material may be at least about 0 eV and not more than about 0.5 eV. When the difference between the triplet energy level (eV) of the delayed fluorescence material and the singlet energy level (eV) of the delayed fluorescence material satisfies the above-described range, up-conversion from a triplet state to a singlet state of the delayed fluorescence materials may effectively occur, and thus, the luminescence efficiency of the light-emitting device 10, 20, or 30 may be improved.

In an embodiment, the delayed fluorescence material may include: a material including at least one electron donor (for example, a π electron-rich C₃-C₆₀ cyclic group such as a carbazole group) and at least one electron acceptor (for example, a sulfoxide group, a cyano group, a π electron-deficient nitrogen-containing C₁-C₆₀ cyclic group, and the like); or a material including a C₈-C₆₀ polycyclic group that includes at least two cyclic groups that are condensed with each other while sharing boron (B).

In an embodiment, the delayed fluorescence material may include at least one of Compounds DF1 to DF9:

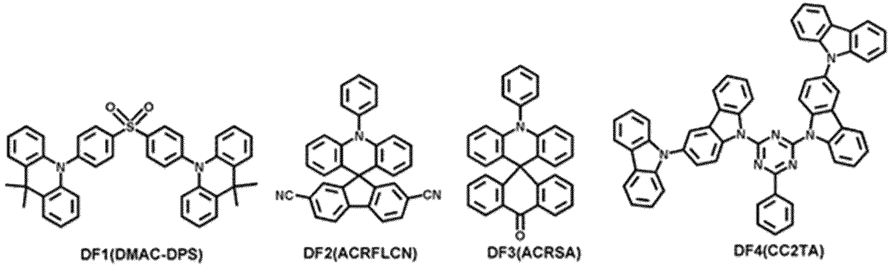

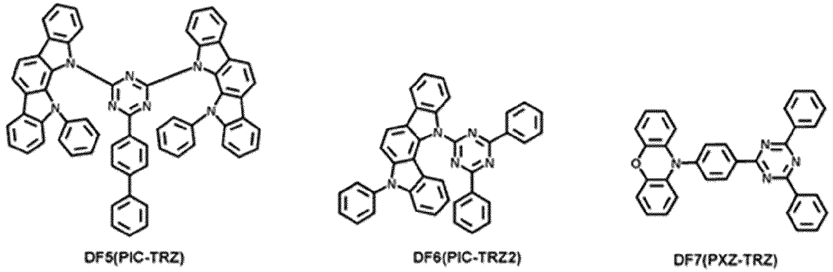

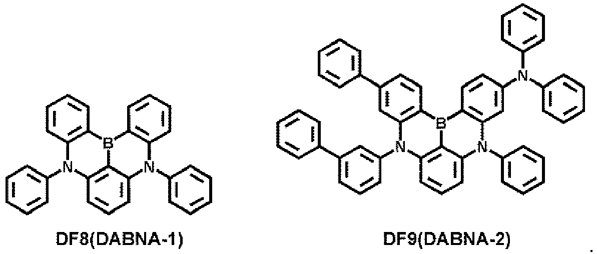

### [Quantum dots]

The emission layer 150 may include quantum dots.

In the specification, quantum dots may be crystals of a semiconductor compound, and may include any material capable of emitting light of various emission wavelengths according to a size of the crystals.

A diameter of a quantum dot may be, for example, in a range of about 1 nm to about 10 nm.

Quantum dots may be synthesized by a wet chemical process, a metal organic chemical vapor deposition process, a molecular beam epitaxy process, or any process similar thereto.

The wet chemical process is a method that includes mixing a precursor material with an organic solvent and growing quantum dot particle crystals. When the crystals grow, the organic solvent naturally serves as a dispersant that is coordinated on the surface of the quantum dot crystals and controls the growth of the crystals so that the growth of quantum dot particles may be controlled through a process which costs less and may be more readily performed than vapor deposition methods, such as metal organic chemical vapor deposition (MOCVD) or molecular beam epitaxy (MBE).

A quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

In embodiments, the quantum dots may have a single structure in which the concentration of each element in the quantum dots is uniform, or the quantum dots may have a core-shell structure. In an embodiment, when a quantum dot has a core-shell structure, a material included in the core and a material included in the shell may be different from each other.

The shell of a quantum dot may serve as a protective layer that prevents chemical degeneration of the core to maintain semiconductor characteristics, and/or may serve as a charging layer that imparts electrophoretic characteristics to the quantum dot. The shell may be single-layered or multi-layered. An interface between the core and the shell may have a concentration gradient in which the concentration of an element that is present in the shell decreases toward the core.

Examples of a shell of quantum dot may include a metal oxide, a metalloid, a non-metal oxide, a semiconductor compound, and any combination thereof. Examples of a metal oxide, a metalloid oxide, or non-metal oxide may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and the like; a ternary compound, such as MgAl₂O₄, CoFe₂O₄, NiFe₂O₄, CoMn₂O₄, and the like; or any combination thereof. Examples of a semiconductor compound may include, as described above: a Group II-VI semiconductor compound; a Group III-V semiconductor compound; a Group III-VI semiconductor compound; a Group I-III-VI semiconductor compound; a Group IV-VI semiconductor compound; and any combination thereof.

A full width at half maximum (FWHM) of an emission wavelength spectrum of the quantum dot may be equal to or less than about 45 nm. For example, the FWHM of an emission wavelength spectrum of the quantum dot may be equal to or less than about 40 nm. For example, the FWHM of an emission wavelength spectrum of the quantum dot may be equal to or less than about 30 nm. Within any of the above ranges, color purity or color reproducibility of the quantum dots may be improved. Light emitted through the quantum dots may be emitted in all directions, so that a wide viewing angle may be improved.

In embodiments, quantum dots may be in the form nanoparticles, nanotubes, nanowires, nanofibers, nanoplates, or the like. For example, quantum dots may be in the form of spherical particles, pyramidal particles, multi-arm particles, or cubic particles.

By controlling a size of the quantum dots, an energy band gap may be adjusted so that light having various wavelength bands may be obtained from an emission layer that includes the quantum dots. Accordingly, by using the quantum dots of different sizes, a light-emitting device that emits light of various wavelengths may be implemented. For example, the size of a quantum dot may be selected to emit red light, green light, and/or blue light. In an embodiment, the size of quantum dots may be configured to emit white light by combining light of various colors.

### [Electron transport region 170 in interlayer]

The electron transport region 170 may have a structure consisting of a layer consisting of a single material, a structure consisting of a layer including different materials, or a structure including multiple layers including different materials.

The electron transport region 170 may include a buffer layer, a hole blocking layer, an electron control layer, an electron transport layer, an electron injection layer, or any combination thereof.

In embodiments, the electron transport region 170 may have a multilayered structure, for example, an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the layers of each structure may be stacked from the emission layer 150 in its respective stated order, but the structure of the electron transport region 170 is not limited thereto.

The electron transport region 170 (e.g., a buffer layer, a hole blocking layer, an electron control layer, or an electron transport layer in the electron transport region 170) may include a metal-free compound that includes at least one π electron-deficient nitrogen-containing C₁-C₆₀ cyclic group.

In embodiments, the electron transport region 170 may include a compound represented by Formula 601.

[Formula 601] [Ar₆₀₁]ₓₑ₁₁-[(L₆₀₁)ₓₑ₁-R₆₀₁]ₓₑ₂₁

In Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or - P(=O)(Q₆₀₁)(Q₆₀₂),
Q₆₀₁ to Q₆₀₃ may each independently be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, in Formula 601, when xe11 is 2 or more, two or more of Ar₆₀₁ may be linked together via a single bond.

In an embodiment, in Formula 601, Ar₆₀₁ may be a substituted or unsubstituted anthracene group.

In an embodiment, the electron transport region 170 may include a compound represented by Formula 601-1:

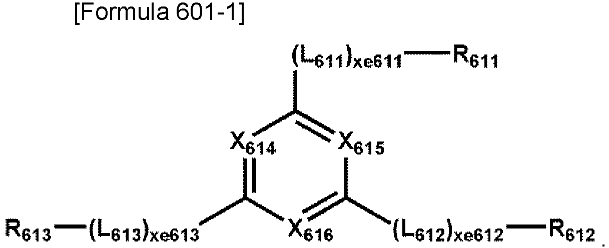

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may each be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In an embodiment, in Formulae 601 and 601-1, xe1 and xe611 to xe613 may each independently be 0, 1, or 2.

In embodiments, the electron transport region may include one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

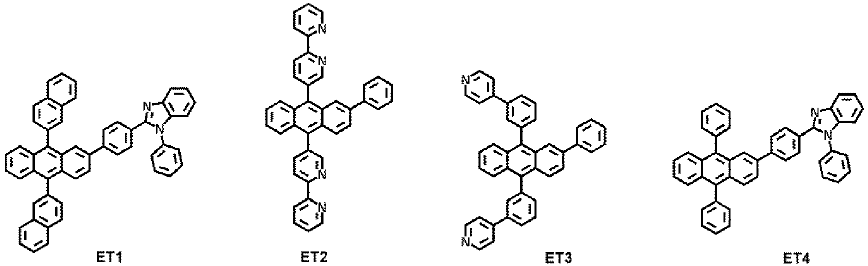

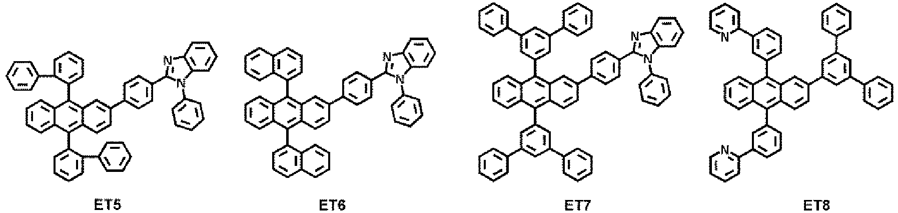

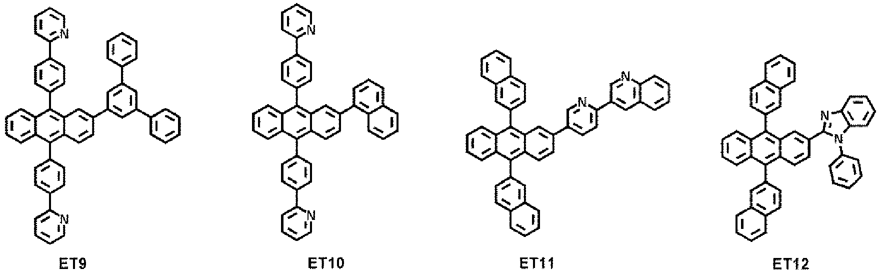

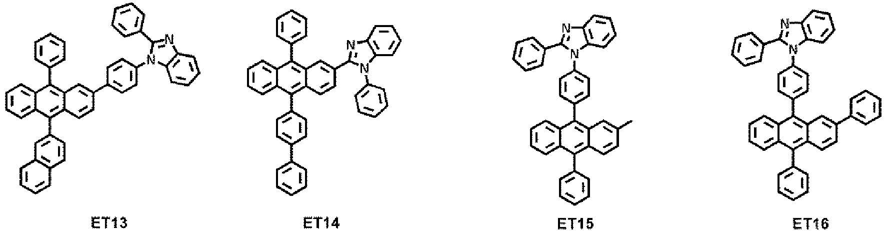

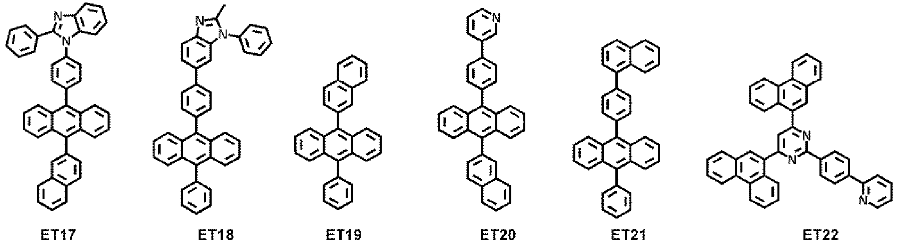

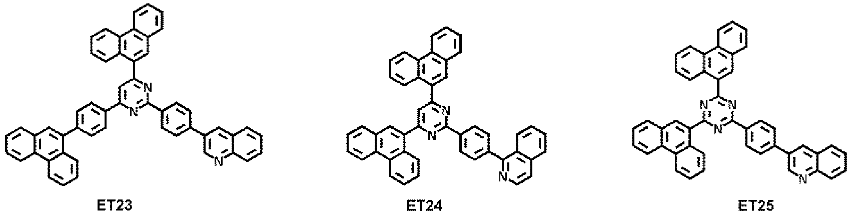

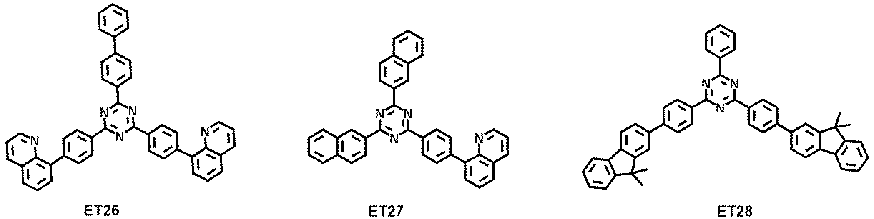

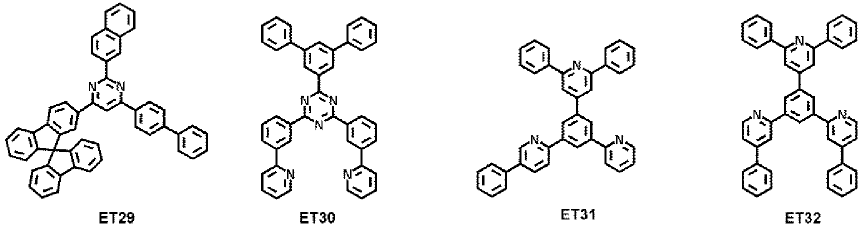

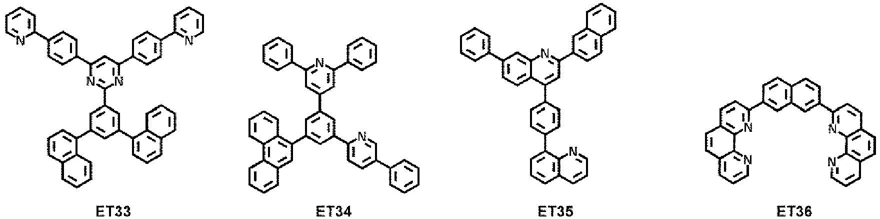

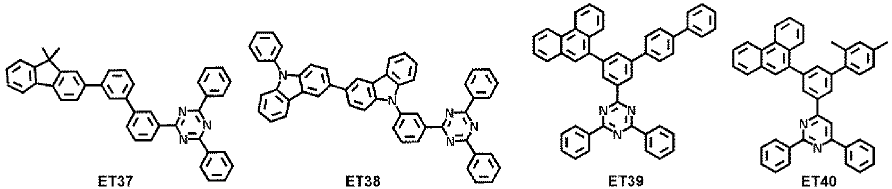

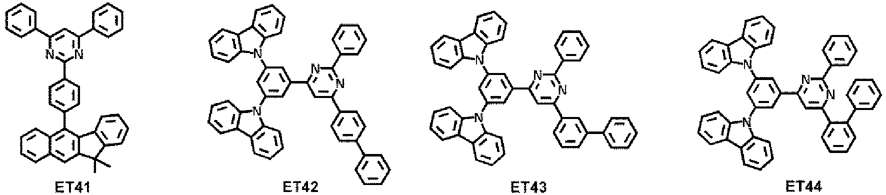

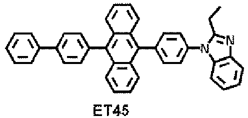

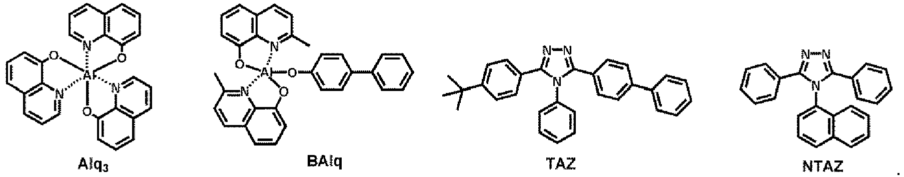

A thickness of the electron transport region 170 may be in a range of about 100 Å to about 5,000 Å. For example, the thickness of the electron transport region 170 may be in a range of about 160 Å to about 4,000 Å. When the electron transport region 170 includes a buffer layer, a hole blocking layer, an electron control layer, an electron transport layer, or any combination thereof, a thickness of the buffer layer, the hole blocking layer, or the electron control layer may each independently be in a range of about 20 Å to about 1,000 Å, and a thickness of the electron transport layer may be in a range of about 100 Å to about 1,000 Å. For example, the thickness of the buffer layer, the hole blocking layer, or the electron control layer may each independently be in a range of about 30 Å to about 300 Å. For example, the thickness of the electron transport layer may be in a range of about 150 Å to about 500 Å. When the thicknesses of the buffer layer, the hole blocking layer, the electron control layer, the electron transport layer, and/or the electron transport region 170 are within the ranges described above, satisfactory electron transporting characteristics may be obtained without a substantial increase in driving voltage.

The electron transport region 170 (for example, an electron transport layer in the electron transport region 170) may further include, in addition to the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with a metal ion of an alkali metal complex or with a metal ion of an alkaline earth-metal complex may each independently include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or Compound ET-D2:

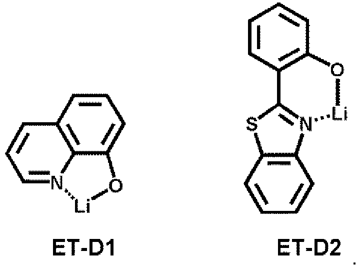

The electron transport region 170 may include an electron injection layer that facilitates the injection of electrons from the second electrode 190. The electron injection layer may directly contact the second electrode 190.

The electron injection layer may have a structure consisting of a layer consisting of a single material, a structure consisting of a layer including different materials, or a structure including multiple layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, iodides, etc.), or tellurides of the alkali metal, the alkaline earth metal, and the rare earth metal, or any combination thereof.

The alkali metal-containing compound may include: an alkali metal oxide, such as Li₂O, Cs₂O, or K₂O; an alkali metal halide, such as LiF, NaF, CsF, KF, Lil, Nal, Csl, or KI; or any combination thereof. The alkaline earth metal-containing compound may include an alkaline earth metal oxide, such as BaO, SrO, CaO, BaₓSr₁₋ₓO (wherein x is a real number satisfying 0<x<1), or BaₓCa₁₋ₓO (wherein x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In an embodiment, the rare earth metal-containing compound may include a lanthanide metal telluride. Examples of a lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include: an alkali metal ion, an alkaline earth metal ion, or a rare earth metal ion; and a ligand bonded to the metal ion (for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof).

In an embodiment, the electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In an embodiment, the electron injection layer may further include an organic material (for example, a compound represented by Formula 601).

In an embodiment, the electron injection layer may consist of an alkali metal-containing compound (for example, an alkali metal halide); or the electron injection layer may consist of an alkali metal-containing compound (for example, an alkali metal halide), and an alkali metal, an alkaline earth metal, a rare earth metal, or any combination thereof. In an embodiment, the electron injection layer may be a KI:Yb co-deposited layer, an Rbl:Yb co-deposited layer, a LiF:Yb co-deposited layer, or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 1 Å to about 100 Å. For example, the thickness of the electron injection layer may be in a range of about 3 Å to about 90 Å. When the thickness of the electron injection layer is within any of the ranges as described above, satisfactory electron injection characteristics may be obtained without a substantial increase in driving voltage.

### [Second electrode 190]

The second electrode 190 may be arranged on the interlayer having the aforementioned structure. The second electrode 190 may be a cathode, which is an electron injection electrode. When the second electrode 190 is a cathode, the second electrode 190 may include a material having a low-work function, such as a metal, an alloy, an electrically conductive compound, or any combination thereof.

The second electrode 190 may include Li, Ag, Mg, Al, Al-Li, Ca, Mg-In, Mg-Ag, Yb, Ag-Yb, ITO, IZO, or any combination thereof. The second electrode 190 may be a transmissive electrode, a semi-transmissive electrode, or a reflective electrode.

The second electrode 150 may have a single-layered structure or a multi-layered structure.

### [Capping layer]

The light-emitting device 10, 20, or 30 may include a first capping layer arranged outside the first electrode 110, and/or a second capping layer arranged outside the second electrode 190. In embodiments, the light-emitting device 10, 20, or 30 may have a structure in which the first capping layer, the first electrode 110, the interlayer, and the second electrode 190 are stacked in this stated order, a structure in which the first electrode 110, the interlayer, the second electrode 190, and the second capping layer are stacked in this stated order, or a structure in which the first capping layer, the first electrode 110, the interlayer, the second electrode 190, and the second capping layer are stacked in this stated order.

Light generated in the emission layer 150 of the interlayer of the light-emitting device 10, 20, or 30 may be extracted through the first electrode 110, which may be a semi-transmissive electrode or a transmissive electrode, and through the first capping layer to the outside. Light generated in the emission layer 150 of the interlayer of the light-emitting device 10, 20, or 30 may be extracted through the second electrode 190, which may be a semi-transmissive electrode or a transmissive electrode, and through the second capping layer to the outside.

The first capping layer and the second capping layer may each increase external emission efficiency according to the principle of constructive interference. Accordingly, light extraction efficiency of the light-emitting device 10, 20, or 30 is increased, such that the luminescence efficiency of the light-emitting device 10, 20, or 30 may be increased.

The first capping layer and the second capping layer may each include a material having a refractive index equal to or greater than about 1.6 (with respect to a wavelength of about 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, Cl, Br, I, or any combination thereof. In an embodiment, at least one of the first capping layer and the second capping layer may each independently include an amine group-containing compound.

In an embodiment, at least one of the first capping layer and the second capping layer may each independently include a compound represented by Formula 201, a compound represented by Formula 202, or any combination thereof.

In an embodiment, at least one of the first capping layer and the second capping layer may each independently include one of Compounds HT28 to HT33, one of Compounds CP1 to CP6, β-NPB, or any combination thereof:

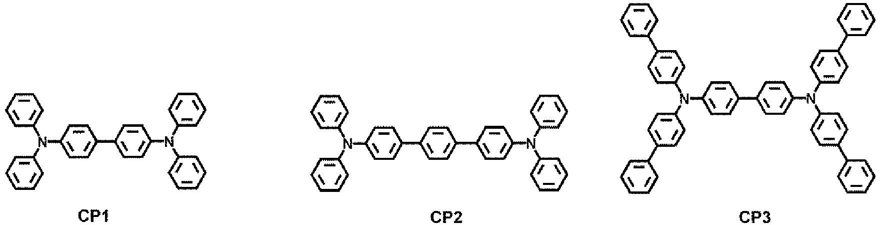

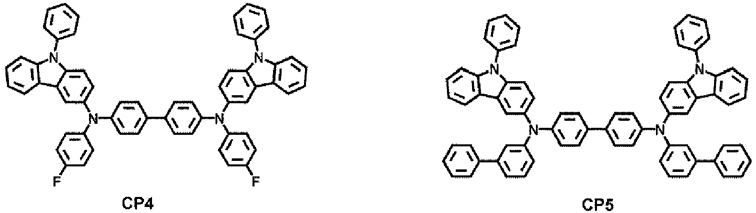

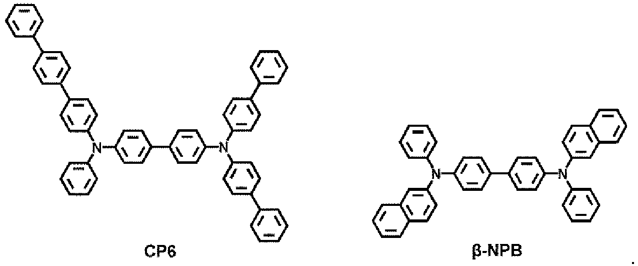

[Film]

The first host, the second host, the first dopant, and/or the second dopant may be included in various films. Thus, according to embodiments, a film may include the first host, the second host, the first dopant, and/or the second dopant. The film may be, for example, an optical member (or a light control means) (e.g., a color filter, a color conversion member, a capping layer, a light extraction efficiency enhancement layer, a selective light absorbing layer, a polarizing layer, a quantum dot-containing layer, etc.), a light blocking member (e.g., a light reflective layer, a light absorbing layer, etc.), a protective member (e.g., an insulating layer, a dielectric layer, etc.), or the like.

### [Electronic apparatus]

The light-emitting device 10, 20, or 30 may be included in various electronic apparatuses. For example, an electronic apparatus including the light-emitting device 10, 20, or 30 may be a light-emitting apparatus, an authentication apparatus, or the like.

The electronic apparatus (e.g., a light-emitting apparatus) may further include a color filter, a color conversion layer, or both a color filter and a color conversion layer, in addition to the light-emitting device 10, 20, or 30. The color filter and/or the color conversion layer may be arranged in at least one traveling direction of light emitted from the light-emitting device 10, 20, or 30. For example, the light emitted from the light-emitting device 10, 20, or 30 may be blue light or white light. Further details on the light-emitting device 10, 20, or 30 may be the same as described herein. In an embodiment, the color conversion layer may include quantum dots. The quantum dots may be, for example, the quantum dots as described above.

The electronic apparatus may further include a light control layer. The light control layer may be arranged in at least one traveling direction of light emitted from the light-emitting device 10, 20, or 30. For example, the light control layer may be arranged on the light-emitting device 10, 20, or 30. In an embodiment, the light control layer may include quantum dots. The quantum dots may be, for example, the quantum dots as described above.

The electronic apparatus may include a substrate. The substrate may include subpixels, the color filter may include color filter areas respectively corresponding to the subpixels, and the color conversion layer may include color conversion areas respectively corresponding to the subpixels.

A pixel-defining film may be arranged between the subpixels to define each subpixel.

The color filter may further include color filter areas and light-shielding patterns arranged between the color filter areas, and the color conversion layer may further include color conversion areas and light-shielding patterns arranged between the color conversion areas.

The color filter areas (or the color conversion areas) may include a first area emitting first color light, a second area emitting second color light, and/or a third area emitting third color light, wherein the first color light, the second color light, and/or the third color light may have different maximum emission wavelengths. In an embodiment, the first color light may be red light, the second color light may be green light, and the third color light may be blue light. In an embodiment, the color filter areas (or the color conversion areas) may include quantum dots. For example, the first area may include red quantum dots, the second area may include green quantum dots, and the third area may not include quantum dots. Further details on the quantum dots may be the same as described herein. The first area, the second area, and/or the third area may each further include a scatterer.

In an embodiment, the light-emitting device 10, 20, or 30 may emit first light, the first area may absorb the first light to emit first-first color light, the second area may absorb the first light to emit second-first color light, and the third area may absorb the first light to emit third-first color light. The first-first color light, the second-first color light, and the third-first color light may have different maximum emission wavelengths. For example, the first light may be blue light, the first-first color light may be red light, the second-first color light may be green light, and the third-first color light may be blue light.

The electronic apparatus may further include a thin-film transistor, in addition to the light-emitting device 10, 20, or 30 as described above. The thin-film transistor may include a source electrode, a drain electrode, and an active layer, wherein any one of the source electrode and the drain electrode may be electrically connected to any one of the first electrode and the second electrode of the light-emitting device 10, 20, or 30.

The thin-film transistor may further include a gate electrode, a gate insulating film, or the like.

The active layer may include crystalline silicon, amorphous silicon, an organic semiconductor, an oxide semiconductor, and the like.

The electronic apparatus may further include a sealing portion for sealing the light-emitting device 10, 20, or 30. The sealing portion may be arranged between the color filter and/or the color conversion layer and the light-emitting device 10, 20, or 30. The sealing portion allows light from the light-emitting device 10, 20, or 30 to be extracted to the outside, and simultaneously prevents ambient air and moisture from penetrating into the light-emitting device 10, 20, or 30. The sealing portion may be a sealing substrate that includes a transparent glass substrate or a plastic substrate. The sealing portion may be a thin-film encapsulation layer that includes at least one of an organic layer and/or an inorganic layer. When the sealing portion is a thin film encapsulation layer, the electronic apparatus may be flexible.

Various functional layers may be further included on the sealing portion, in addition to the color filter and/or the color conversion layer, according to a use of the electronic apparatus. Examples of a functional layer may include a touch screen layer and a polarizing layer. The touch screen layer may be a pressure-sensitive touch screen layer, a capacitive touch screen layer, or an infrared touch screen layer.

The authentication apparatus may further include, in addition to the light-emitting device as described above, a biometric information collector. The authentication apparatus may be, for example, a biometric authentication apparatus that authenticates an individual by using biometric information of a living body (for example, fingertips, pupils, etc.).

The electronic apparatus may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and the like.

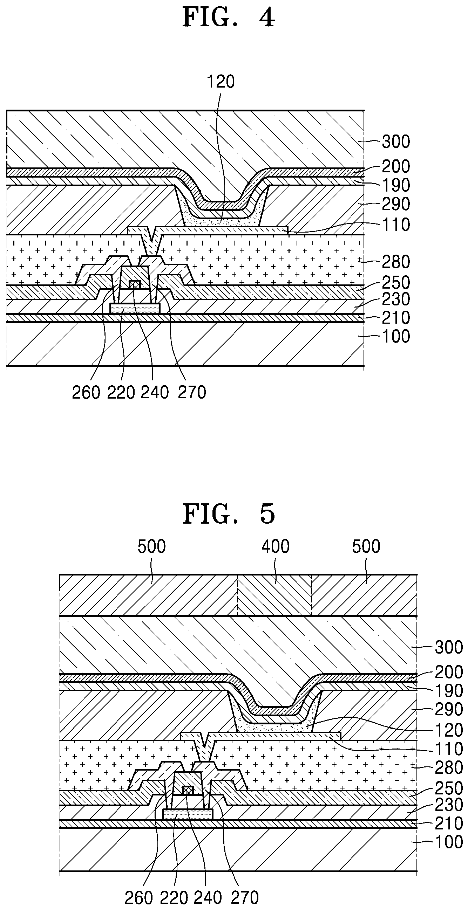

### [Description of FIGS. 4 and 5]

FIG. 4 is a schematic cross-sectional view of an electronic apparatus according to an embodiment.

The electronic apparatus (for example, a light-emitting apparatus) of FIG. 4 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent penetration of impurities through the substrate 100 and may provide a flat surface on the substrate 100.

A TFT may be arranged on the buffer layer 210. The TFT may include an active layer 220, a gate electrode 240, a source electrode 260, and a drain electrode 270.

The active layer 220 may include an inorganic semiconductor such as silicon or polysilicon, an organic semiconductor, or an oxide semiconductor, and the active layer 220 may include a source region, a drain region, and a channel region.

A gate insulating film 230 for insulating the active layer 220 from the gate electrode 240 may be arranged on the active layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 and between the gate electrode 240 and the drain electrode 270 to insulate the gate electrode 240, the source electrode 260, and the drain electrode 270 from one another.

The source electrode 260 and the drain electrode 270 may be arranged on the interlayer insulating film 250. The interlayer insulating film 250 and the gate insulating film 230 may be formed to expose a source region and a drain region of the active layer 220, and the source electrode 260 and the drain electrode 270 may respectively contact the exposed portions of the source region and the drain region of the active layer 220.

The TFT may be electrically connected to a light-emitting device to drive the light-emitting device, and may be covered and protected by a passivation layer 280. The passivation layer 280 may include an inorganic insulating film, an organic insulating film, or any combination thereof. The light-emitting device may be provided on the passivation layer 280. The light-emitting device may include the first electrode 110, an interlayer 120, and the second electrode 190.

The first electrode 110 may be arranged on the passivation layer 280. The passivation layer 280 may not completely cover the drain electrode 270 and may expose a portion of the drain electrode 270. The first electrode 110 may be connected (for example, electrically connected) to the exposed portion of the drain electrode 270.

A pixel-defining film 290 including an insulating material may be arranged on the first electrode 110. The pixel defining layer 290 may expose a region of the first electrode 110, and the interlayer 120 may be formed on the exposed region of the first electrode 110. The pixel-defining film 290 may be a polyimide-based organic film or a polyacrylic organic film. Although not shown in FIG. 4, at least some layers of the interlayer 120 may extend beyond the upper portion of the pixel defining layer 290 to be provided in the form of a common layer.

The second electrode 190 may be arranged on the interlayer 120, and a capping layer 200 may be further included on the second electrode 190. The capping layer 200 may be formed to cover the second electrode 190.

The encapsulation portion 300 may be arranged on the capping layer 200. The encapsulation portion 300 may be disposed on the light-emitting device to protect the light-emitting device from moisture and/or oxygen. The encapsulation portion 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (e.g., polymethyl methacrylate, polyacrylic acid, etc.), an epoxy-based resin (e.g., aliphatic glycidyl ether (AGE), etc.), or any combination thereof; or any combination of the inorganic films and the organic films.

FIG. 5 is a schematic cross-sectional view of an electronic apparatus according to another embodiment.

The electronic apparatus (for example, a light-emitting apparatus) of FIG. 5 may differ from the electronic apparatus of FIG. 4, at least in that a light-shielding pattern 500 and a functional region 400 are further included on the encapsulation portion 300. The functional region 400 may be a color filter area, a color conversion area, or a combination of the color filter area and the color conversion area. The functional region 400 may further include a light control layer, as described herein.

In an embodiment, the light-emitting device included in the electronic apparatus of FIG. 5 may be a tandem light-emitting device.

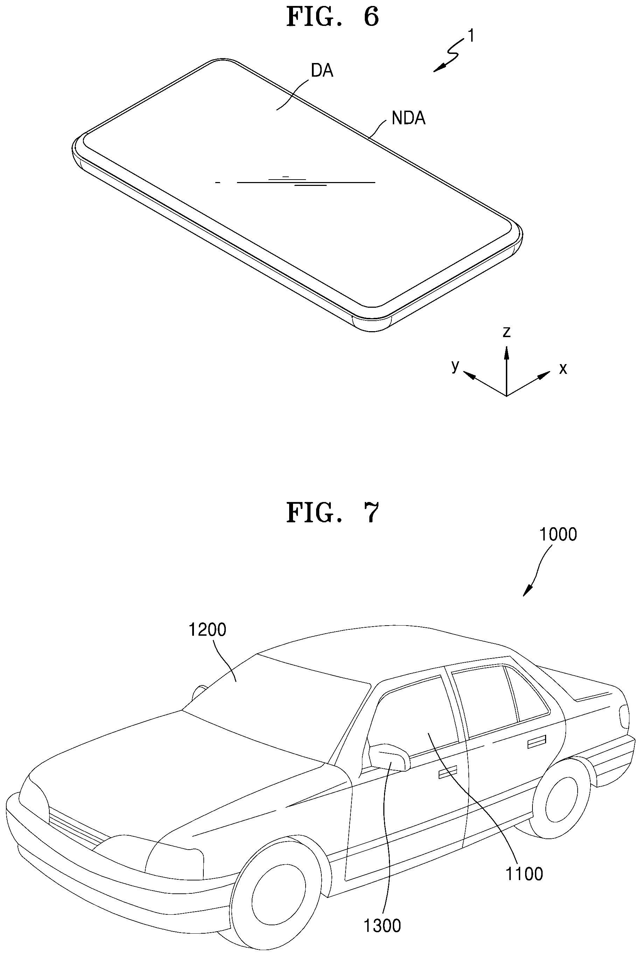

### [Description of FIG. 6]

FIG. 6 is a schematic perspective view of an electronic equipment 1 including the light-emitting device according to an embodiment.

The electronic equipment 1, which may be an apparatus that displays a moving image or a still image, may be not only a portable electronic equipment, such as a mobile phone, a smartphone, a tablet computer, a mobile communication terminal, an electronic notebook, an electronic book, a portable multimedia player (PMP), a navigation device, or an ultra-mobile PC (UMPC), but may also be various products, such as a television, a laptop computer, a monitor, a billboard, or an Internet of things (IoT) device. The electronic equipment 1 may be any such product as described above or a part thereof.

In an embodiment, the electronic equipment 1 may be a wearable device, such as a smart watch, a watch phone, a glasses-type display, or a head mounted display (HMD), or a part of the wearable device. However, embodiments are not limited thereto.

In embodiments, examples of the electronic equipment 1 may include a dashboard of a vehicle, a center information display arranged on a center fascia or on dashboard of a vehicle, a room mirror display that replaces a side-view mirror of a vehicle, an entertainment display for a rear seat of a vehicle or arranged on the back of a front seat of a vehicle, a head-up display (HUD) installed at the front of a vehicle or projected on a front window glass, or a computer generated hologram augmented reality head up display (CGH AR HUD). FIG. 6 illustrates an embodiment in which the electronic equipment 1 is a smartphone, for convenience of description.

The electronic equipment 1 may include a display area DA and a non-display area NDA outside the display area DA. A display apparatus may implement an image through a two-dimensional array of pixels that are arranged in the display area DA.

The non-display area NDA is an area that does not display an image, and may surround (for example, entirely surround) the display area DA. A driver, which provides electrical signals or power to display devices arranged on the display area DA, may be arranged in the non-display area NDA. A pad, which is an area to which an electronic element or a printed circuit board may be electrically connected, may be arranged in the non-display area NDA.

In the electronic equipment 1, a length in an x-axis direction and a length in a y-axis direction may be different from each other. In an embodiment, as shown in FIG. 6, the length in the x-axis direction may be shorter than the length in the y-axis direction. In an embodiment, the length in the x-axis direction may be the same as the length in the y-axis direction. In an embodiment, the length in the x-axis direction may be greater than the length in the y-axis direction.

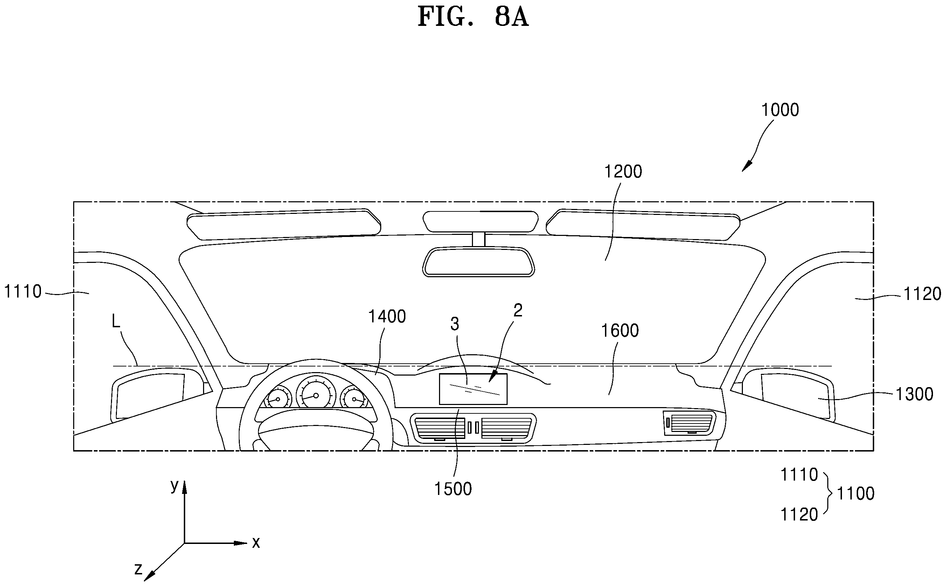

### [Description of FIGS. 7 and 8A to 8C]

FIG. 7 is a schematic perspective view of an exterior of a vehicle 1000 as an electronic equipment including a light-emitting device, according to an embodiment. FIGS. 8A to 8C are each a schematic diagram of an interior of a vehicle 1000 according to embodiments.

Referring to FIGS. 7 and 8A to 8C, embodiments of a vehicle 1000 may include various apparatuses for moving a subject object to be transported, such as a person, an object, or an animal, from a departure point to a destination. Examples of a vehicle 1000 may include a vehicle traveling on a road or a track, a vessel moving over a sea or a river, an airplane flying in the sky using the action of air, and the like.

The vehicle 1000 may travel on a road or a track. The vehicle 1000 may move in a selected or given direction according to the rotation of at least one wheel. In an embodiment, examples of a vehicle 1000 may include a three-wheeled or four-wheeled vehicle, a construction machine, a two-wheeled vehicle, a prime mover device, a bicycle, and a train running on a track.

The vehicle 1000 may include a vehicle body having an interior and an exterior, and a chassis that is a portion excluding the vehicle body in which mechanical apparatuses necessary for driving are installed. The exterior of the vehicle body may include a front panel, a bonnet, a roof panel, a rear panel, a trunk, a pillar provided at a boundary between doors, and the like. The chassis may include a power generating device, a power transmitting device, a driving device, a steering device, a braking device, a suspension device, a transmission device, a fuel device, front and rear wheels, left and right wheels, and the like.

The vehicle 1000 may include a side window glass 1100, a front window glass 1200, a side-view mirror 1300, a cluster 1400, a center fascia 1500, a passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on a side of the vehicle 1000. In an embodiment, the side window glass 1100 may be installed on a door of the vehicle 1000. Multiple side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400, and the second side window glass 1120 may be arranged adjacent to the passenger seat dashboard 1600.

In an embodiment, the side window glasses 1100 may be spaced apart from each other in an x direction or a -x direction. In an embodiment, the first side window glass 1110 and the second side window glass 1120 may be spaced apart from each other in the x direction or the -x direction. For example, a virtual straight line L connecting the side window glasses 1100 may extend in the x direction or the -x direction. In an embodiment, a virtual straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side-view mirror 1300 may provide a rear view of the vehicle 1000. The side-view mirror 1300 may be installed on the exterior of the vehicle body. In an embodiment, multiple side-view mirrors 1300 may be provided. For example, one of the side-view mirrors 1300 may be arranged outside the first side window glass 1110, and another of the side-view mirrors 1300 may be arranged outside the second side window glass 1120.

The cluster 1400 may be arranged in front of a steering wheel. The cluster 1400 may include a tachometer, a speedometer, a coolant thermometer, a fuel gauge, a turn signal indicator, a high beam indicator, a warning light, a seat belt warning light, an odometer, a tachograph, an automatic shift selector indicator, a door open warning light, an engine oil warning light, and/or a low fuel warning light.

The center fascia 1500 may include a control panel on which buttons for adjusting an audio device, an air conditioning device, and a seat heater are disposed. The center fascia 1500 may be arranged on a side of the cluster 1400.

The passenger seat dashboard 1600 may be spaced apart from the cluster 1400, and the center fascia 1500 may be arranged between the cluster 1400 and the passenger seat dashboard 1600. In an embodiment, the cluster 1400 may be arranged to correspond to a driver seat (not shown), and the passenger seat dashboard 1600 may be arranged to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display apparatus 2 may include a display panel 3, and the display panel 3 may display an image. The display apparatus 2 may be arranged inside the vehicle 1000. In an embodiment, the display apparatus 2 may be arranged between the side window glasses 1100 facing each other. The display apparatus 2 may be arranged on at least one of the cluster 1400, the center fascia 1500, and the passenger seat dashboard 1600.

The display apparatus 2 may include an organic light-emitting display, an inorganic electroluminescent display, a quantum dot display, or the like. Hereinafter, an organic light-emitting display apparatus including the light-emitting device according to an embodiment will be described as an example of the display apparatus 2. However, various types of display apparatuses as described above may be used in embodiments.

Referring to FIG. 8A, the display apparatus 2 may be arranged on the center fascia 1500. In an embodiment, the display apparatus 2 may display navigation information. In an embodiment, the display apparatus 2 may display information regarding audio settings, video settings, or vehicle settings.

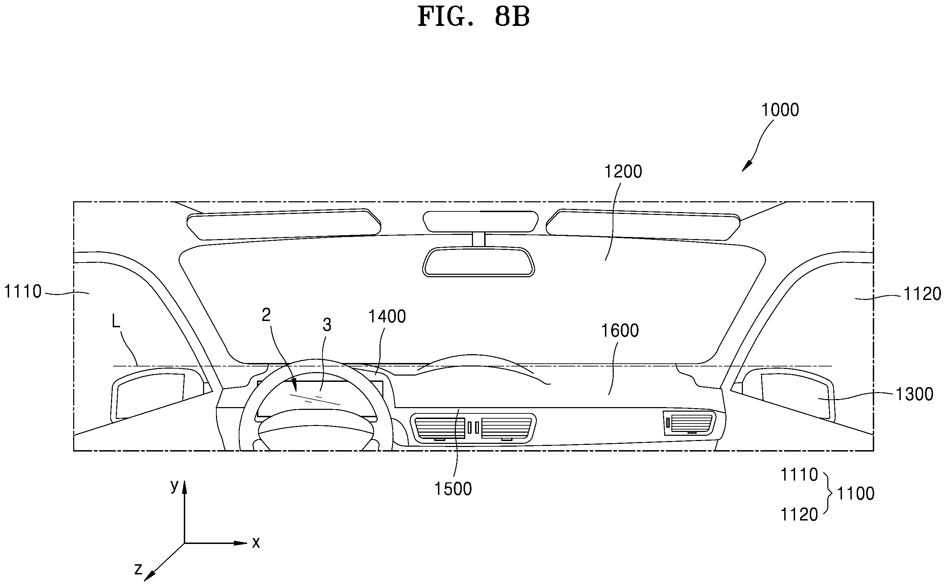

Referring to FIG. 8B, the display apparatus 2 may be arranged on the cluster 1400. The cluster 1400 may display driving information and the like through the display apparatus 2. For example, the cluster 1400 may digitally implement driving information and the like. The cluster 1400 may digitally implement vehicle information and driving information as images. In an embodiment, a needle and a gauge of a tachometer and various warning lights or icons may be displayed by a digital signal.

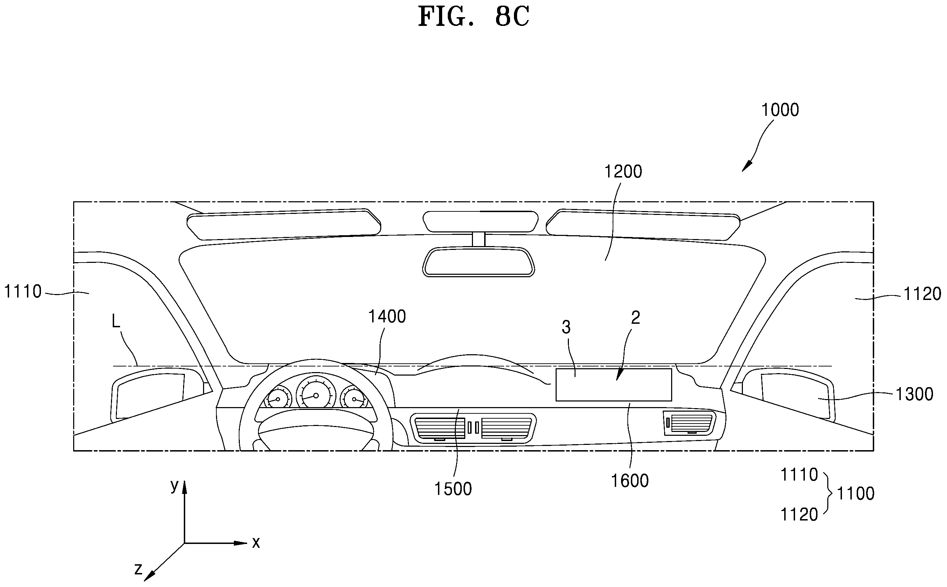

Referring to FIG. 8C, the display apparatus 2 may be arranged on the passenger seat dashboard 1600. The display apparatus 2 may be embedded in the passenger seat dashboard 1600 or arranged on the passenger seat dashboard 1600. In an embodiment, the display apparatus 2 arranged on the passenger seat dashboard 1600 may display an image that is related to information displayed on the cluster 1400 and/or information displayed on the center fascia 1500. In an embodiment, the display apparatus 2 arranged on the passenger seat dashboard 1600 may display information that is different from information displayed on the cluster 1400 and/or information displayed on the center fascia 1500.

### [Manufacturing method]

Layers constituting the hole transport region 130, layers constituting the emission layer 150, and layers constituting the electron transport region 170 may be formed in a selected region by using various methods such as vacuum deposition, spin coating, casting, Langmuir-Blodgett (LB) deposition, ink-jet printing, laser-printing, laser-induced thermal imaging, and the like.

When the layers constituting the hole transport region 130, layers constituting the emission layer 150, and the layers constituting the electron transport region 170 are formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 Å/sec to about 100 Å/sec, depending on a material to be included in a layer to be formed and the structure of a layer to be formed.

### [Definitions of terms]

The term "C₃-C₆₀ carbocyclic group" as used herein may be a cyclic group consisting of carbon atoms as the only ring-forming atoms and having three to sixty carbon atoms. The term "C₁-C₆₀ heterocyclic group" as used herein may be a cyclic group that has one to sixty carbon atoms and further includes, in addition to the carbon atoms, at least one heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. In an embodiment, the number of ring-forming atoms of a C₁-C₆₀ heterocyclic group may be from 3 to 61.

The term "cyclic group" as used herein may be a C₃-C₆₀ carbocyclic group or a C₁-C₆₀ heterocyclic group.

The term "π electron-rich C₃-C₆₀ cyclic group" as used herein may be a cyclic group that has three to sixty carbon atoms and may not include *-N=*' as a ring-forming moiety. The term "π electron-deficient nitrogen-containing C₁-C₆₀ cyclic group" as used herein may be a heterocyclic group that has one to sixty carbon atoms and may include *-N=*' as a ring-forming moiety.

In embodiments,
a C₃-C₆₀ carbocyclic group may be a T1 group or a group in which two or more T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
a C₁-C₆₀ heterocyclic group may be a T2 group, a group in which two or more T2 groups are condensed with each other, or a group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
a π electron-rich C₃-C₆₀ cyclic group may be a T1 group, a group in which two or more T1 groups are condensed with each other, a T3 group, a group in which two or more T3 groups are condensed with each other, or a group in which at least one T3 group and at least one T1 group are condensed with each other (for example, a C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like), and
a π electron-deficient nitrogen-containing C₁-C₆₀ cyclic group may be a T4 group, a group in which two or more T4 groups are condensed with each other, a group in which at least one T4 group and at least one T1 group are condensed with each other, a group in which at least one T4 group and at least one T3 group are condensed with each other, or a group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like), wherein
a T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
a T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
a T3 group may be a furan group, a thiophene group, a 1H-pyrrole group, a silole group, or a borole group, and
a T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "C₃-C₆₀ carbocyclic group", "C₁-C₆₀ heterocyclic group", "π electron-rich C₃-C₆₀ cyclic group", and "π electron-deficient nitrogen-containing C₁-C₆₀ cyclic group" as used herein may each be a group condensed to any cyclic group, a monovalent group, or a polyvalent group (for example, a divalent group, a trivalent group, a tetravalent group, etc.) according to the structure of a formula for which the corresponding term is used. For example, a "benzene group" may be a benzo group, a phenyl group, a phenylene group, or the like, which may be readily understood by those of ordinary skill in the art according to the structure of a formula including the "benzene group."

Examples of a monovalent C₃-C₆₀ carbocyclic group or a monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of a divalent C₃-C₆₀ carbocyclic group or a divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein may be a linear or branched monovalent aliphatic hydrocarbon group that has one to sixty carbon atoms, and examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein may be a divalent group having a same structure as the C₁-C₆₀ alkyl group.

The term "C₂-C₆₀ alkenyl group" as used herein may be a monovalent hydrocarbon group having at least one carbon-carbon double bond in the middle or at a terminus of a C₂-C₆₀ alkyl group, and examples thereof may include an ethenyl group, a propenyl group, and a butenyl group. The term "C₂-C₆₀ alkenylene group" as used herein may be a divalent group having a same structure as the C₂-C₆₀ alkenyl group.

The term "C₂-C₆₀ alkynyl group" as used herein may be a monovalent hydrocarbon group having at least one carbon-carbon triple bond in the middle or at a terminus of a C₂-C₆₀ alkyl group, and examples thereof may include an ethynyl group and a propynyl group. The term "C₂-C₆₀ alkynylene group" as used herein may be a divalent group having a same structure as the C₂-C₆₀ alkynyl group.

The term "C₁-C₆₀ alkoxy group" as used herein may be a monovalent group represented by -O(A₁₀₁) (wherein A₁₀₁ may be a C₁-C₆₀ alkyl group), and examples thereof may include a methoxy group, an ethoxy group, and an isopropyloxy group.

The term "C₃-C₁₀ cycloalkyl group" as used herein may be a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "C₃-C₁₀ cycloalkylene group" as used herein may be a divalent group having a same structure as the C₃-C₁₀ cycloalkyl group.

The term "C₁-C₁₀ heterocycloalkyl group" as used herein may be a monovalent cyclic group that has one to ten carbon atoms and further includes, in addition to the carbon atoms, at least one heteroatom as a ring-forming atom, and examples thereof may include a 1,2,3,4-oxatriazolidinyl group, a tetrahydrofuranyl group, and a tetrahydrothiophenyl group. The term "C₁-C₁₀ heterocycloalkylene group" as used herein may be a divalent group having a same structure as the C₁-C₁₀ heterocycloalkyl group.

The term "C₃-C₁₀ cycloalkenyl group" as used herein may be a monovalent cyclic group that has three to ten carbon atoms and at least one carbon-carbon double bond in the cyclic structure thereof and no aromaticity, and examples thereof may include a cyclopentenyl group, a cyclohexenyl group, and a cycloheptenyl group. The term "C₃-C₁₀ cycloalkenylene group" as used herein may be a divalent group having a same structure as the C₃-C₁₀ cycloalkenyl group.

The term "C₁-C₁₀ heterocycloalkenyl group" as used herein may be a monovalent cyclic group that has one to ten carbon atoms that further includes, in addition to the carbon atoms, at least one heteroatom as a ring-forming atom, and has at least one double bond in the cyclic structure thereof. Examples of a C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein may be a divalent group having a same structure as the C₁-C₁₀ heterocycloalkenyl group.

The term "C₆-C₆₀ aryl group" as used herein may be a monovalent group having a carbocyclic aromatic system of six to sixty carbon atoms, and the term "C₆-C₆₀ arylene group" as used herein may be a divalent group having a carbocyclic aromatic system of six to sixty carbon atoms. Examples of a C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the respective two or more rings may be condensed with each other.

The term "C₁-C₆₀ heteroaryl group" as used herein may be a monovalent group having a heterocyclic aromatic system that has one to sixty carbon atoms and further includes, in addition to the carbon atoms, at least one heteroatom as a ring-forming atom. The term "C₁-C₆₀ heteroarylene group" as used herein may be a divalent group having a heterocyclic aromatic system that has one to sixty carbon atoms and further includes, in addition to the carbon atoms, at least one heteroatom as a ring-forming atom. Examples of a C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the respective two or more rings may be condensed with each other.

The term "monovalent non-aromatic condensed polycyclic group" as used herein may be a monovalent group having two or more rings condensed with each other, only carbon atoms (for example, eight to sixty carbon atoms) as ring-forming atoms, and no aromaticity in its molecular structure when considered as a whole. Examples of a monovalent non-aromatic condensed polycyclic group may include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein may be a divalent group having a same structure as the monovalent non-aromatic condensed polycyclic group.

The term "monovalent non-aromatic condensed heteropolycyclic group" as used herein may be a monovalent group that has two or more rings condensed with each other that further includes, in addition to carbon atoms (for example, one to sixty carbon atoms), at least one heteroatom as a ring-forming atom, and has no aromaticity in its molecular structure when considered as a whole. Examples of a monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein may be a divalent group having a same structure as the monovalent non-aromatic condensed heteropolycyclic group.

The term "C₆-C₆₀ aryloxy group" as used herein may be a group represented by -O(A₁₀₂) (wherein A₁₀₂ may be a C₆-C₆₀ aryl group), and the term "C₆-C₆₀ arylthio group" as used herein may be a group represented by -S(A₁₀₃) (wherein A₁₀₃ may be a C₆-C₆₀ aryl group).

The term "C₇-C₆₀ arylalkyl group" as used herein may be a group represented by -(A₁₀₄)(A₁₀₅) (wherein A₁₀₄ may be a C₁-C₅₄ alkylene group, and A₁₀₅ may be a C₆-C₅₉ aryl group), and the term "C₂-C₆₀ heteroarylalkyl group" as used herein may be a group represented by -(A₁₀₆)(A₁₀₇) (wherein A₁₀₆ may be a C₁-C₅₉ alkylene group, and A₁₀₇ may be a C₁-C₅₉ heteroaryl group).

In the specification, the group "R₁₀ₐ" may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

In the specification, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group, a C₁-C₆₀ heterocyclic group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "heteroatom" as used herein may be any atom other than a carbon atom or a hydrogen atom. Examples of a heteroatom may include B, O, S, N, P, Si, B, Ge, Se, and any combination thereof.

In the specification, the term "Ph" refers to a phenyl group, the term "Me" refers to a methyl group, the term "Et" refers to an ethyl group, the terms "tert-Bu" and "Bu^{t}" each refers to a tert-butyl group, and the term "OMe" refers to a methoxy group.

The term "biphenyl group" as used herein may be a "phenyl group that is substituted with a phenyl group." For example, a "biphenyl group" may be a substituted phenyl group having a C₆-C₆₀ aryl group as a substituent.

The term "terphenyl group" as used herein may be a "phenyl group substituted with a biphenyl group." For example, a "terphenyl group" may be a substituted phenyl group having, as a substituent, a C₆-C₆₀ aryl group substituted with a C₆-C₆₀ aryl group.

The symbols * and *' as used herein, unless defined otherwise, each indicate a binding site to a neighboring atom in a corresponding formula or moiety.

Hereinafter, compounds according to embodiments and light-emitting devices according to embodiments will be described in detail with reference to the following Synthesis Examples and Examples.

### [Examples]

### [Synthesis Example]

Compound HTH29, Compound ETH94, and Compound PD41 were synthesized by referring to the published article (Jinwon Sun et al., Exceptionally stable blue phosphorescent organic light-emitting diodes, Nature Photonics, 16, pages 212-218 (2022)), the entirety of which is incorporated herein by reference.

Compound DFD26 was synthesized by referring to the published article (Eungdo Kim et al., Highly efficient and stable deep-blue organic light-emitting diode using phosphor-sensitized thermally activated delayed fluorescence, Science Advances, 8, eabq1641 (2022)), the entirety of which is incorporated herein by reference.

**[Table 1]**

| Compound No. | ¹H NMR (CDCl₃, 400 MHz) | MS/FAB | |
|---|---|---|---|
| | | found | calc. |
| HTH29 | 7.16-7.20(m, 3H), 7.35-7.60(m, 23H), 7.66-7.72(m, 3H), 7.94(d. 2H), 8.19 (m, 1H), 8.55(d, 2H) | 666.25 | 666.90 |
| ETH94 | 7.16(m, 4H), 7.35-7.64(m, 23H), 7.88-7.94(m, 3H), 8.19 (d, 2H), 8.38(m, 1H), 8.55 (d, 2H) | 745.27 | 745.96 |
| PD41 | 1.32(s, 9H), 1.92(s, 6H), 6.69(d, 1H), 7.00 (m, 1H), 7.20-7.31 (m, 7H), 7.40-7.50(m, 4H), 7.58(m, 1H), 8.19 (d, 1H), 8.39 (d,1H), 8.56(m, 2H), 8.74 (d, 1H) | 805.24 | 805.85 |
| DFD26 | 6.84(S. 2H), 7.16-7.55(m, 29H), 7.75(m, 4H), 7.85(s, 2H), 7.94 (d, 2H) 8.19(d, 2H), 8.55(d, 2H) | 902.36 | 902.91 |

### [Comparative Example 1]

As an anode, an ITO substrate was cut to a size of 50 mm x 50 mm x 0.5 mm, sonicated with acetone, isopropyl alcohol, and pure water each for 15 minutes, and cleaned by exposure to ultraviolet rays and ozone for 30 minutes each. The ITO substrate was provided to a vacuum deposition apparatus.

Compound HT3 was deposited on the ITO substrate to form a hole transport layer having a thickness of 1,250 Å, and Compound HTH29 was vacuum-deposited on the hole transport layer to form an electron blocking layer having a thickness of 50 Å.

On the electron blocking layer, Compound HTH29 (first host) and Compound ETH94 (second host) were deposited at a weight ratio of 6:4, and Compound PD41 (first dopant) and Compound DFD26 (second dopant) were co-deposited on at a weight ratio of 10 wt% and 1.5 wt%, respectively, based on a total of 100 wt% of the emission layer, to form an emission layer having a thickness of 400 Å.

Compound ETH94 was vacuum-deposited on the emission layer to form a hole blocking layer having a thickness of 50 Å, and Compound ETH102 and LiQ were vacuum-deposited at a weight ratio of 5:% on the hole blocking layer to form an electron transport layer having a thickness of 300 Å.

AgMg was deposited on the electron transport layer to form a cathode having a thickness of 1,100 Å, and Compound HT45 was deposited on the cathode to form a capping layer having a thickness of 600 Å, thereby completing the manufacture of a light-emitting device.

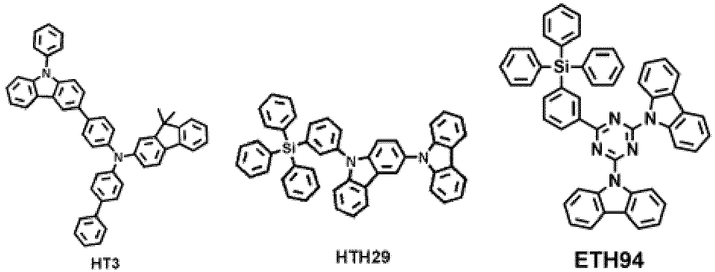

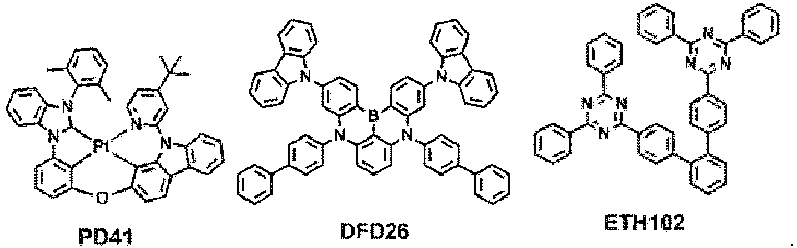

### [Examples 1 to 20 and Comparative Examples 2 to 9]

Light-emitting devices were each manufactured in the same manner as in Comparative Example 1, except that, as shown in Table 2, a depletion layer or a low-doped layer was formed in forming of an emission layer. In Table 2, a region of the doping layer or low-doped layer indicates a starting point and an end point based on the interface (0 nm) between the electron blocking layer and the emission layer.

### [Evaluation Example 1]

Regarding the light-emitting devices of Examples 1 to 20 and Comparative Examples 1 to 9, driving voltage, luminescence efficiency (cd/A), and device lifespan, at a current density of 10 mA/cm, were each measured by using Keithley MU 236 and luminance meter PR650, and the results are shown in Table 2. The device lifespan is a measurement of the time from starting luminance of 1,000 cd/m² to the point where the luminance reaches 95 %. In Table 2, the change in the driving voltage shows a difference on the basis of the driving voltage of Comparative Example 1, and the relative efficiency and the relative lifespan were on the basis of Comparative Example 1.

**[Table 2]**

| | Depleted/low-doped region (nm) | Concentration of second dopant (wt%) | Change in driving voltage (V) | Relative efficiency (%) | Relative lifespan (%) |
|---|---|---|---|---|---|
| Comparative Example 1 | - | 1.5 | 0.00 | 100 | 100 |
| Example 1 | 16~17 | - | -0.08 | 100 | 100 |
| Example 2 | 20~21 | - | -0.08 | 100 | 100 |
| Example 3 | 23~24 | - | -0.09 | 100 | 100 |
| Example 4 | 16~18 | - | -0.08 | 99 | 101 |
| Example 5 | 20~22 | - | -0.10 | 100 | 99 |
| Example 6 | 22~24 | - | -0.10 | 100 | 100 |
| Example 7 | 16~19 | - | -0.10 | 99 | 101 |
| Example 8 | 19~22 | - | -0.10 | 99 | 101 |
| Example 9 | 21~24 | - | -0.05 | 99 | 99 |
| Comparative Example 2 | 16~20 | - | 0.05 | 100 | 85 |
| Comparative Example 3 | 18~22 | - | 0.01 | 97 | 84 |
| Comparative Example 4 | 20~24 | - | 0.00 | 94 | 85 |
| Comparative Example 5 | 16~24 | - | 0.15 | 90 | 80 |
| Example 10 | 16~17 | 0.5 | -0.08 | 100 | 100 |
| Example 11 | 20~21 | 0.5 | -0.08 | 100 | 100 |
| Example 12 | 23~24 | 0.5 | -0.09 | 100 | 100 |
| Example 13 | 16~18 | 0.5 | -0.08 | 100 | 100 |
| Example 14 | 20~22 | 0.5 | -0.11 | 100 | 100 |
| Example 15 | 22~24 | 0.5 | -0.12 | 99 | 99 |
| Example 16 | 16~19 | 0.5 | -0.13 | 99 | 99 |
| Example 17 | 19~22 | 0.5 | -0.11 | 100 | 100 |
| Example 18 | 21~24 | 0.5 | -0.05 | 99 | 92 |
| Comparative Example 6 | 16~20 | 0.5 | -0.08 | 96 | 89 |
| Comparative | 18~22 | 0.5 | -0.09 | 98 | 91 |
| Example 7 | | | | | |
| Comparative Example 8 | 20~24 | 0.5 | -0.10 | 95 | 88 |
| Comparative Example 9 | 16~24 | 0.5 | -0.12 | 92 | 81 |
| Example 19 | 16~17, 19~20, 22~23 | - | -0.15 | 100 | 99 |
| Example 20 | 16~17, 19~20, 22~23 | 0.5 | -0.10 | 100 | 101 |

Referring to Table 2, it was confirmed that the light-emitting devices of Examples 1 to 20 exhibited, as compared to the light-emitting devices of Comparative Examples 1 to 5, efficiency and lifespan characteristics that are at an equivalent or higher level, and low driving voltage.

Referring to Table 2, it was confirmed that the light-emitting devices of Examples 1 to 20 exhibited, as compared to the light-emitting devices of Comparative Examples 6 to 9, the driving voltage at an equivalent or high level, and high efficiency and long lifespan characteristics.

According to embodiments, a light-emitting device includes a depletion layer or a low-doped layer, and thus may exhibit characteristics of a low driving voltage, high efficiency, and long lifespan at the same time, and a high-quality electronic apparatus may be manufactured by using the light-emitting device.

Embodiments have been disclosed herein, and although terms are employed, they are used and are to be interpreted in a generic and descriptive sense only and not for the purposes of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the claims.

## Claims

1. A light-emitting device (10) comprising:
a first electrode (110);
a second electrode (190) facing the first electrode (110);
an emission layer (150) between the first electrode (110) and the second electrode (190);
a hole transport region (130) between the first electrode (110) and the emission layer (150); and
an electron transport region (170) between the emission layer (150) and the second electrode (190), wherein
the emission layer (150) includes a first emission layer (140), a second emission layer (150N), and a third emission layer (160), which are sequentially arranged from the hole transport region (130),
a thickness of the emission layer (150) is x,
a thickness of the first emission layer (140) is a,
a thickness of the second emission layer (150N) is (b-a),
a thickness of the third emission layer (160) is (x-b),
a is a real number that satisfies 0.4x ≤ a < 0.6x,
b is a real number that satisfies 0.4x < b ≤ 0.6x,
a and b are different from each other, and satisfy a < b,
the first emission layer (140) and the third emission layer (160) each independently include a first host, a second host, a first dopant, and a second dopant,
the second emission layer (150N) includes:
a first host, a second host, and a first dopant; or
a first host, a second host, a first dopant, and a second dopant,
when the second emission layer (150N) includes the second dopant, y2 is smaller than y1,
y1 is a weight percentage (wt%) value of the second dopant in the first emission layer (140) that is expressed based on 100 wt% of the entire first emission layer (140),
y2 is a weight percentage (wt%) value of the second dopant in the second emission layer (150N) that is expressed based on 100 wt% of the entire second emission layer (150N), and
the first host, the second host, the first dopant, and the second dopant are different from one another.

2. The light-emitting device (10) of claim 1, wherein x is in a range of 30 nm to 40 nm; or
wherein (b-a) is equal to or less than (0.1x) nm; or
wherein (b-a) is equal to or less than 3 nm; or wherein (b-a) is equal to or greater than 1 nm.

3. The light-emitting device (10) of claim 1 or 2, wherein y1 is equal to or less than 3.

4. The light-emitting device (10) of any one of the preceding claims, wherein when the second emission layer includes a second dopant, y2 is equal to or less than 0.35(y1).

5. The light-emitting device (10) of any one of the preceding climas, wherein
the first host includes a group represented by Formula 1,
the second host includes at least one π electron-deficient nitrogen-containing C₁-C₆₀ cyclic group,
the first dopant includes a transition metal, and
the second dopant emits delayed fluorescence: 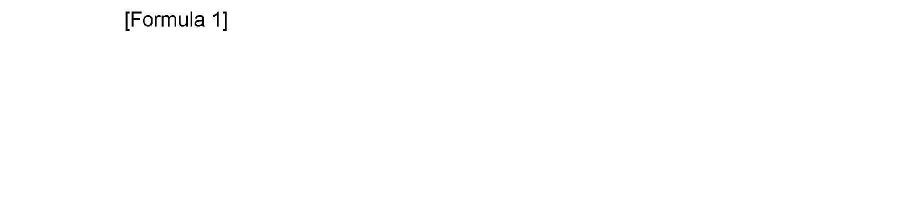 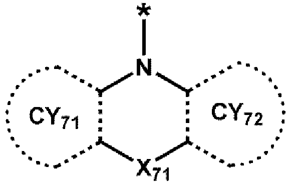
wherein in Formula 1,
ring CY₇₁ and ring CY₇₂ are each independently a π electron-rich C₃-C₆₀ cyclic group or a pyridine group,
X₇₁ is: a single bond; or a linking group including O, S, N, B, C, Si, or a combination thereof, and
* indicates a binding site to a neighboring atom in the first host.

6. The light-emitting device (10) of any one of the preceding claims, wherein the second host includes a pyridine group, a pyrimidine group, a pyrazine group, a pyridazine group, a triazine group, or a combination thereof.

7. The light-emitting device (10) of any one of the preceding claims, wherein the second host includes a compound represented by Formula 2: 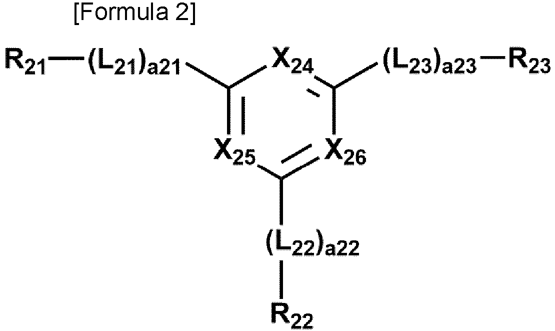
wherein in Formula 2,
L₂₁ to L₂₃ are each independently a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
a21 to a23 are each independently an integer from 1 to 5,
X₂₄ is N or C(R₂₄),
X₂₅ is N or C(R₂₅),
X₂₆ is N or C(R₂₆),
at least one of X₂₄ to X₂₆ is N,
R₂₁ to R₂₆ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(**=**O)(Q₁), **-**S(=O)₂(Q₁), -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -Ge(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or a combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -CI, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -Ge(Q₂₁)(Q₂₂)(Q₂₃), -N(Q₂₁)(Q₂₂), **-**B(Q₂₁)(Q₂₂), **-**C(=O)(Q₂₁), - S(=O)₂(Q₂₁), -P(=O)(Q₂₁)(Q₂₂), or a combination thereof; or
-Si(Q₃₁)(Q₃₂)(Q₃₃), -Ge(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇-C₆₀ arylalkyl group, or a C₂-C₆₀ heteroarylalkyl group, each unsubstituted or substituted with deuterium, - F, a cyano group, a C₁-C₆₀ alkyl group, a C₁-C₆₀ alkoxy group, a phenyl group, a biphenyl group, or a combination thereof.

8. The light-emitting device (10) of any one of the preceding claims, wherein the first dopant comprises iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm).

9. The light-emitting device (10) of any one of the preceding claims, wherein the first dopant comprises:
platinum (Pt); and
two or more nitrogen-containing cyclic groups.

10. The light-emitting device (10) of any one of the preceding claims, wherein a difference between a triplet energy level (eV) and a singlet energy level (eV) of the second dopant is in a range of 0 eV to 0.3 eV.

11. The light-emitting device (10) of any one of the preceding claims, wherein the second dopant comprises at least one cyclic group that includes boron (B) and nitrogen (N) as ring-forming atoms.

12. The light-emitting device (10) of any one of the preceding claims, wherein the emission layer (150) emits light having a maximum emission wavelength in a range of 430 nm to 480 nm.

13. An electronic apparatus comprising the light-emitting device of claim 1.

14. The electronic apparatus of claim 12, further comprising:
a thin-film transistor, wherein
the thin-film transistor includes a source electrode and a drain electrode, and
the first electrode of the light-emitting device is electrically connected to at least one of the source electrode and the drain electrode.

15. The electronic apparatus of claim 13, further comprising:
a light control layer, wherein
the light control layer includes quantum dots.
